# EUROPEAN PATENT APPLICATION

(11) **EP 4 811 979 A1**
(43) Date of publication of application: **23.09.2026**
(21) Application number: 24910101.5
(22) Date of filing: 29.09.2024
(51) Int. Cl.: H10H 20/857

(54) **WIRING SUBSTRATE, LIGHT-EMITTING SUBSTRATE, AND DISPLAY DEVICE**

(30) Priority: 28.12.2023 WO PCT/CN2023/142936
(71) Applicant: Boe Technology Group Co., Ltd., Beijing 100015 (CN); Hefei Boe Ruisheng Technology Co., Ltd., Hefei, Anhui 230012 (CN)
(72) Inventor: LEI, Jie, Beijing 100176 (CN)
(74) Representative: Cohausz & Florack
(86) International application number: PCT/CN2024/122523
(87) International publication number: WO 2025/139159

(57) **Abstract**

Disclosed are a wiring substrate, a light-emitting substrate, and a display device. The wiring substrate comprises: a substrate comprising a functional area and a bonding area; a plurality of columns of pad units, at least one of the plurality of columns of pad units comprising a plurality of pad units cascaded in a first direction, at least one pad unit comprising a first pad area comprising a plurality of types of first pads, and the plurality of types of first pads comprising at least one data pad and at least one ground pad; and a plurality of traces electrically connected to the plurality of pad units, the plurality of traces comprising a plurality of data signal lines and a plurality of ground signal lines, the plurality of data signal lines comprising a plurality of first data signal lines each electrically connected to the data pads of a plurality of first pad areas in a column of pad units, and the ground signal lines each being electrically connected to the ground pads of two first pad areas which are located in adjacent columns of pad units and cascaded.

## Description

### Cross reference to Related Applications

The disclosure claims priority of application No. PCT/CN2023/142936, filed to the China National Intellectual Property Administration on December 28, 2023, and entitled "Wiring Substrate, Light-Emitting Substrate And Display Apparatus", of which the entire contents are incorporated herein by reference.

### Technical Field

The disclosure herein relates to the field of a display technology, and in particular to a wiring substrate, a light-emitting substrate and a display apparatus.

### Background

Due to their advantages such as smaller size, ultra-high brightness, and long lifespan, micro light-emitting diodes (Micro-LEDs) are increasingly being used in the display field.

### Summary

Embodiments of the disclosure provide a wiring substrate, and the wiring substrate includes a substrate, a plurality of pad cell columns and a plurality of traces. The substrate includes a functional region and a bonding region at a side of the functional region in a first direction. The plurality of pad cell columns are at a side of the substrate and in the functional region; at least one of the plurality of pad cell columns includes a plurality of pad cells cascaded in the first direction; at least one of the plurality of pad cells includes a first pad region; and the first pad region includes multiple kinds of first pads, and the multiple kinds of first pads include at least one data pad and at least one ground pad. The plurality of traces are electrically connected to the plurality of pad cells; the plurality of traces include a plurality of data signal lines and a plurality of ground signal lines; the plurality of data signal lines includes a plurality of first data signal lines, and the first data signal line is electrically connected to data pads of the plurality of first pad regions in one pad cell column, the ground signal line is electrically connected to ground pads of two cascaded first pad regions respectively located in adjacent pad cell columns.

In some embodiments, ground pads of the plurality of first pad regions in the one pad cell column are adjacent to ground pads of a plurality of first pad regions in a pad cell column that is adjacent to the one pad cell column.

In some embodiments, ground pads of the plurality of first pad regions in the one pad cell column are arranged in a mirror image with ground pads of a plurality of first pad regions in a pad cell column that is adjacent to the one pad cell column.

In some embodiments, the traces further include a plurality of address signal lines and a plurality of second voltage lines. The first pad region further includes an address pad, a relay pad, and at least one power supply pad. The address signal line is electrically connected to the address pad and the relay pad, and the second voltage line is electrically connected to the power supply pad. In two first pad regions that are adjacent to each other and respectively in two cascaded pad cell columns, an address pad of one of the two first pad regions is arranged adjacent to a relay pad of the other one of the two first pad regions.

In some embodiments, address pads and relay pads of the plurality of first pad regions in the one pad cell column after being rotated 180°are arranged in a mirror image with address pads and relay pads of the plurality of first pad regions in the pad cell column adjacent to the one pad cell column.

In some embodiments, in two adjacent pad cell columns, a cascaded direction of a plurality of pad cells in one of the two adjacent pad cell columns is opposite to a cascaded direction of a plurality of pad cells in the other one of the two adjacent pad cell columns. The wiring substrate includes 2N pad cell columns, multiple kinds of first pads of a first pad region that is rotated by 180° in a 2n-th pad cell column are arranged in a same manner as multiple kinds of first pads of a first pad region in a (2n-1)-th pad cell column, and N is a positive integer, and n is a positive integer not greater than N.

In some embodiments, the at least one data pad and the at least one ground pad are in a same column in the first direction. The at least one data pad and the at least one ground pad each includes a portion that is in the first pad region and is close to an edge of the ground signal line.

In some embodiments, the ground signal line includes a trunk portion extending in the first direction; the trunk portion is between two pad cell columns that are electrically connected to the ground signal line.

In some embodiments, the first data signal line includes a plurality of first sub-segments; the first sub-segment is electrically connected to data pads of two cascaded first pad regions in the pad cell column. An orthographic projection of the first sub-segment on the substrate is at a side of the orthographic projection of the trunk portion on the substrate facing the orthographic projection of the pad cell column on the substrate.

In some embodiments, the plurality of data signal lines further includes: a plurality of second data signal lines. The second data signal line is electrically connected to data pads of the two cascaded first pad regions that are respectively located in the adjacent pad cell columns.

In some embodiments, the ground signal line includes a trunk portion; an orthographic projection of the second data signal line on the substrate is at a side of an orthographic projection of the trunk portion on the substrate away from the bonding region.

In some embodiments, two pad cell columns that are adjacent to each other and are cascaded are electrically connected to a same trunk portion.

In some embodiments, two pad cell columns that are adjacent to each other and are cascaded are electrically connected to different trunk portions, and the branch portions are respectively electrically connected to the ground pads of the two cascaded first pad regions that are respectively located in the adjacent pad cell columns.

In some embodiments, the ground signal line includes a trunk portion. The pad cell further includes: at least one second pad region; and the second pad region is electrically connected to the first pad region. The first pad further includes: at least one output pad. The plurality of traces further includes: a plurality of first voltage lines extending in the first direction; the first voltage line is electrically connected to input terminals of a plurality of second pad regions in the pad cell column, and output terminals of the plurality of second pad regions are electrically connected to the output pads; and a first voltage line and a trunk portion that are electrically connected to a same pad cell column are respectively at both sides of the same pad cell column.

In some embodiments, at least some of the adjacent pad cell columns are electrically connected to a same first voltage line.

In some embodiments, the first pad region further includes: an address pad, a relay pad, and at least one power supply pad. The traces further include: a plurality of address signal lines and a plurality of second voltage lines; the address signal line includes a plurality of second sub-segments. An end of the second sub-segment is electrically connected to a relay pad of one first pad region, and the other end of the second sub-segment is electrically connected to an address pad of a first pad region of a next stage of the one first pad region. The second voltage line includes a plurality of third sub-segments; and the third sub-segment is electrically connected to power supply pads of two cascaded first pad regions; and in the first direction, the relay pad is in a column different from a column where the at least one power supply pad is located.

In some embodiments, the multiple kinds of first pads included in the first pad region are arranged in an array of M*2 with a first pad column and a second pad column, and M is a positive integer. In the second direction, an orthographic projection of the second pad column on the substrate is between an orthographic projection of the first pad column on the substrate and an orthographic projection of the trunk portion on the substrate. At least a part of a region of the at least one data pad, the relay pad, and at least a part of a region of the at least one ground pad are in the second pad column, and the at least one output pad and at least a part of a region of the at least one power supply pad are in the first pad column.

In some embodiments, the traces are arranged in a same layer as the first pads; the address pad is in the second pad column. An arrangement direction of the address pad and the relay pad in the second pad column is the same as a cascaded direction of the plurality of pad cells in the pad cell column. In the second pad column and in the first direction, an orthographic projection of the ground pad on the substrate is between an orthographic projection of the address pad on the substrate and an orthographic projection of the relay pad on the substrate. An orthographic projection of the second sub-segment that electrically connects the two cascaded first pad regions in the pad cell column on the substrate is between the orthographic projection of the first sub-segment on the substrate and the orthographic projection of the trunk portion on the substrate.

In some embodiments, the at least one data pad includes: a data input pad and a data output pad. In each pad cell column, a data output pad of an i-th stage first pad region is electrically connected to a data input pad of an (i + 1)-th stage first pad region through the first sub-segment, and i is a positive integer. In the adjacent pad cell columns, an end of the second data signal line is electrically connected to a data output pad of a last stage first pad region in one of the adjacent pad cell columns, and the other end of the second data signal line is electrically connected to a data input pad of a first stage first pad region in the other one of the adjacent pad cell columns. The data input pad and the data output pad are in the second pad column; an arrangement direction of the data input pad and the data output pad is the same as the cascaded direction of the plurality of pad cells in the pad cell column. The orthographic projection of the address pad on the substrate is between an orthographic projection of the data input pad on the substrate and the orthographic projection of the ground pad on the substrate, and the orthographic projection of the relay pad on the substrate is between an orthographic projection of the data output pad on the substrate and the orthographic projection of the ground pad on the substrate.

In some embodiments, the at least one data pad includes: a data input pad and a data output pad. In each pad cell column, a data input pad of an i-th stage first pad region is electrically connected to a data output pad of an (i + 1)-th stage first pad region through the first sub-segment; and i is a positive integer. In the adjacent pad cell columns, an end of the second data signal line is electrically connected to a data input pad of a last stage first pad region in one of the adjacent pad cell columns, and the other end of the second data signal line is electrically connected to a data output pad of a first stage first pad region in the other one of the adjacent pad cell columns. The data input pad and the data output pad are in the second pad column; an arrangement direction of the data output pad and the data input pad is the same as the cascaded direction of the plurality of pad cells in the pad cell column. The orthographic projection of the address pad on the substrate is between an orthographic projection of the data input pad on the substrate and the orthographic projection of the ground pad on the substrate, and the orthographic projection of the relay pad on the substrate is between an orthographic projection of the data output pad on the substrate and the orthographic projection of the ground pad on the substrate.

In some embodiments, in the second direction, the data output pad of the first pad region and the data input pad of the first pad region rotated by 180° are in a same row. The address pad of the first pad region and the relay pad of the first pad region rotated by 180° are in a same row. The second data signal line extends in the second direction, and the orthographic projection of the second data signal line on the substrate is at a side of the orthographic projection of the branch portion on the substrate away from the bonding region. The second sub-segment that electrically connects two adjacent pad cell columns extends in the second direction, an orthographic projection of the second sub-segment that electrically connects the two adjacent pad cell columns on the substrate is between the orthographic projection of the second data signal line on the substrate and the orthographic projection of the branch portion on the substrate.

In some embodiments, the at least one power supply pad includes: a first power supply pad and a second power supply pad; both the first power supply pad and the second power supply pad are in the first pad column. An arrangement direction of the first power supply pad and the second power supply pad in the first pad column is the same as the cascaded direction of the plurality of pad cells in the pad cell column. In the first direction, an orthographic projection of the output pad on the substrate is between an orthographic projection of the first power supply pad on the substrate and an orthographic projection of the second power supply pad on the substrate. An end of the third sub-segment is electrically connected to a second power supply pad of one first pad region, and the other end of the third sub-segment is electrically connected to a first power supply pad of a next stage of the one first pad region.

In some embodiments, in the second direction, the power supply pad and the data pad are in a same row.

In some embodiments, the first pad region includes a plurality of ground pads, and the plurality of ground pads are all in the second pad column.

In some embodiments, the output pads included in the first pad region are all in the first pad column.

In some embodiments, the address pad and the at least a part of the region of the at least one data pad are in the first pad column. An arrangement direction of the data pad, the address pad, the power supply pad and the output pad in the first pad column is the same as a cascaded direction of the plurality of pad cells in the pad cell column. An arrangement direction of the ground pad, the data pad and the relay pad in the second pad column is the same as the cascaded direction of the plurality of pad cells in the pad cell column. An end of the first sub-segment is electrically connected to the data pad in the second pad column, and the other end of the first sub-segment is electrically connected to the data pad in the first pad column. An orthographic projection of the first sub-segment on the substrate is between an orthographic projection of the second sub-segment on the substrate and the orthographic projection of the trunk portion on the substrate.

In some embodiments, the traces are arranged in a same layer as the first pads. At least a part of the region of the at least one power supply pad is in the second pad column. An arrangement direction of the ground pad, the data pad, the relay pad and the power supply pad in the second pad column is the same as the cascaded direction of the plurality of pad cells in the pad cell column. An end of the third sub-segment is electrically connected to the power supply pad in the second pad column, and the other end of the third sub-segment is electrically connected to the power supply pad in the first pad column. An orthographic projection of the second sub-segment that electrically connects the two cascaded first pad regions in the pad cell column on the substrate is between the orthographic projection of the first sub-segment on the substrate and an orthographic projection of the third sub-segment that electrically connects the two cascaded first pad regions in the pad cell column on the substrate.

In some embodiments, in the traces electrically connected to the two cascaded first pad regions in the pad cell column, an arrangement direction of the first sub-segment, the second sub-segment and the third sub-segment in the first direction is the same as the cascaded direction of the plurality of pad cells in the pad cell column. In the traces electrically connected to two cascaded first pad regions respectively located in two pad cell columns, the second data signal line, the second sub-segment and the third sub-segment are arranged in sequence in a direction pointing from the bonding region to the functional region.

In some embodiments, the at least one data pad includes: a data input pad and a data output pad; the data input pad is in the first pad column, and the data output pad is in the second pad column. In each pad cell column, a data output pad of an i-th stage first pad region is electrically connected to a first portion of the first sub-segment, and the data output pad of the i-th stage first pad region is electrically connected to a data input pad of an (i + 1)-th stage first pad region through the first sub-segment; and i is a positive integer. In the adjacent pad cell columns, an end of the second data signal line is electrically connected to a data output pad of a last stage first pad region in one of the adjacent pad cell columns, and the other end of the second data signal line is electrically connected to a data input pad of a first stage first pad region in the other one of the adjacent pad cell columns.

In some embodiments, the at least one data pad includes: a data input pad and a data output pad; the data output pad is in the first pad column, and the data input pad is in the second pad column. In each pad cell column, a data input pad of an i-th stage first pad region is electrically connected to a first portion of the first sub-segment, and the data input pad of the i-th stage first pad region is electrically connected to a data output pad of an (i + 1)-th stage first pad region through the first sub-segment; and i is a positive integer. In the adjacent pad cell columns, an end of the second data signal line is electrically connected to a data input pad of a last stage first pad region in one of the adjacent pad cell columns, and the other end of the second data signal line is electrically connected to a data output pad of a first stage first pad region in the other one of the adjacent pad cell columns.

In some embodiments, the at least one power supply pad includes: a first power supply pad and a second power supply pad; the first power supply pad is in the first pad column, and the second power supply pad is in the second pad column. A second power supply pad of the i-th stage first pad region is electrically connected to a first power supply pad of the (i + 1)-th stage first pad region through the third sub-segment.

In some embodiments, the first pad region includes two ground pads, and the two ground pads are in the first pad column and the second pad column, respectively; in the first direction, the two ground pads are in a same row. In the first pad column, the ground pad is at a side of the data pad away from the address pad. In the second direction, the data input pad and the data output pad are in a same row, the address pad and the relay pad are in a same row, and the first power supply pad and the second power supply pad are in a same row.

In some embodiments, the first pad region includes a plurality of output pads; some of the output pads are in the second pad column; and in the second direction, the output pads in the second pad column are at a side of the second power supply pad away from the relay pad.

In some embodiments, the first pad region further includes: a first connection lead; and the data input pad and the data output pad are electrically connected with each other through the first connection lead.

In some embodiments, the first power supply pad and the second power supply pad of the first pad region are not electrically connected through the trace.

In some embodiments, the first pad region further includes: a second connection lead; and the first power supply pad and the second power supply pad are electrically connected through the second connection lead.

In some embodiments, the second voltage line includes a third sub-segment; power supply pads of two cascaded first pad regions respectively located in adjacent pad cell columns are electrically connected through the third sub-segment.

In some embodiments, the bonding region includes a plurality of bonding electrodes. In the adjacent pad cell columns that are electrically connected through the third sub-segment, a power supply pad of a first stage first pad region in one of the adjacent pad cell columns and a power supply pad of a last stage first pad region in the other one of the adjacent pad cell columns are both electrically connected to the bonding electrodes through the traces.

In some embodiments, the bonding region includes a plurality of bonding electrodes. In the adjacent pad cell columns that are electrically connected through the third sub-segment, a power supply pad of a first stage first pad region in one of the adjacent pad cell columns is electrically connected to the bonding electrode through the trace, and a power supply pad of a last stage first pad region in the other one of the adjacent pad cell columns is not connected to the bonding electrode.

In some embodiments, the first pad region further includes: a third connection lead; two ends of the third connection lead are electrically connected to different ground pads, respectively.

In some embodiments, the quantity of the first pads included in the first pad column is the same as the quantity of the first pads included in the second pad column.

The embodiments of the disclosure provide a light-emitting substrate, and the light-emitting substrate includes: the wiring substrate provided by the embodiments, driver chips bonded with the first pad regions in a one-to-one correspondence, and light-emitting elements bonded with pad groups in the plurality of second pad regions in a one-to-one correspondence.

In some embodiments, the light-emitting elements are micro-sized inorganic light-emitting diodes.

The embodiments of the disclosure provide a display apparatus, including the light-emitting substrate provided by the embodiment of disclosure.

### Brief Description of Figures

In order to illustrate technical solutions of embodiments of the disclosure more clearly, drawings needing to be used in descriptions of the embodiments will be introduced below briefly. Apparently, the drawings described below are only some embodiments of the disclosure, and those ordinarily skilled in the art can further obtain other drawings according to these drawings without inventive efforts.
FIG. 1 is a schematic structural diagram of a light-emitting substrate in the related art.
FIG. 2 is a schematic structural diagram of a wiring substrate according to an embodiment of the disclosure.
FIG. 3 is a schematic structural diagram of another wiring substrate according to an embodiment of the disclosure.
FIG. 4 is a schematic structural diagram of yet another wiring substrate according to an embodiment of the disclosure.
FIG. 5 is a schematic structural diagram of yet another wiring substrate according to an embodiment of the disclosure.
FIG. 6 is a schematic structural diagram of yet another wiring substrate according to an embodiment of the disclosure.
FIG. 7 is a schematic structural diagram of yet another wiring substrate according to an embodiment of the disclosure.
FIG. 8 is a schematic structural diagram of yet another wiring substrate according to an embodiment of the disclosure.
FIG. 9 is a schematic structural diagram of yet another wiring substrate according to an embodiment of the disclosure.
FIG. 10 is a schematic structural diagram of yet another wiring substrate according to an embodiment of the disclosure.
FIG. 11 is a schematic structural diagram of yet another wiring substrate according to an embodiment of the disclosure.
FIG. 12 is a schematic structural diagram of yet another wiring substrate according to an embodiment of the disclosure.
FIG. 13 is a schematic structural diagram of yet another wiring substrate according to an embodiment of the disclosure.
FIG. 14 is a schematic structural diagram of yet another wiring substrate according to an embodiment of the disclosure.
FIG. 15 is a schematic structural diagram of yet another wiring substrate according to an embodiment of the disclosure.
FIG. 16 is a schematic structural diagram of yet another wiring substrate according to an embodiment of the disclosure.
FIG. 17 is a schematic structural diagram of yet another wiring substrate according to an embodiment of the disclosure.
FIG. 18 is a schematic structural diagram of yet another wiring substrate according to an embodiment of the disclosure.
FIG. 19 is a schematic structural diagram of yet another wiring substrate according to an embodiment of the disclosure.
FIG. 20 is a schematic structural diagram of yet another wiring substrate according to an embodiment of the disclosure.
FIG. 21 is a schematic structural diagram of yet another wiring substrate according to an embodiment of the disclosure.
FIG. 22 is a schematic structural diagram of yet another wiring substrate according to an embodiment of the disclosure.
FIG. 23 is a schematic structural diagram of yet another wiring substrate according to an embodiment of the disclosure.
FIG. 24 is a schematic structural diagram of yet another wiring substrate according to an embodiment of the disclosure.
FIG. 25 is a schematic structural diagram of yet another wiring substrate according to an embodiment of the disclosure.
FIG. 26 is a schematic structural diagram of yet another wiring substrate according to an embodiment of the disclosure.
FIG. 27 is a schematic structural diagram of yet another wiring substrate according to an embodiment of the disclosure.
FIG. 28 is a schematic structural diagram of yet another wiring substrate according to an embodiment of the disclosure.
FIG. 29 is a schematic structural diagram of yet another wiring substrate according to an embodiment of the disclosure.
FIG. 30 is a schematic structural diagram of yet another wiring substrate according to an embodiment of the disclosure.
FIG. 31 is a schematic structural diagram of yet another wiring substrate according to an embodiment of the disclosure.
FIG. 32 is a schematic structural diagram of yet another wiring substrate according to an embodiment of the disclosure.
FIG. 33 is a schematic structural diagram of yet another wiring substrate according to an embodiment of the disclosure.
FIG. 34 is a schematic structural diagram of yet another wiring substrate according to an embodiment of the disclosure.
FIG. 35 is a schematic structural diagram of yet another wiring substrate according to an embodiment of the disclosure.
FIG. 36 is a schematic structural diagram of yet another wiring substrate according to an embodiment of the disclosure.
FIG. 37 is a schematic structural diagram of yet another wiring substrate according to an embodiment of the disclosure.
FIG. 38 is a schematic structural diagram of yet another wiring substrate according to an embodiment of the disclosure.
FIG. 39 is a schematic structural diagram of yet another wiring substrate according to an embodiment of the disclosure.
FIG. 40 is a schematic structural diagram of yet another wiring substrate according to an embodiment of the disclosure.
FIG. 41 is a schematic structural diagram of yet another wiring substrate according to an embodiment of the disclosure.
FIG. 42 is a schematic structural diagram of yet another wiring substrate according to an embodiment of the disclosure.
FIG. 43 is a schematic structural diagram of yet another wiring substrate according to an embodiment of the disclosure.
FIG. 44 is a schematic structural diagram of yet another wiring substrate according to an embodiment of the disclosure.
FIG. 45 is a schematic structural diagram of yet another wiring substrate according to an embodiment of the disclosure.
FIG. 46 is a schematic structural diagram of yet another wiring substrate according to an embodiment of the disclosure.
FIG. 47 is a schematic structural diagram of yet another wiring substrate according to an embodiment of the disclosure.
FIG. 48 is a schematic structural diagram of yet another wiring substrate according to an embodiment of the disclosure.
FIG. 49 is a schematic structural diagram of yet another wiring substrate according to an embodiment of the disclosure.
FIG. 50 is a schematic structural diagram of yet another wiring substrate according to an embodiment of the disclosure.
FIG. 51 is a schematic structural diagram of yet another wiring substrate according to an embodiment of the disclosure.
FIG. 52 is a schematic structural diagram of yet another wiring substrate according to an embodiment of the disclosure.
FIG. 53 is a schematic structural diagram of yet another wiring substrate according to an embodiment of the disclosure.
FIG. 54 is a schematic structural diagram of yet another wiring substrate according to an embodiment of the disclosure.
FIG. 55 is a schematic structural diagram of yet another wiring substrate according to an embodiment of the disclosure.
FIG. 56 is a schematic structural diagram of yet another wiring substrate according to an embodiment of the disclosure.
FIG. 57 is a schematic structural diagram of another light-emitting substrate according to an embodiment of the disclosure.
FIG. 58 is a schematic structural diagram of a display apparatus according to an embodiment of the disclosure.

### Detailed Description

In order to make the purpose, technical solutions and advantages of embodiments of the disclosure more clear, the technical solutions of embodiments of the disclosure will be clearly and completely described below in conjunction with the drawings of embodiments of the disclosure. Obviously, the described embodiments are some, but not all, of embodiments of the disclosure. In addition, the embodiments and the features of the embodiments in the disclosure can be combined with each other without conflict. Based on the described embodiments of the disclosure, all other embodiments obtained by those of ordinary skill in the art without creative efforts fall within the scope of protection of the disclosure.

Unless otherwise defined, technical or scientific terms used here shall have their ordinary meaning understood by a person of ordinary skill in the art to which this disclosure belongs. "First", "Second" and similar words used in the description and claims in the disclosure do not indicate any order, quantity or importance, but are only used to distinguish different components. Words such as "include" or "comprise" mean that the elements or things appearing before the word include the elements or things listed after the word and their equivalents, without excluding other elements or things. The word "connection" or "coupling" and the like is not restricted to physical or mechanical connection, but may include electrical connection, whether direct or indirect.

It should be noted that the sizes and shapes of the figures in the drawings do not reflect the real scale, and are only intended to illustrate the disclosure. In addition, the same or similar reference numerals refer to the same or similar elements or elements having the same or similar functions throughout.

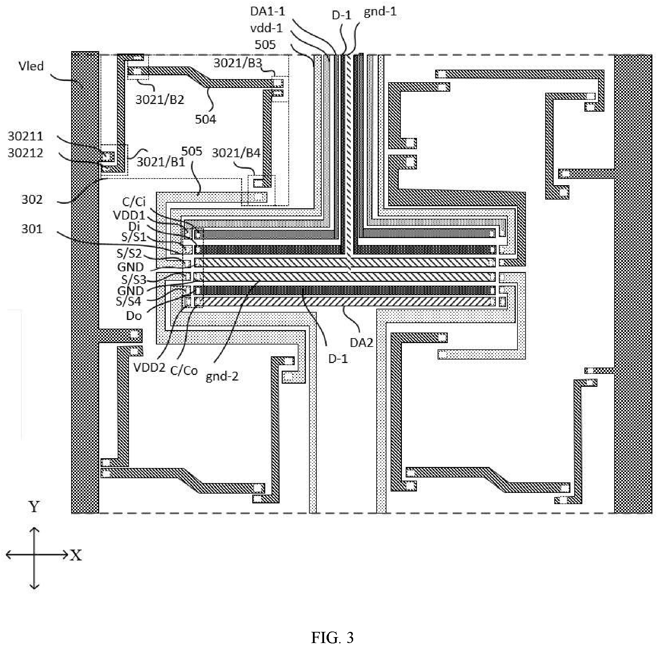

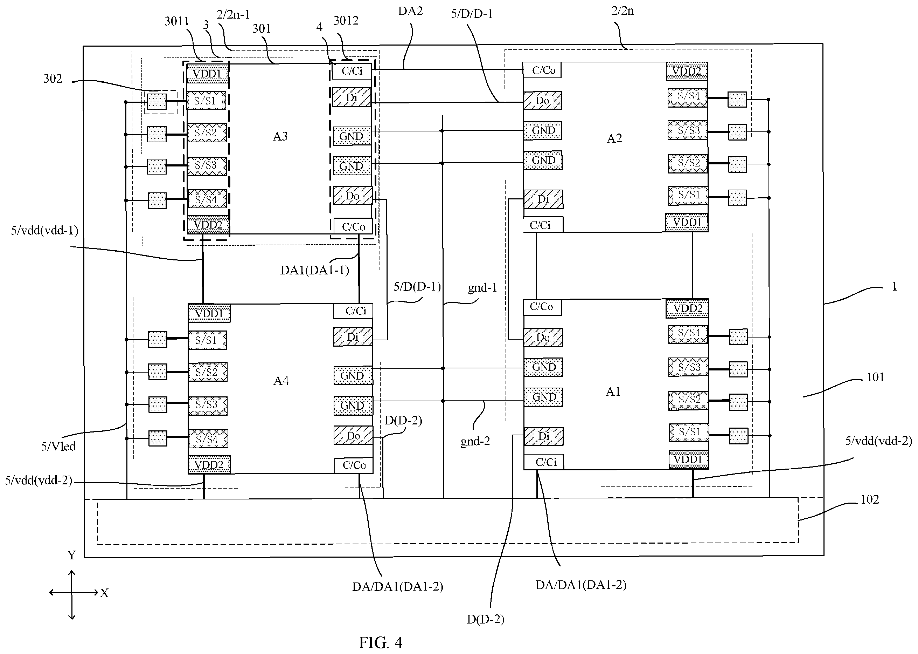

The embodiments of the disclosure provide a wiring substrate, as shown in FIG. 3 and FIG. 4, the wiring substrate includes a substrate 1, a plurality of pad cell columns 2, a plurality of traces 5.

The substrate 1 includes a functional region 101 and a bonding region 102 located at a side of the functional region 101 in a first direction Y.

The plurality of pad cell columns 2 are at a side of the substrate 1 and in the functional region 101; at least one of the plurality of pad cell columns 2 includes a plurality of pad cells 3 cascaded along the first direction Y; at least one of the plurality of pad cells 3 includes a first pad region 301; the first pad region 301 includes: multiple kinds of first pads 4; and the multiple kinds of first pads 4 include at least one data pad C and at least one ground pad GND.

The plurality of traces 5 are electrically connected to the plurality of pad cells 3. The plurality of traces 5 include: a plurality of data signal lines DA and a plurality of ground signal lines gnd; and the plurality of data signal lines DA include: a plurality of first data signal lines DA1. The first data signal line DA1 is electrically connected to data pads C of the plurality of first pad regions 301 in one pad cell column 2. The ground signal line gnd is electrically connected to ground pads GND of two cascaded first pad regions 301, and the two cascaded first pad regions are respectively located in adjacent pad cell columns 2.

In the wiring substrate provided by the embodiments of the disclosure, the data pads of two cascaded first pad regions which are respectively located in the adjacent pad cell columns are electrically connected through a same ground signal line, which can reduce the number of ground signal lines, thereby saving wiring space, and reducing the wiring difficulty of the traces.

In some embodiments, as shown in FIG. 4, the plurality of pad cell columns 2 are arranged along a second direction X and extend along the first direction Y, and the second direction X intersects with the first direction Y. In FIG. 4, it is illustrated by taking an example that the second direction X is perpendicular to the first direction Y. Each pad cell column 2 of the plurality of pad cell columns 2 includes a plurality of pad cells 3 cascaded along the first direction Y; and each pad cell 3 of the plurality of pad cells 3 includes a first pad region 301.

In some embodiments, the plurality of traces are arranged in a same layer in the functional region.

In some embodiments, as shown in FIGS. 3 and 4, the pad cell 3 further includes: at least one second pad region 302. The second pad region 302 is electrically connected to the first pad region 301. As shown in FIG. 3, the second pad region 302 includes at least one pad group 3021.

In specific implementation, the wiring substrate provided by the embodiments of the disclosure may be applied to a light-emitting substrate. Each pad group is bonded with a light-emitting device, and multiple first pads included in the first pad region are bonded with pins of a driver chip (for example, an integrated circuit chip with a size in the scale of hundred micrometers), so that the light-emitting device can be driven to emit light under the control of the driver chip. For example, a driver chip may control light-emitting devices bonded and connected within a second pad region corresponding to the driver chip to emit light. A region occupied by the plurality of pads bonded with a driver chip is the first pad region, and a region occupied by the plurality of pad groups and a region enclosed by the plurality of pad groups are the second pad region.

It can be understood that an insulating layer is formed on a side of the trace 5 away from the substrate 1, and the insulating layer is configured to isolate the trace 5 from water and oxygen. The insulating layer may include a plurality of via holes, and a surface of a part of the trace 5 is exposed by the via holes to constitutes a pad (including any one of the first pad 4, a positive-polarity pad 30211, and a negative-polarity pad 30212).

In some embodiments, as shown in FIG. 3 to FIG. 6, the ground signal line gnd at least includes a portion located between two pad cell columns 2 that are adjacent to each other and are cascaded. Thus, it is easier to realize that the ground pads GND of two cascaded first pad regions 301 located in two adjacent pad cell columns 2 are electrically connected through the ground signal line gnd.

In some embodiments, as shown in FIG. 3 to FIG. 6, in the second direction X, in the two pad cell columns 2 that are adjacent to each other and are cascaded, there is no pad cell 3 between at least some of the ground pads GND in one of the two pad cell columns 2 and at least some of the ground pads GND in the other one of the two pad cell columns 2. Here, the second direction X intersects with the first direction Y. In FIG. 3 to FIG. 6, it is illustrated by taking the example that the second direction X is perpendicular to the first direction Y.

In some embodiments, as shown in FIG. 3 to FIG. 5, ground pads of the plurality of first pad regions in one pad cell column are arranged in a mirror image with ground pads of the plurality of first pad regions in a pad cell column that is adjacent to the one pad cell column.

In some embodiments, as shown in FIG. 3 to FIG. 5, ground pads GND of the plurality of first pad regions 301 in one pad cell column 2 are adjacent to ground pads GND of the plurality of first pad regions 301 in a pad cell column 2 adjacent to the one pad cell column. Thus, the ground pads GND of two adjacent pad cell columns can be directly electrically connected through the ground signal line gnd, making it easier to realize that the ground pads GND of two cascaded first pad regions 301 located in two adjacent pad cell columns 2 are electrically connected through the ground signal line gnd, and to reduce the wiring difficulty.

In some embodiments, as shown in FIG. 3 to FIG. 6, the multiple kinds of first pads 4 further include: an address pad Di, a relay pad Do, and at least one power supply pad VDD; the traces 5 further include: a plurality of address signal lines D and a plurality of second voltage lines vdd; and the address signal line D is electrically connected to the address pad Di and the relay pad Do, and the second voltage line vdd is electrically connected to the power supply pad VDD.

In specific implementation, when the wiring substrate is applied to a light-emitting substrate, that is, the driver chip is bonded to the first pads included in the first pad region, the address pad Di may be used to receive an address signal, address information of the driver chip is configured according to the address signal, and a relay signal is generated; the relay signal may serve as an address signal of the next stage micro-driver chip; the data pad C are used to receive driving data, which includes driving information and address verification information. When the address verification information matches the address information, according to the driving information, a driving current corresponding to the light-emitting device electrically connected to the driver chip is generated, and an electrical path is formed between an output pad of the driver chip and the corresponding light-emitting device, and the driving current flows in this electrical path. The address pad Di may receive the address signal, address information is configured according to the address signal, and the driver chip generates a relay signal according to the received address information, and the relay signal is output by the relay pad Do to an address pad Di in the next stage first pad region to serve as an address signal of the next stage first pad region. The voltage input from the power supply pad VDD enables the driver chip to work normally. The data signal lines may also be used to transmit test signals to test whether there are any abnormalities in the light-emitting devices in the second pad regions electrically connected to each first pad region; that is, the data signal lines are configured to be able to transmit test signals and driving data signals in a time-division manner.

In the wiring substrate provided by the embodiments of the disclosure, the data signal lines and the second voltage lines adopts different traces respectively, which can simplify the circuit structure in a region where the first pad region is located. There is no need to set up a power adjustment circuit (the power adjustment circuit is configured to generate a driving voltage based on a direct current component of a power supply signal and generate driving data based on a modulation component of the power supply signal) in the region where the first pad region is located, which is beneficial to reducing an area of the region where the first pad region is located. In addition, this setting method can also simplify the external circuit structure. It can avoid setting up a modulation circuit that modulates the driving voltage and driving data for power line carrier communication, and can also reduce the quality requirements for the driving voltage.

In some embodiments, as shown in FIG. 3 to FIG. 5, in two first pad regions 301 that are adjacent to each other and respectively in two cascaded pad cell columns 2, an address pad Di in one of the two first pad regions 301 is arranged adjacent to a relay pad Do in the other one of the two first pad regions 301. Thus, in two pad cell columns 2 that are adjacent to each other and are cascaded, two cascaded first pad regions 301 may be directly electrically connected through an address signal line D, which can reduce the wiring difficulty.

In some embodiments, as shown in FIG. 3 to FIG. 6, address pads Di and relay pads Do of the plurality of first pad regions 301 in one pad cell column 2 after being rotated 180° are arranged in a mirror image with address pads Di and relay pads Do of the plurality of first pad regions 301 in the pad cell column 2 that is adjacent to the one pad cell column.

In the wiring substrate provided by the embodiments of the disclosure, in two pad cell columns that are adjacent to each other and are cascaded, an arrangement of the address pads and the relay pads in one of the two pad cell columns is different from an arrangement of the address pads and the relay pads in the other one of the two pad cell columns. Correspondingly, positions of traces electrically connected to the two pad cell columns are also different. The embodiments of the disclosure are equivalent to changing the arrangements of the address pads and the relay pads of the first pad region of one of the two pad cell columns that are adjacent to each other and are cascaded, which can change the wiring placement position of the wiring substrate, and it easier to realize that two cascaded first pad regions are electrically connected through the address signal line, thereby reducing the difficulty of wiring.

In some embodiments, the wiring substrate includes 2N pad cell columns; N is a positive integer. The wiring substrate includes N cascaded loops, and each cascaded loop includes two cascaded pad cell columns.

In some embodiments, as shown in FIG. 4, in two adjacent pad cell columns 2, a cascaded direction of a plurality of pad cells 3 in one of the two adjacent pad cell columns 2 is opposite to a cascaded direction of a plurality of pad cells 3 in the other one of the two adjacent pad cell columns 2.

In the wiring substrate provided by the embodiments of the disclosure, the cascaded direction of the plurality of pad cells in the one of the two adjacent pad cell columns is opposite to the cascaded direction of the plurality of pad cells in the other one of the two adjacent pad cell columns. Thus, two pad cells which are farthest from the bonding region and are respectively located in two pad cell columns in one cascaded loop can be cascaded, and ground pads of two cascaded first pad regions that are located in adjacent pad cell columns are electrically connected by the address signal lines, so as to reduce the wiring difficulty.

It should be noted that the cascading of the plurality of pad cells specifically refers to the cascading of first pad regions of the plurality of pad cells. As shown in FIG. 4, taking each pad cell column 2 including two pad cells 3 as an example, the 2n-th pad cell column 2 and the (2n-1)-th pad cell column 2 form a cascaded loop, here n is a positive integer not greater than N; four cascaded first pad regions 301 are cascaded in an order of A1, A2, A3, and A4. That is, in the 2n-th pad cell column 2, A1 is the first stage first pad region 301 of a plurality of cascaded first pad regions 301 in this column, and A2 is the last stage first pad region 301 of the plurality of cascaded first pad regions 301 in this column. In the (2n-1)-th pad cell column 2, A3 is the first stage first pad region 301 of a plurality of cascaded first pad regions 301 in this column, A4 is the last stage first pad region 301 of the plurality of cascaded first pad regions 301 in this column.

It should be noted that only one cascaded loop, i.e., only two adjacent pad cell columns 2, are shown in FIG. 4. In specific implementation, the number of pad cell columns included in the wiring substrate can be set according to actual needs.

In some embodiments, as shown in FIG. 3 to FIG. 6, multiple kinds of first pads 4 in a first pad region 301 that is rotated by 180°in the 2n-th pad cell column 2 are arranged in the same manner as multiple kinds of first pads 4 in a first pad region 301 in the (2n-1)-th pad cell column 2.

That is, in the wiring substrate provided by the embodiments of the disclosure, an arrangement of pads of a first pad region in an odd-numbered pad cell column is different from an arrangement of pads of a first pad region in an even-numbered pad cell column. Correspondingly, a position of each trace corresponding to the even-numbered pad cell column is different from a position of each trace corresponding to the odd-numbered pad cell column. The embodiments of the disclosure are equivalent to changing the arrangement of the pads of the first pad region in the even-numbered pad cell column, which can change the wiring placement position in the wiring substrate, making it easier to cascade two adjacent pad cell columns through the traces.

In some embodiments, as shown in FIG. 3 to FIG. 6, the ground signal line gnd is electrically connected to the ground pads GND of the plurality of first pad regions 301 in the pad cell column 2.

The ground signal line gnd includes: a trunk portion gnd-1 extending along the first direction Y; the trunk portion gnd-1 is between two pad cell columns 2 that are electrically connected to the ground signal line gnd.

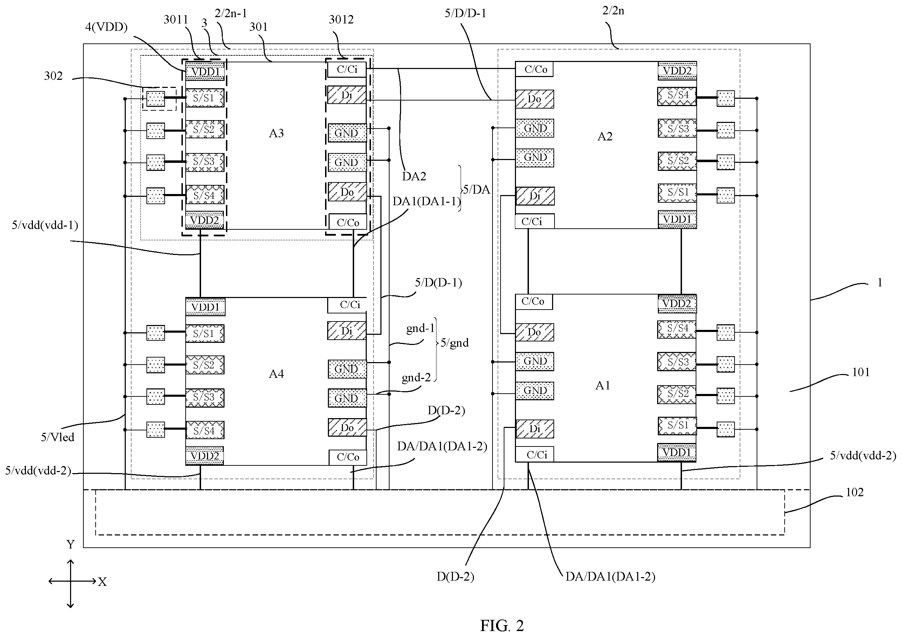

In some embodiments, as shown in FIG. 2 to FIG. 6, at least one data pad C and at least one ground pad GND are in the same column in the first direction Y; and at least one data pad C and at least one ground pad GND each includes a portion that is in the first pad region 301 and is close to an edge of the trunk portion gnd-1.

The ground signal line gnd further includes a branch portion gnd-2 extending along the second direction X. An orthographic projection of the branch portion gnd-2 on the substrate 1 is between an orthographic projection of the trunk portion gnd-1 on the substrate 1 and an orthographic projection of the pad cell column 2 on the substrate 1. The trunk portion gnd-1 is connected to the ground pad GND included in a second pad column through the branch portion gnd-2.

In the wiring substrate provided by the embodiments of the disclosure, the at least one data pad and the at least one ground pad are in the same column in the first direction, and the at least one data pad and the at least one ground pad each includes a portion that is in the first pad region and is close to the edge of the trunk portion, which facilitates that the data pads in the two pad cell columns in a cascade loop are connected to each other through the second data signal line. Moreover, since the multiple kinds of first pads of the first pad region rotated by 180° in the 2n-th pad cell columns are arranged in the same manner as the multiple kinds of first pads of the first pad region of the (2n-1)-th pad cell column, when the trunk portion is between two pad cell column electrically connected to the second data signal line, the two cascaded pad cell columns both include ground pads with a short distance from the trunk portion, which facilitates the electrically connecting the ground pads to the trunk portion through the branch portion, and can simplify the wiring difficulty under reasonable utilization of the wiring space.

In some embodiments, as shown in FIG. 3 to FIG. 6, the first data signal line DA1 includes a plurality of first sub-segments DA1-1; the first sub-segment DA1-1 is electrically connected to the data pads C of two cascaded first pad regions 301 in the pad cell column 2. An orthographic projection of the first sub-segment DA1-1 on the substrate 1 is at a side of the orthographic projection of the trunk portion gnd-1 on the substrate 1 facing the orthographic projection of the pad cell column 2 on the substrate 1.

In the wiring substrate provided by the embodiments of the disclosure, the cascaded pad cells in the pad cell column are electrically connected through the first sub-segment. Since the cascaded directions of two adjacent pad cell columns are opposite, in a cascaded loop, the two pad cells which are farthest from the bonding region and are respectively located in the two pad cell columns are cascaded, and the orthographic projection of the first sub-segment on the substrate is at the side of the orthographic projection of the trunk portion on the substrate facing the orthographic projection of the pad cell column on the substrate, which can avoid interference between the data signal line and the ground signal line.

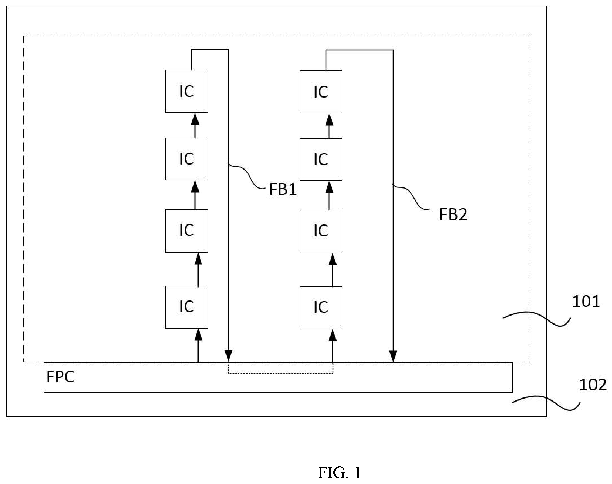

The light-emitting substrate in the related art is shown in FIG. 1, where a signal for realizing a specific function is transmitted from a bonding region 102 to a driver circuit integrated circuit (IC) of a first column closest to a flexible printed circuit (FPC) board via a signal line, then sequentially transmitted along the column direction to a driver circuit IC of the first column farthest from the flexible printed circuit board and, then transmitted back to the flexible printed circuit board in the bonding region 102 via a feedback signal line FB1, then transmitted to a driver circuit IC of a second column closest to the flexible printed circuit board after being transferred by the flexible printed circuit board, then sequentially transmitted along the column direction to a driver circuit IC of the first column farthest from the flexible printed circuit board, and then returned to the flexible printed circuit board in the bonding region 102 through a feedback signal line FB2. The two columns of driver circuit ICs form a loop. Since the feedback signal line FB need to be led from the farthest end of a column of the driver circuit ICs to the bonding region, limited by the line width of the feedback signal line FB, i.e., influenced by the resistance of the feedback signal line FB, there is a time limit for the signal in the transmission process, which may result in a delay in the time for each of the driver circuit ICs in the entire loop to receive the signal, and may then result in the reduction in the frequency of the signal transmission.

In some embodiments, as shown in FIG. 2 to FIG. 6, the plurality of data signal lines DA further include: a plurality of second data signal lines DA2, and the second data signal line DA2 is electrically connected to data pads C of two cascaded first pad regions 301, which are respectively located in the adjacent pad cell columns 2.

In the wiring substrate provided by the embodiments of the disclosure, the data pads of the two cascaded first pad regions located in the adjacent pad cell columns are electrically connected through the second data signal line, which avoids a data signal output by the data pad of the first pad region farthest from the bonding region from being transmitted back to the bonding region through a trace with a relatively long length, thereby reducing the transmission time of the data signal and increase the transmission frequency of the data signal, and avoiding the transmission delay of the data signal. Moreover, the wiring space can be saved, which is beneficial to increasing the line widths of other traces, and reducing the resistances and voltage drops of the traces.

Furthermore, in the wiring substrate provided by the embodiments of the disclosure, in two adjacent pad cell columns, a cascaded direction of a plurality of pad cells in one of the two adjacent pad cell columns is opposite to a cascaded direction of a plurality of pad cells in the other one of the two adjacent pad cell columns, so that the two pad cells which are farthest from the bonding region and are respectively located in the two pad cell columns in one cascaded loop can be cascaded, which facilitates that the data pads of two cascaded first pad regions located in adjacent pad cell columns are electrically connected by the second data signal line, and which can avoid a data signal output by the data pad in the first pad region farthest from the bonding region from being transmitted back to the bonding region through a trace with a relatively long length while reducing the wiring difficulty.

In some embodiments, as shown in FIG. 2, when the plurality of data signal lines DA include a plurality of second data signal lines DA2, it is also possible that the ground pads GND of two cascaded first pad regions 301 located in adjacent pad cell columns 2 are respectively electrically connected to different ground signal lines gnd.

In some embodiments, as shown in FIG. 2 to FIG. 6, the trunk portion gnd-1 is between two pad cell columns 2 that are electrically connected to the second data signal line DA2. An orthographic projection of the second data signal line DA2 on the substrate 1 is at a side of the orthographic projection of the trunk portion gnd-1 on the substrate 1 away from the bonding region 102.

In the wiring substrate provided by the embodiments of the disclosure, the cascaded pad cells in the pad cell column are electrically connected through the first sub-segment. Since the cascaded directions of two adjacent pad cell columns are opposite, in a cascaded loop, the two pad cells which are farthest from the bonding region and are respectively located in the two pad cell columns are cascaded, the data pads of two cascaded first pad regions located in the adjacent pad cell columns are electrically connected through the second data signal line, and the orthographic projection of the first sub-segment on the substrate is at the side of the orthographic projection of the trunk portion on the substrate facing the orthographic projection of the pad cell column on the substrate, and the orthographic projection of the second data signal line on the substrate is at the side of the orthographic projection of the trunk portion on the substrate away from the bonding region, which can avoid interference between the data signal line and the ground signal line.

In some embodiments, the bonding region includes a plurality of bonding electrodes; at least some of the traces are electrically connected to the bonding electrodes.

In some embodiments, as shown in FIG. 2, the first data signal line DA1 further includes a fourth sub-segment DA1-2; an end of the fourth sub-segment DA1-2 is electrically connected to a bonding electrode (not shown) of the bonding region 102, and the other end of the fourth sub-segment DA1-2 is electrically connected to a data pad C in the first pad region 301 closest to the bonding region 102 in the pad cell column 2.

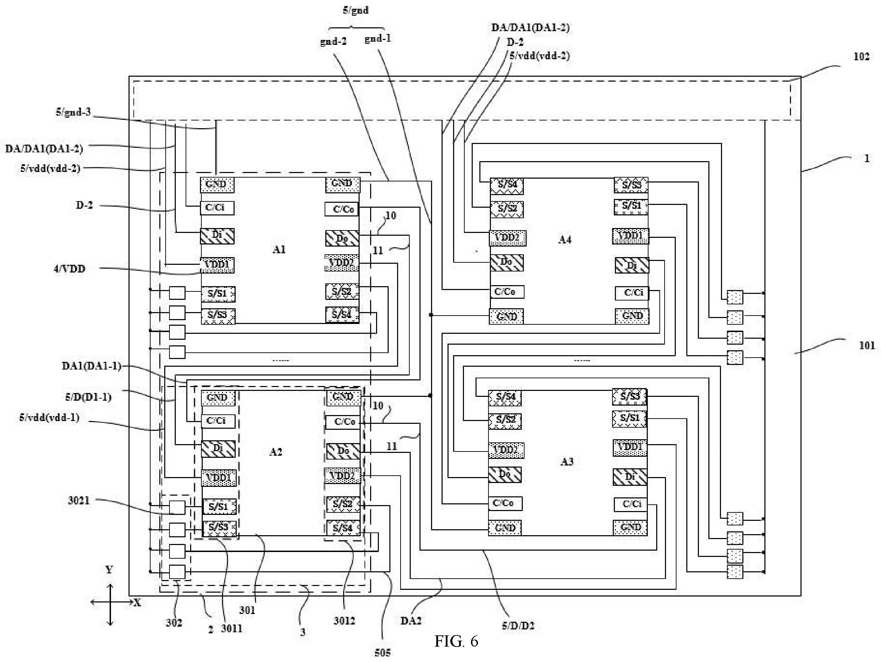

In some embodiments, as shown in FIG. 3 and FIG. 6, two pad cell columns 2 that are adjacent to each other and are cascaded are electrically connected to the same trunk portion gnd-1. That is, two pad cell columns 2 electrically connected to the second data signal line DA2 are electrically connected to the same trunk portion gnd-1, which can further save the wiring space, and is beneficial to increasing a width of a trace between the two pad cell columns, thereby reducing the resistance and voltage drop of the traces.

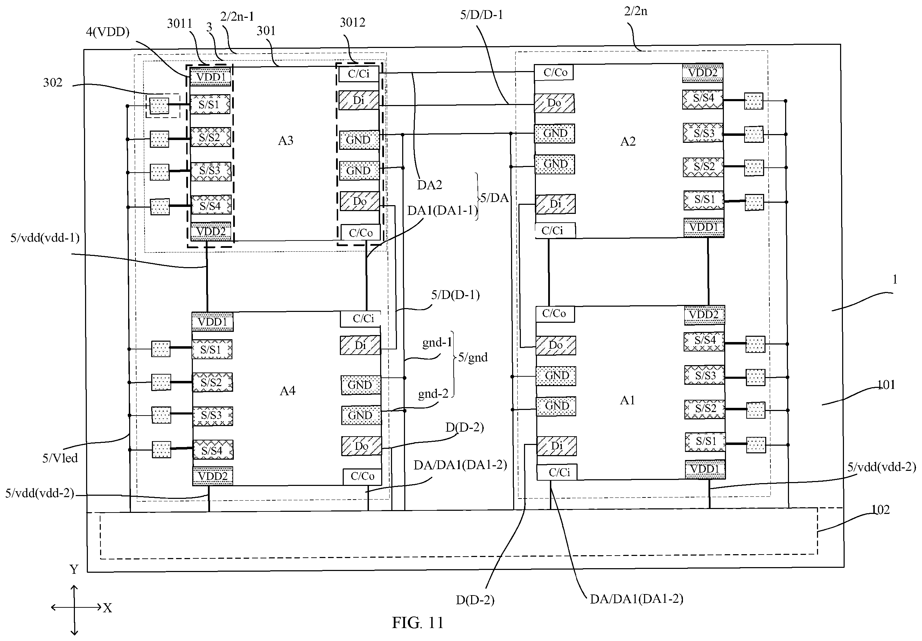

Alternatively, in some embodiments, as shown in FIG. 11, two pad cell columns 2 that are adjacent to each other and are cascaded are electrically connected to different trunk portions gnd-1, and branch portions gnd-2 are respectively electrically connected to the ground pads GND of two cascaded first pad regions 301 located in adjacent pad cell columns 2.

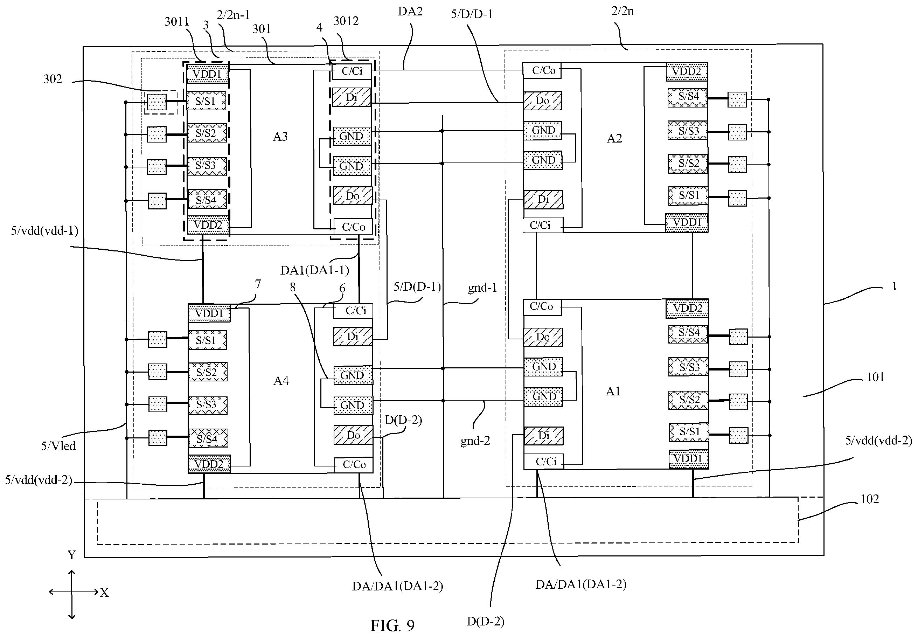

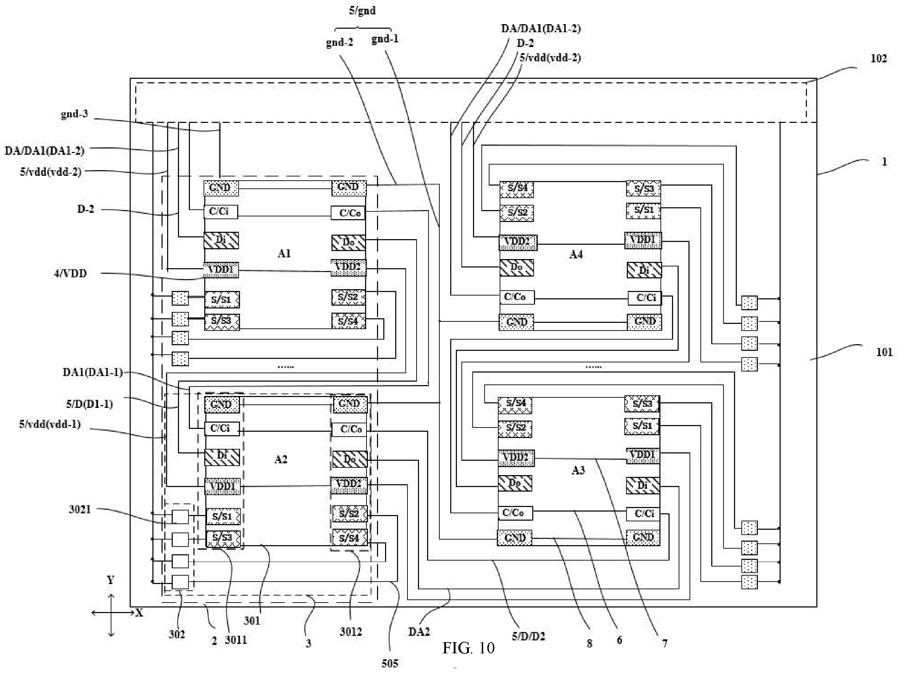

In some embodiments, as shown in FIG. 2 to FIG. 11, the first pad 4 further includes: at least one output pad S. The plurality of traces 5 further include: a plurality of first voltage lines Vled extending in the first direction Y. The first voltage line Vled is electrically connected to input terminals of a plurality of second pad regions 302 in the pad cell column 2, and output terminals of the second pad regions 302 are electrically connected to the output pads S. The first voltage line Vled and the trunk portion gnd-1 electrically connected to the same pad cell column 2 are respectively at both sides of the same pad cell column 2.

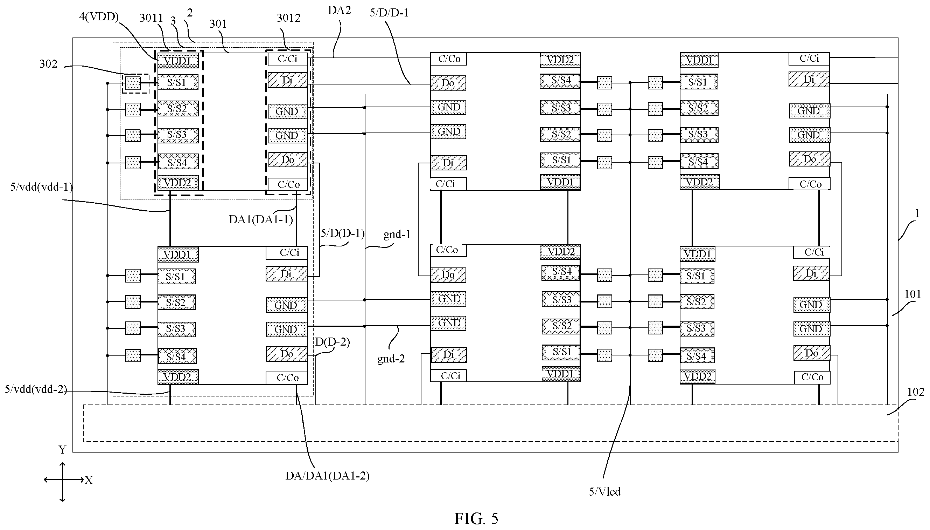

In some embodiments, as shown in FIG. 5, at least some adjacent pad cell columns 2 are electrically connected to a same first voltage line Vled. Thereby, the wiring space can be further saved, which is beneficial to increasing the width of the traces between the two pad cell columns, and thus the resistance and voltage drop of the trace are reduced.

In specific implementation, the two pad cell columns electrically connected to the same first voltage line are located in two cascaded loops that are adjacent to each other, respectively. That is, these two pad cell columns are not electrically connected through the second data signal line.

In some embodiments, as shown in FIG. 2, FIG. 4 to FIG. 6, and FIG. 8 to FIG. 11, the number of the second pad regions 302 is the same as that of the output pads S, that is, one output pad S is electrically connected to one second pad region 302. In FIG. 2, for example, the first pads 4 include four output pads S which are S1, S2, S3, and S4, and one pad cell 3 includes four second pad regions 302. S1, S2, S3, and S4 are electrically connected to output terminals of the four second pad regions 302, respectively.

In some embodiments, as shown in FIG. 3, the second pad region 302 includes at least one pad group 3021, and each pad group 3021 includes a positive-polarity pad 30211 and a negative-polarity pad 30212. In specific implementation, the positive-polarity pad is electrically connected to an anode of the light-emitting device, and the negative-polarity pad is electrically connected to a cathode of the light-emitting device.

In some embodiments, as shown in FIG. 3, the second pad region 302 includes a plurality of pad groups 3021. The plurality of pad groups 3021 are connected in series with each other. The plurality of traces 5 further include a fourth connection lead 504. Each pad group 3021 includes a positive-polarity pad 30211 and a negative-polarity pad 30212. In two pad groups 3021 that are connected to each other, a positive-polarity pad 30211 of one of the two pad groups 3021 is connected to a negative-polarity pad 30212 of the other one of the two pad groups 3021 through the fourth connection lead 504. In FIG. 3, for example, the second pad region 302 includes four pad groups 3021 connected in series, and the four pad groups 3021 are B1, B2, B3, and B4, respectively. A negative-polarity pad 30212 of the pad group 3021 (B1) is connected to a positive-polarity pad 30211 of the pad group 3021 (B2), a negative-polarity pad 30212 of the pad group 3021 (B2) is connected to a positive-polarity pad 30211 of the pad group 3021 (B3), and a negative-polarity pad 30212 of the pad group 3021 (B3) is connected to a positive-polarity pad 30211 of the pad group 3021 (B4). It should be noted that an input terminal of the second pad region refers to a positive-polarity pad of one of the pad groups included in the second pad region. As shown in FIG. 3, when the plurality of pad groups 3021 included in the second pad region 302 are connected in series with each other, a positive-polarity pad 30211 of the first second pad group 3021, i.e., the pad group 3021 (B1) shown in FIG. 4, of the plurality of second pad groups 3021 connected in series is connected to the first voltage line Vled, and a negative-polarity pad 30212 of the last second pad group 3021, i.e., the pad group 3021 (B4) shown in FIG. 3, of the plurality of second pad groups 3021 connected in series is connected to the output pad S in the first pad region 301. The negative-polarity pad 30212 of the last second pad group 3021 of the plurality of second pad groups 3021 connected in series is connected to the output pad S through a fifth connection lead 505.

Of course, in specific implementation, the plurality of pad groups may also be connected in parallel.

In some embodiments, the pad groups, the first pads, and the plurality of traces are provided in the same layer. That is, the traces, the positive-polarity pads, the negative-polarity pads, and the multiple kinds of first pads are provided in the same layer. The traces, the positive-polarity pads, the negative-polarity pads, and the first pads are prepared using the same material (e.g., the main materials thereof all include copper) or have the same structure. In specific implementation, a conductive layer may be formed on a side of the substrate, and then a patterning process may be performed on the conductive layer to form the patterns of the traces and the pads.

In some embodiments, the wiring substrate further includes a first insulating layer at a side of the traces, the positive-polarity pads, the negative-polarity pads, and the multiple kinds of first pads facing away from the substrate. The first insulating layer is provided with a plurality of openings. It can be understood that a portion of the patterned conductive layer that is exposed by the openings in the insulating layer is the pad, and the trace is in a region covered by the insulating layer. That is, the trace is integrally connected to the pad.

In some embodiments, as shown in FIG. 2, FIG. 4 to FIG. 6, and FIG. 8 to FIG. 11, the address signal line D includes a plurality of second sub-segments D-1. An end of the second sub-segment D-1 is electrically connected to a relay pad Do of one first pad region 301, and the other end of the second sub-segment D-1 is electrically connected an address pad Di of a first pad region 301 of the next stage of the one first pad region 301.

In some embodiments, as shown in FIG. 2, FIG. 4 to FIG. 6, and FIG. 8 to FIG. 11, the second voltage line vdd includes a plurality of third sub-segments vdd-1. The third sub-segment vdd-1 is electrically connected to the power supply pads VDD of two cascaded first pad regions 301.

In some embodiments, as shown in FIG. 2, FIG. 4 to FIG. 5, and FIG. 11, in one pad cell column 2, power supply pads VDD of two cascaded first pad regions 301 are electrically connected through the third sub-segment vdd-1. The power supply pads VDD of the two cascaded first pad regions 301 that are respectively located in the adjacent pad cell columns 2 are not electrically connected through the third sub-segment vdd-1.

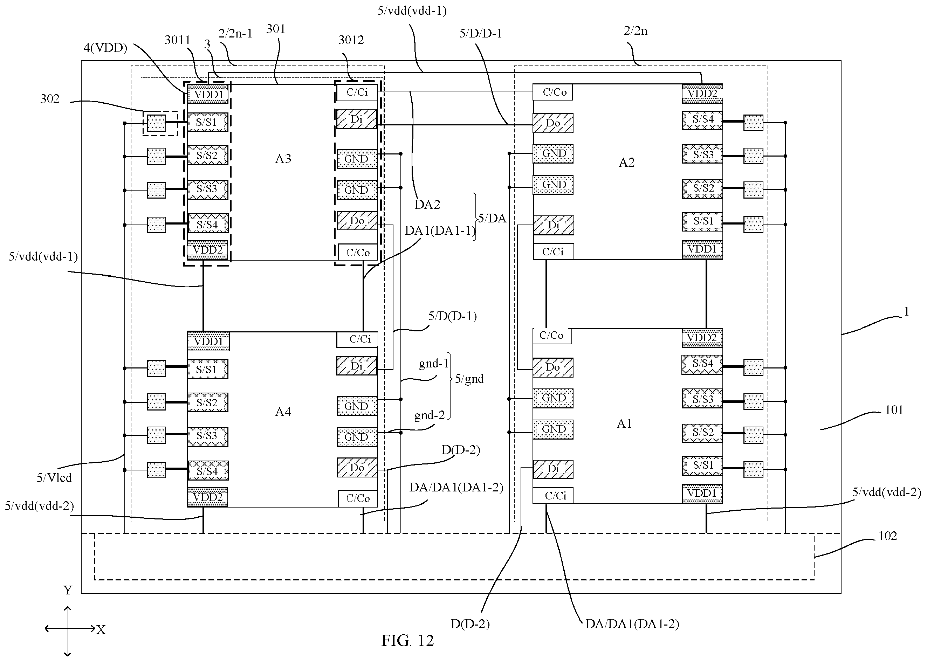

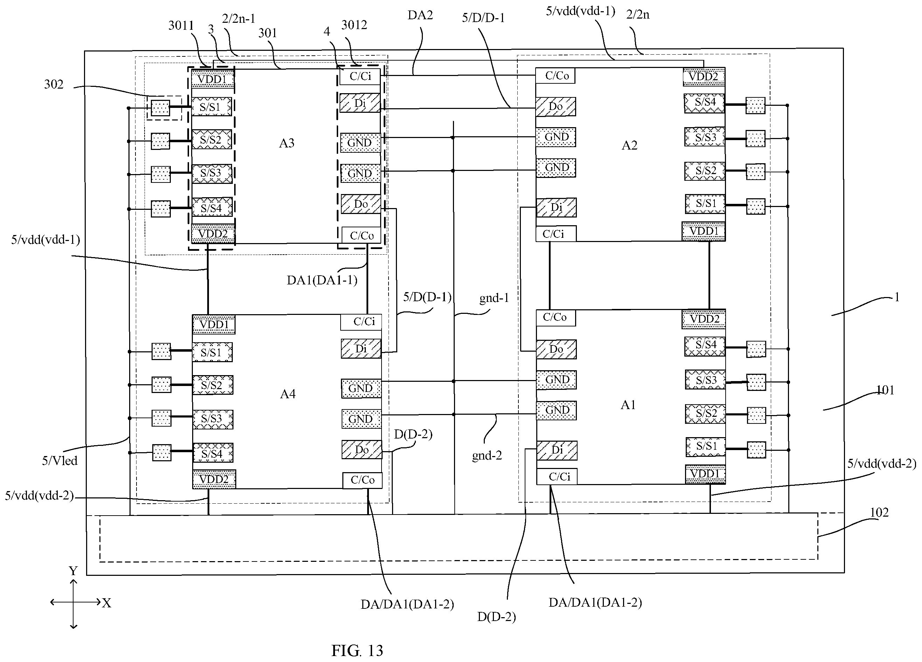

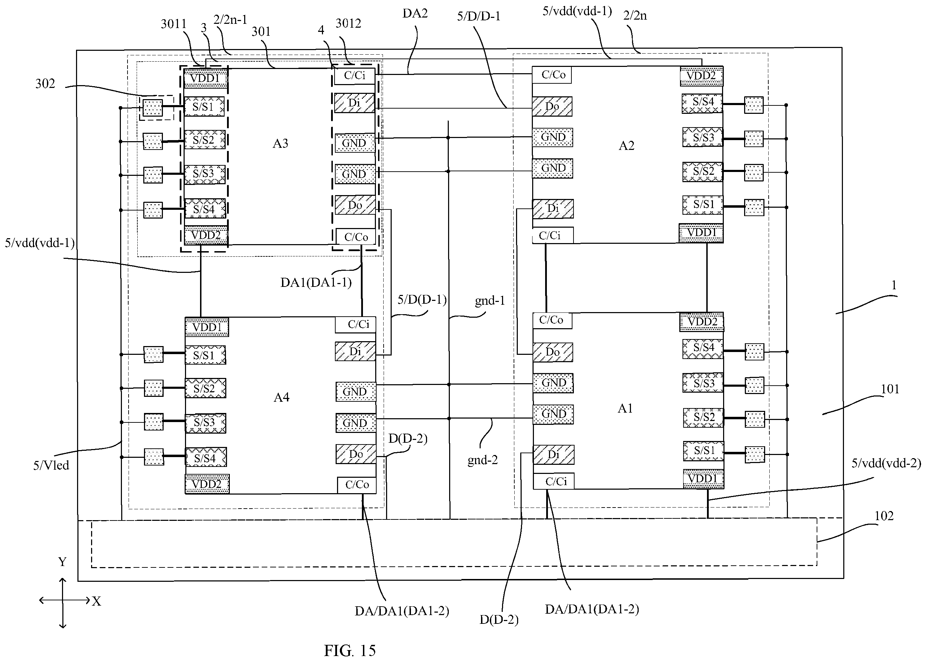

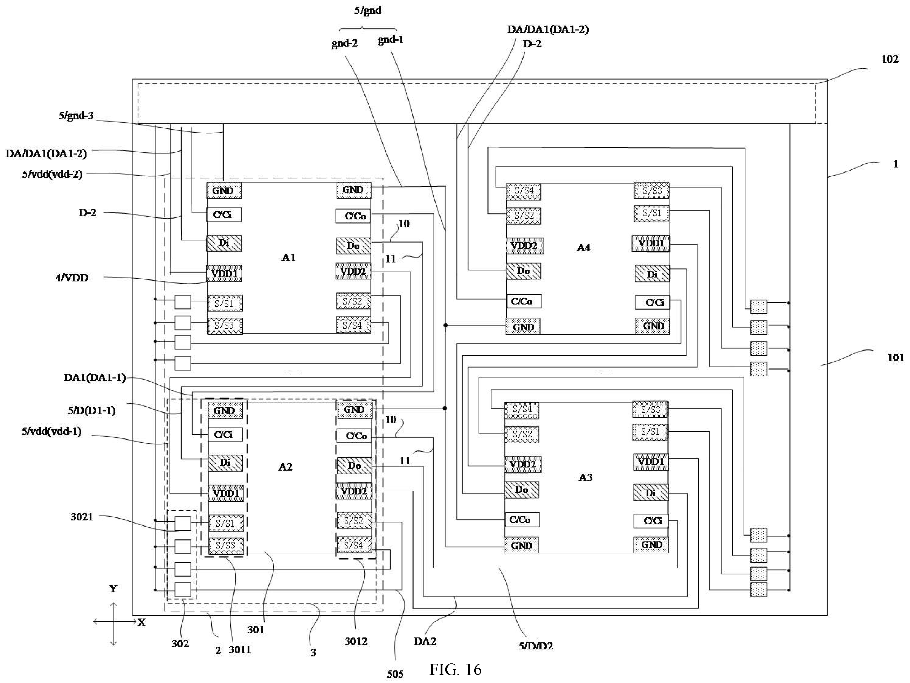

Alternatively, as shown in FIG. 6, FIG. 12 to FIG. 16, the power supply pads VDD of two cascaded first pad regions 301 that are respectively located in the adjacent pad cell columns 2 are electrically connected through the third sub-segment vdd-1.

In some embodiments, as shown in FIG. 2, FIG. 4 to FIG. 6, FIG. 8 to FIG. 16, in the first direction Y, the relay pad Do and at least one power supply pad VDD are located in different columns. Thereby, the wiring difficulty of the second sub-segment and the third sub-segment can be reduced, which is beneficial to avoiding interference between them.

In some embodiments, as shown in FIG. 2, FIG. 4 to FIG. 6, and FIG. 8 to FIG. 16, the address signal line D further includes a fifth sub-segment D-2. An end of the fifth sub-segment D-2 is electrically connected to a bonding electrode (not shown) of the bonding region 102, and the other end of the fifth sub-segment D-2 is electrically connected to an address pad Di or a relay pad Do of a first pad region 301 closest to the bonding region 102 in the pad cell column 2.

In specific implementation, as shown in FIG. 2, FIG. 4, FIG. 6, and FIG. 8 to FIG. 16, for two pad cell columns 2 in one cascaded loop, an address pad Di of a first pad region 301 (A1) in the first stage pad cell 3 is electrically connected to the bonding electrode (not shown) of the bonding region 102 through the fifth sub-segment D-2, and a relay pad Do of the first pad region 301 (A4) in the last stage pad cell 3 is electrically connected to the bonding electrode (not shown) of the bonding region 102 through the fifth sub-segment D-2.

In some embodiments, as shown in FIG. 2, FIG. 4 to FIG. 6, and FIG. 8 to FIG 16, the second voltage line vdd further includes a sixth sub-segment vdd-2; an end of the sixth sub-segment vdd-2 is electrically connected to a bonding electrode (not shown) of the bonding region 102, and the other end of the sixth sub-segment vdd-2 is electrically connected to a power supply pad VDD of a first pad region 301 closest to the bonding region 102 in the pad cell column 2.

In some embodiments, as shown in FIG. 2, FIG. 4 to FIG. 5, and FIG. 11, in each pad cell column 2, the power supply pad VDD of the first pad region 301 closest to the bonding region 102 is electrically connected to the bonding electrode (not shown) through the sixth sub-segment vdd-2.

In some embodiments, as shown in FIG. 6, and FIG. 12 to FIG. 13, in adjacent pad cell columns 2 that are electrically connected through the third sub-segment vdd-1, a power supply pad VDD of the first stage first pad region 301 in one of the adjacent pad cell columns 2 and a power supply pad VDD of the last stage first pad region 301 in the other one of the adjacent pad cell columns are both electrically connected to a bonding electrode (not shown) through the trace, i.e., the sixth sub-segment vdd-2.

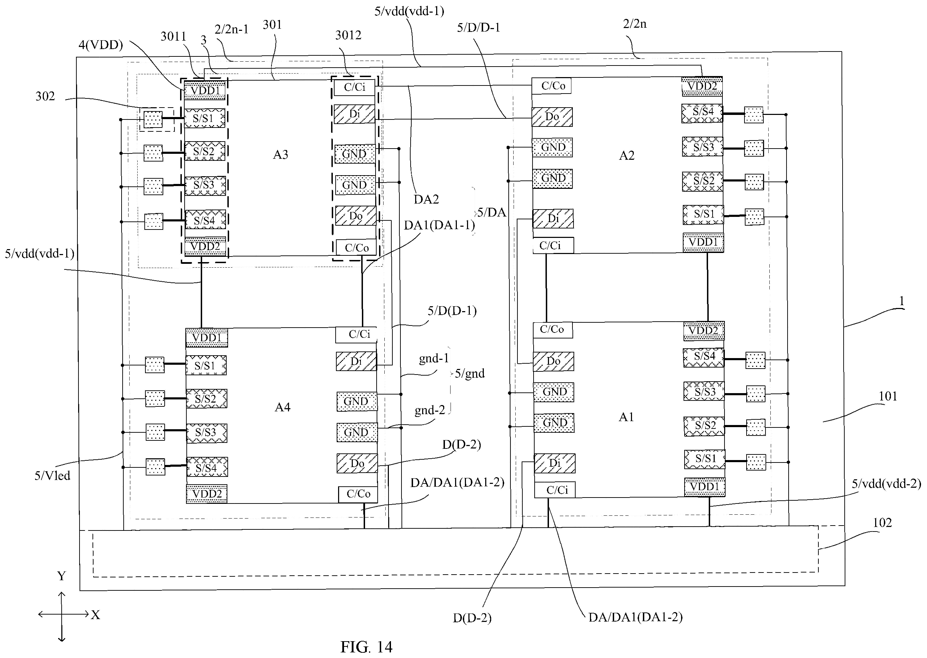

Alternatively, in some embodiments, as shown in FIG. 14 to FIG. 16, in the adjacent pad cell columns 2 that are electrically connected through the third sub-segment vdd-1, the power supply pad VDD of the first stage first pad region 301 in one of the adjacent pad cell columns 2 and the power supply pad VDD of the last stage first pad region 301 in the other one of the adjacent pad cell columns are not connected to the bonding electrode (not shown) through the trace, that is, the sixth sub-segment vdd-2.

In some embodiments, as shown in FIG. 2, FIG. 4 to FIG. 6, and FIG. 8 to FIG. 16, the multiple kinds of first pads 4 included in the first pad region 301 are arranged in an array of M*2 with a first pad column 3011 and a second pad column 3012; M is a positive integer.

In the second direction X, an orthographic projection of the second pad column 3012 on the substrate 1 is between an orthographic projection of the first pad column 3011 on the substrate 1 and the orthographic projection of the trunk portion gnd-1 on the substrate 1.

In specific implementation, since the multiple kinds of first pads in the first pad region that is rotated by 180° in the 2n-th pad cell column are arranged in the same manner as the multiple kinds of first pads in the first pad region in the (2n-1)-th pad cell column, the first pad column in the first pad region in the 2n-th pad cell column, after being rotated by 180°, is the same as the first pad column in the first pad region in the (2n-1)-th pad cell column, and the second pad column in the first pad region in the 2n-th pad cell column, after being rotated by 180°, is the same as the second pad column in the first pad region in the (2n-1)-th pad cell column. For two pad cell columns in a cascaded loop, the trunk portion is between the two pad cell columns, and the first voltage line and the trunk portion are on both sides of the pad cell column, respectively. That is, the second pad column is closer to the trunk portion, and the first pad column is closer to the first voltage line.

It should be noted that the multiple kinds of first pads included in the first pad region are arranged in an array of M*2 with the first pad column and the second pad column, which means that the first pad column and the second pad column include the same number of first pads, both of which are M.

In the wiring substrate provided by the embodiments of the disclosure, the number of first pads included in the first pad column and the number of the first pads included in the second pad column are the same, and the multiple kinds of first pads in the first pad region are regularly and evenly arranged, which can improve the thickness homogeneity of the first pad region, and thus can improve the effect of the first pad region in supporting the driver chip, which is conducive to realizing the balance of the gravity center of the driver chip after it is bonded to the first pad.

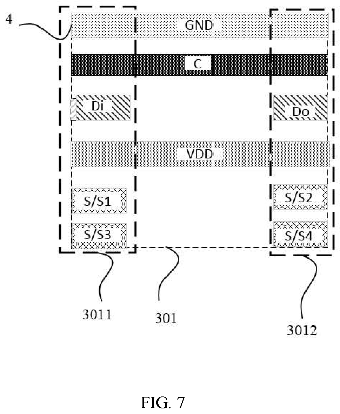

In specific implementation, as shown in FIG. 2, FIG. 4 to FIG. 6, and FIG. 8 to FIG. 16, each first pad 4 is in the first pad column 3011 or the second pad column 3012. Alternatively, as shown in FIG. 7, a specific kind of first pads 4 is partially in the first pad column 3011 and partially in the second pad column 3012. In FIG. 7, with the first pad region 301 includes a data pad C, a ground pad GND, and a power supply pad VDD as example, the data pad C is partially in the first pad column 3011 and partially in the second pad column 3012, the ground pad GND is partially in the first pad column 3011 and partially in the second pad column 3012, and the power supply pad VDD is partially in the first pad column 3011 and partially in the second pad column 3012. It should be understood that in this case, the sizes of the ground pad GND, the power supply pad VDD, and the data pad C are larger than the sizes of the other kinds of first pads.

In some embodiments, as shown in FIG. 2, FIG. 4 to FIG. 6, and FIG. 8 to FIG. 16, at least a part of a region of the at least one data pad C, the relay pad Do, and at least a part of a region of at least one ground pad GND are in the second pad column 3012. Since the second pad column 3012 is closer to the trunk portion gnd-1, at least a part of a region of at least one ground pad GND is in the second pad column 3012 to facilitate the ground pad GND to be connected to the trunk portion gnd-1 through the branch portion gnd-2.

It should be noted that in FIG. 2, FIG. 4 to FIG. 6, and FIG. 8 to FIG. 16, the entire region of at least one data pad C and the entire region of at least one ground pad GND are in the second pad column 3012 are illustrated as an example.

In some embodiments, as shown in FIG. 2, FIG. 4 to FIG. 6, and FIG. 8 to FIG. 16, at least one output pad S and at least a part of a region of at least one power supply pad VDD are in the first pad column 3011. Since the first pad column 3011 is closer to the first voltage line Vled, and the second pad region 302 is electrically connected to both the output pad S and the first voltage line Vled, at least one output pad S is in the first pad column 3011 which is closer to the first voltage line Vled, so as to reduce the difficulty of electrically connecting the second pad region 302 to the output pad S and the first voltage line Vled.

It should be noted that in FIG. 2, FIG. 4 to FIG. 6, and FIG. 8 to FIG. 16, an example is illustrated with the entire region of at least one power supply pad VDD is in the first pad column 3011.

In some embodiments, as shown in FIG. 2, FIG. 4, FIG. 8, FIG. 9, and FIG. 11 to FIG. 15, the address pad Di is in the second pad column 3012; that is, both the address pad Di and the relay pad Do are in the second pad column 3012.

An arrangement direction of an address pad Di and a relay pad Do in a second pad column 3012 is the same as a cascaded direction of a plurality of pad cells 3 in a pad cell column 2. For example, in the (2n-1)-th pad cell column 2, a cascaded direction of a plurality of pad cells 3 (i.e., an arrangement direction in accordance with an order of A3 and A4) is a direction pointing from the functional region 101 to the bonding region 102. In each first pad region 3, the arrangement direction of the address pad Di and the relay pad Do is also the direction pointing from the functional region 101 to the bonding region 102. In the 2n-th pad cell column 2, a cascaded direction of the plurality of pad cells 3 (i.e., an arrangement direction in accordance with an order of A1 and A2) is the direction pointing from the bonding region 102 to the functional region 101. In each first pad region 3, the arrangement direction of the address pad Di and the relay pad Do is also the direction pointing from the bonding region 102 to the functional region 101.

In the second pad column 3012 and in the first direction Y, an orthographic projection of the ground pad GND on the substrate 1 is between an orthographic projection of the address pad Di on the substrate 1 and an orthographic projection of the relay pad Do on the substrate 1.

In the wiring substrate provided by the embodiments of the disclosure, as shown in FIG. 2, FIG. 4, FIG. 8, FIG. 9, and FIG. 11 to FIG. 15, the orthographic projection of the ground pad GND on the substrate 1 is between the orthographic projection of the address pad Di on the substrate 1 and the orthographic projection of the relay pad Do on the substrate 1. That is, the arrangement direction of the address pad Di, the ground pad GND, and the relay pad Do is the same as the cascaded direction of the plurality of pad cells 3 in the pad cell column 2. In the pad cell column 2 and in the first direction Y, a relay pad Do of the i-th stage first pad region 301 and an address pad Di of the (i + 1)-th stage first pad region 301 are between a ground pad GND of the i-th stage first pad region 301 and a ground pad GND of the (i + 1)-th stage first pad region 301. Since an end of the second sub-segment D-1 is electrically connected to the relay pad Do of the i-th stage first pad region 301 and the other end of the second sub-segment D-1 is electrically connected to the address pad Di of the (i + 1)-th stage first pad region 301, an orthographic projection of the second sub-segment D-1 on the substrate 1 is between orthographic projections of two branch portions gnd-2 corresponding to two cascaded first pad regions 301 on the substrate 1, in one pad cell column 2 along the first direction Y, which can simplify the wiring difficulty of the traces, beneficial to rationally utilizing the wiring space to ensure the line width of the traces, and avoid interference between different kinds of traces.

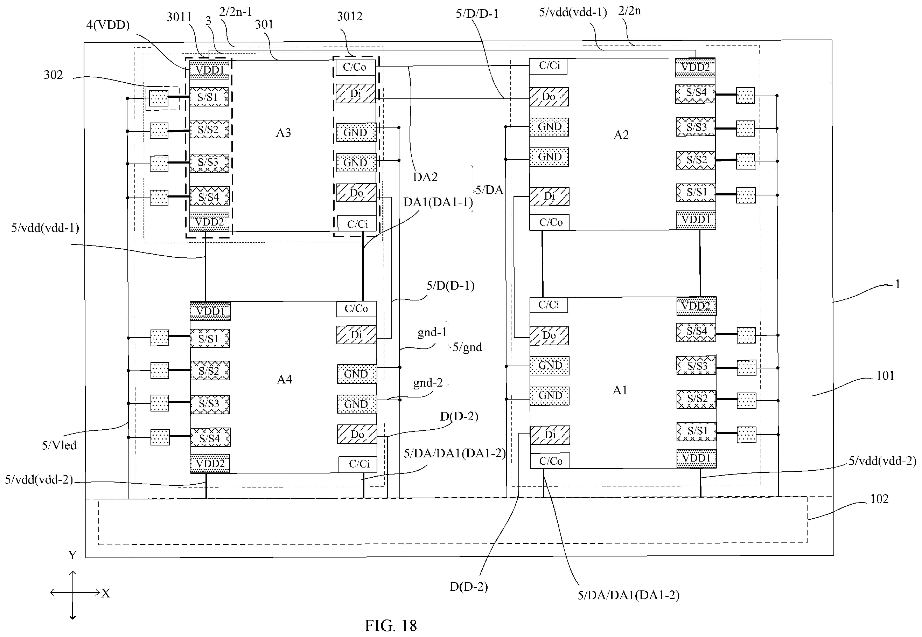

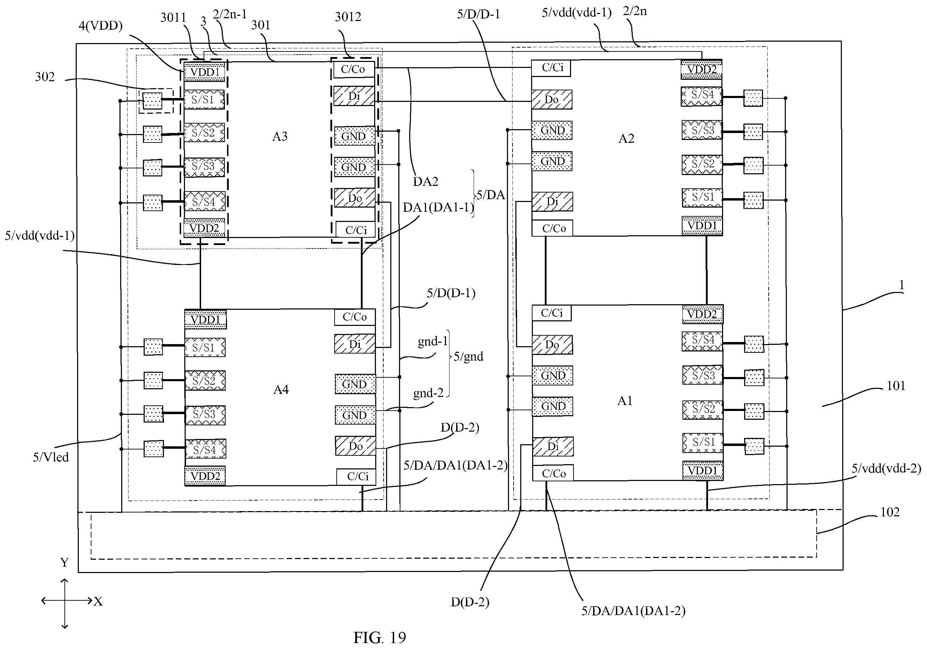

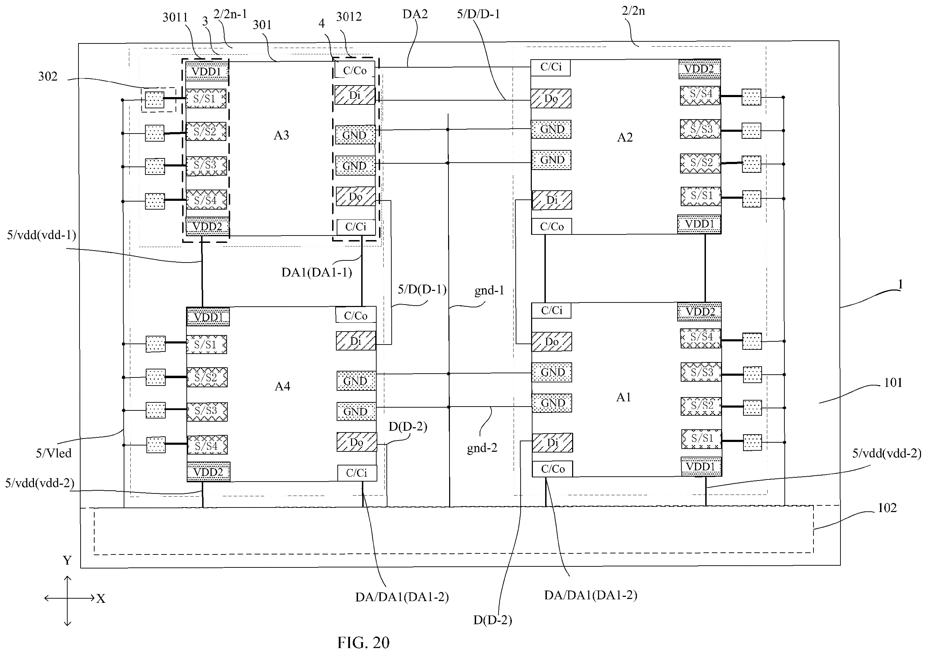

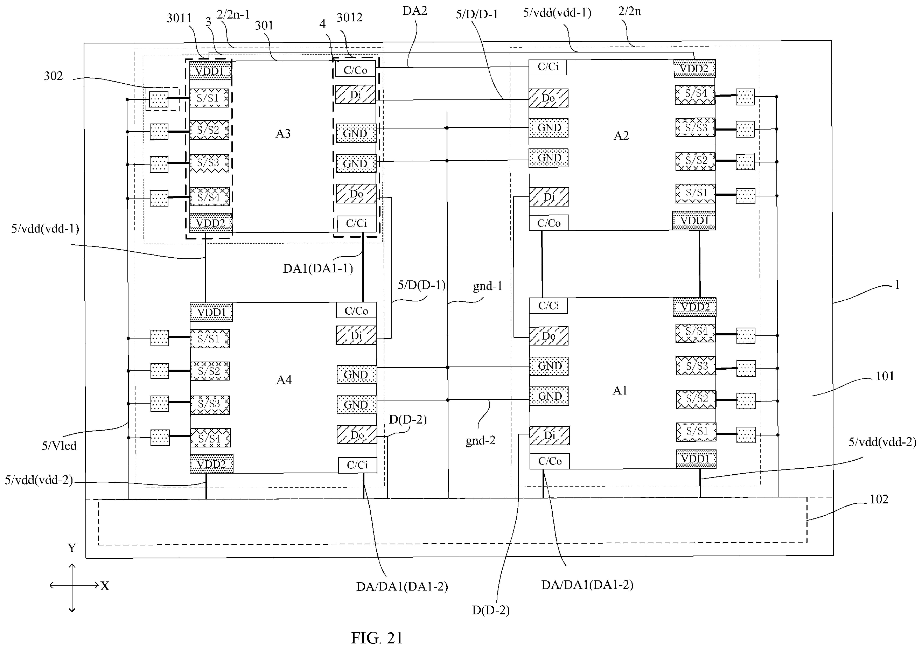

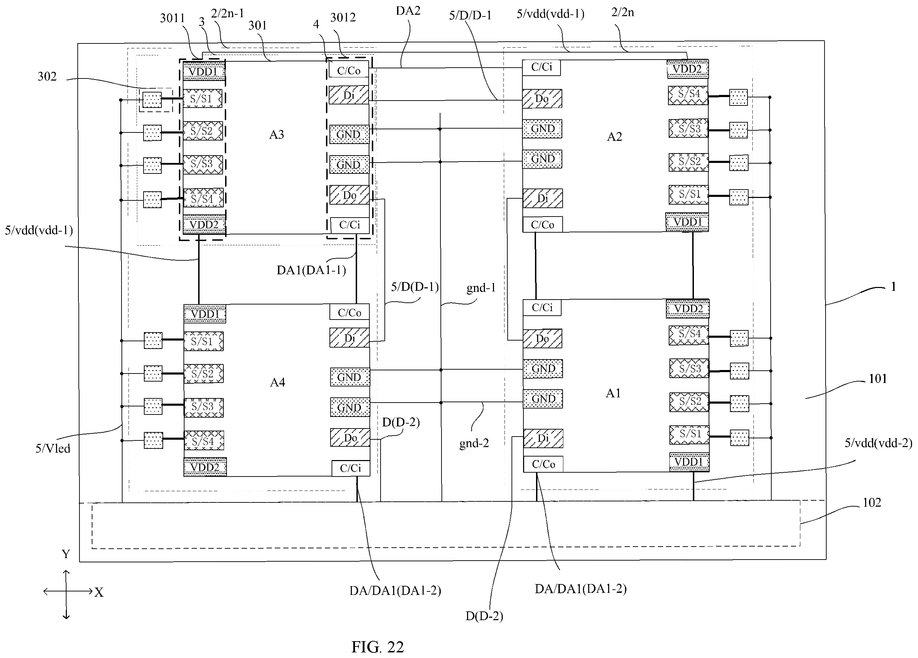

In some embodiments, as shown in FIG. 2, FIG. 4, FIG. 8, FIG. 9, FIGS. 11-15, and FIGS. 17-22, at least one data pad C includes a data input pad Ci and a data output pad Co. In each pad cell column 2, a data output pad Co in one of two cascaded first pad region 301 is electrically connected to a data input pad Ci in the other one of the two cascaded first pad region 301 through a first sub-segment DA1-1. The data input pad Ci and the data output pad Co are in the second pad column 3012.

In some embodiments, as shown in FIG. 2, FIG. 4, FIG. 8, FIG. 9, and FIGS. 11-15, in each pad cell column 2, a data output pad Co of the i-th stage first pad region 301 is electrically connected to a data input pad Ci of the (i + 1)-th stage first pad region 301 through the first sub-segment DA1-1, here, i is a positive integer.

In adjacent pad cell columns 2, an end of the second data signal line DA2 is electrically connected to a data output pad Co of the last stage first pad region 301 in one of the adjacent pad cell columns 2, and the other end of the second data signal line DA2 is electrically connected to a data input pad Ci of the first stage first pad region 301 in the other one of the adjacent pad cell columns 2.

An arrangement direction of the data input pad Ci and the data output pad Co is the same as a cascaded direction of a plurality of pad cells 3 in the pad cell column 2.

An orthographic projection of the address pad Di on the substrate 1 is between an orthographic projection of the data input pad Ci on the substrate 1 and the orthographic projection of the ground pad GND on the substrate 1, and an orthographic projection of the relay pad Do on the substrate 1 is between an orthographic projection of the data output pad Co on the substrate 1 and the orthographic projection of the ground pad GND on the substrate 1.

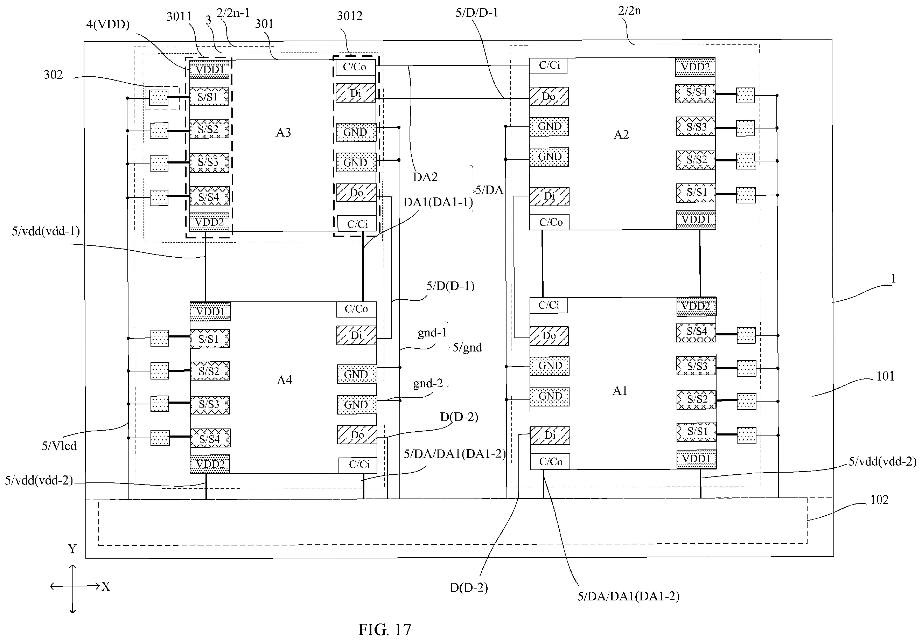

Alternatively, in some embodiments, as shown in FIGS. 17-22, in each pad cell column 2, a data input pad Ci of the i-th stage first pad region 301 is electrically connected to a data output pad Co of the (i + 1)-th stage first pad region 301 through the first sub-segment DA1-1, here i is a positive integer.

In adjacent pad cell columns 2, an end of the second data signal line DA2 is electrically connected to a data input pad Ci of the last stage first pad region 301 in one of the adjacent pad cell columns 2, and the other end of the second data signal line DA2 is electrically connected to a data output pad Co of the first stage first pad region 301 in the other one of the adjacent pad cell columns 2.

An arrangement direction of the data output pad Co and the data input pad Ci is the same as a cascaded direction of a plurality of pad cells 3 in the pad cell column 2.

An orthographic projection of the address pad Di on the substrate 1 is between an orthographic projection of the data output pad Co on the substrate 1 and the orthographic projection of the ground pad GND on the substrate 1, and an orthographic projection of the relay pad Do on the substrate 1 is between an orthographic projection of the data input pad Ci on the substrate 1 and the orthographic projection of the ground pad GND on the substrate 1.

That is, in specific implementation, the positions of the data input pad Ci and the data output pad Co can be interchanged.

In some embodiments, as shown in FIG. 2, FIG. 4, FIG. 8, FIG. 9, FIGS. 11-15, and FIGS. 17-22, the orthographic projection, on the substrate 1, of the second sub-segment D-1 that electrically connects two cascaded first pad regions 301 in the pad cell column 2 is between the orthographic projection of the first sub-segment DA1-1 on the substrate 1 and the orthographic projection of the trunk portion gnd-1 on the substrate 1.

In the wiring substrate provided by the embodiments of the disclosure, the data pad includes the data input pad Ci and the data output pad Co located in the second pad column, and the remaining first pads in the second pad column are between the data input pad Ci and the data output pad Co, which is beneficial to realizing that the data pads of the cascaded first pad region is connected through the first sub-segment, and can reduce the wiring difficulty.

In the wiring substrate provided by the embodiments of the disclosure, as shown in FIG. 2, FIG. 4, FIG. 8, FIG. 9, and FIGS. 11-15, an arrangement direction of the data input pad Ci, the address pad Di, the ground pad GND, the relay pad Do, and the data output pad Co is the same as the cascaded direction of the plurality of pad cells 3 in the pad cell column 2. In the pad cell column 2 and in the first direction Y, a data output pad Co of the i-th stage first pad region 301 and a data input pad Ci of the (i + 1)-th stage first pad region 301 are between a relay pad Do of the i-th stage first pad region 301 and an address pad Di of the (i + 1)-th stage first pad region 301. Since the data output pad Co of the i-th stage first pad region 301 is electrically connected to the data input pad Ci of the (i + 1)-th stage first pad region 301 through the first sub-segment DA1-1, the orthographic projections of the first sub-segment DA1-1 and the second sub-segment D-1 on the substrate 1 are between the orthographic projections of the two branch portions gnd-2 corresponding to the two cascaded first pad regions 301 on the substrate 1, in one pad cell column 2 along the first direction Y. Alternatively, as shown in FIGS. 17-22, an arrangement direction of the data output pad Co, the address pad Di, the ground pad GND, the relay pad Do, and the data input pad Ci is the same as the cascaded direction of the plurality of pad cells 3 in the pad cell column 2. In the pad cell column 2 and in the first direction Y, a data input pad Ci of the i-th stage first pad region 301 and a data output pad Co of the (i + 1)-th stage first pad region 301 are between a relay pad Do of the i-th stage first pad region 301 and an address pad Di of the (i + 1)-th stage first pad region 301. Since the data input pad Ci of the i-th stage first pad region 301 is electrically connected to the data output pad Co of the (i + 1)-th stage first pad region 301 through the first sub-segment DA1-1, the orthographic projections of the first sub-segment DA1-1 and the second sub-segment D-1 on the substrate 1 are between the orthographic projections of the two branch portions gnd-2 corresponding to the two cascaded first pad regions 301 on the substrate 1, in the first direction Y along the one pad cell column. Thus, the orthographic projection of the second sub-segment D-1 that electrically connects two cascaded first pad regions 301 in the pad cell column 2 on the substrate 1 is between the orthographic projection of the first sub-segment DA1-1 on the substrate 1 and the orthographic projection of the trunk portion gnd-1 on the substrate 1, which can simplify the wiring difficulty of the traces, save the wiring space, and avoid interference between different kinds of traces.

In some embodiments, as shown in FIG. 2, FIG. 4, FIG. 8, FIG. 9, FIGS. 11-15, and FIGS. 17-22, the orthographic projection of the second data signal line DA2 on the substrate 1 is at the side of the orthographic projection of the branch portion gnd-2 on the substrate 1 away from the bonding region 102.

The orthographic projection of the second sub-segment D-1 that electrically connects two adjacent pad cell columns 2 on the substrate 1 is between the orthographic projection of the second data signal line DA2 on the substrate 1 and the orthographic projection of the branch portion gnd-2 on the substrate 1.

In the wiring substrate provided by the embodiments of the disclosure, as shown in FIG. 2, FIG. 4, FIG. 8, FIG. 9, FIGS. 11-15, and FIGS. 17-22, in two first pad regions 3 that are farthest from the bonding region 102 in two pad cell columns 2 of a cascaded loop, the address pad Di and the relay pad Do electrically connected through the second sub-segment D-1 are at a side of the ground pad GND away from the bonding region 102. Since multiple kinds of first pads 4 in a first pad region 301 that is rotated by 180° in the 2n-th pad cell column 2 is arranged in the same manner as multiple kinds of first pads 4 in a first pad region 301 in the (2n-1)-th pad cell column 2, in the two first pad regions 3 farthest from the bonding region 102 in the two pad cell columns 2 in the cascaded loop, the data input pad Ci and the data output pad Co electrically connected through the second data signal line DA2 each is at a position in the second pad column 3012 farthest from the bonding region 102. Thus, it can be set that the second data signal line DA2 is connected to the data input pad Ci and the data output pad Co in a region between the two pad cell columns 2, and the second sub-segment D-1 is connected to the address pad Di and the relay pad Do in the region between the two pad cell columns 2. It can also be set that the orthographic projection of the second data signal line DA2 on the substrate 1 and the orthographic projection of the second sub-segment D-1 that electrically connects two adjacent pad cell columns 2 on the substrate 1 are at a side of the trunk portion gnd-1 and the branch portion gnd-2 away from the bonding region 102, and the orthographic projection of the second sub-segment D-1 that electrically connects two adjacent pad cell columns 2 on the substrate 1 is between the orthographic projection of the second data signal line DA2 on the substrate 1 and the orthographic projection of the branch portion gnd-2 on the substrate 1. The second data signal line DA2, the second sub-segment D-1, the branch portion gnd-2, and the trunk portion gnd-1 will not interfere with each other, which can reduce the wiring difficulty and save the wiring space.

In some embodiments, as shown in FIG. 2, FIG. 4, FIG. 8, FIG. 9, and FIGS. 11-15, for two pad cell columns 2 in a cascaded loop, a data input pad Ci in the first pad region 301 (A1) in the first stage pad cell 3 is electrically connected to a bonding electrode (not shown) of the bonding region 102 through a fourth sub-segment DA1-2, and a data output pad Co in the first pad region 301 (A4) in the last stage pad cell 3 is electrically connected to a bonding electrode (not shown) of the bonding region 102 through a fourth sub-segment DA1-2.

Alternatively, in some embodiments, as shown in FIGS. 17-22, for two pad cell columns 2 in a cascaded loop, a data output pad Co of the first pad region 301 (A1) in the first stage pad cell 3 is electrically connected to a bonding electrode (not shown) of the bonding region 102 through a fourth sub-segment DA1-2, and a data input pad Ci of the first pad region 301 (A4) in the last stage pad cell 3 is electrically connected to a bonding electrode (not shown) of the bonding region 102 through the fourth sub-segment DA1-2.

In some embodiments, as shown in FIGS. 2-5, FIG. 8, FIG. 9, FIGS. 11-15, and FIGS. 17-22, in the second direction X, a data output pad Co in the first pad region 301 and a data input pad Ci in the first pad region 301 after being rotated 180° are in a same row. An address pad Di of the first pad region 301 and a relay pad Do in the first pad region 301 after being rotated 180° are in a same row. The second data signal line DA2 extends along the second direction X. The second sub-segment D-1 that electrically connects two adjacent pad cell columns 2 extends along the second direction X.

In some embodiments, as shown in FIG. 2, FIG. 4, FIG. 8, FIG. 9, FIGS. 11-15, and FIGS. 17-22, at least one power supply pad VDD includes a first power supply pad VDD1 and a second power supply pad VDD2. Both the first power supply pad VDD1 and the second power supply pad VDD2 are in the first pad column 3011.

An arrangement direction of the first power supply pad VDD1 and the second power supply pad VDD2 in the first pad column 3011 is the same as a cascaded direction of the plurality of pad cells 3 in the pad cell column 2. For example, in the (2n-1)-th pad cell column 2, a cascaded direction (i.e., an arrangement direction in the order of A3 and A4) of a plurality of pad cells 3 is a direction pointing from the functional region 101 to the bonding region 102, and in each first pad region 3, an arrangement direction of the first power supply pad VDD1 and the second power supply pad VDD2 is also the direction pointing from the functional region 101 to the bonding region 102. In the 2n-th pad cell column 2, a cascading direction (i.e., an arrangement direction in the order of A1 and A2) of a plurality of pad cells 3 is a direction pointing from the bonding region 102 to the functional region 101, and in each first pad region 3, the arrangement direction of the first power supply pad VDD1 and the second power supply pad VDD2 is also the direction pointing from the bonding region 102 to the functional region 101.

In the first direction Y, the orthographic projection of the output pad S on the substrate 1 is between an orthographic projection of the first power supply pad VDD1 on the substrate 1 and an orthographic projection of the second power supply pad VDD2 on the substrate 1.

An end of the third sub-segment vdd-1 is electrically connected to a second power supply pad VDD2 of one first pad region 301, and the other end of the third sub-segment vdd-1 is electrically connected to a first power supply pad VDD1 of a first pad region 301 of the next stage of the one first pad region 301.

In the wiring substrate provided by the embodiments of the disclosure, the first pad region includes a plurality of power supply pads, so that the number of first pads in the first pad column and the number of first pads in the second pad column can be balance, and the first pad column and the second pad column include an equal number of pads, which can improve the thickness homogeneity of the first pad region, and thus can improve the effect of the first pad region in supporting the driver chip, can improve the gravity center balance of the driver chip, and can further improve the reliability of the electrical connection between the driver chip and the first pad. Moreover, the remaining pads in the first pad column are between the first power supply pad and the second power supply pad, and a first power supply pad and a second power supply pad respectively located in two cascaded first pad regions in the pad cell column are adjacent to each other, which facilitates the electrical connection between the cascaded power supply pads through the third sub-segment and is more conducive to reducing the wiring difficulty.

In the wiring substrate provided by the embodiments of the disclosure, as shown in FIG. 2, FIG. 4, FIG. 8, FIG. 9, FIGS. 11-15, and FIGS. 17-22, the first power supply pad VDD1 and the second power supply pad VDD2 are in the first pad column 3011, which can fully utilize the wiring space and avoid the third sub-segment vdd-1 interfering with the first sub-segment DA1-1 and the second sub-segment D-1. Moreover, the arrangement direction of the first power supply pad VDD1, the output pad S, and the second power supply pad VDD2 is the same as the cascaded direction of the plurality of pad cells 3 in the pad cell column 2. Thus, in one pad cell column 2, the first power supply pad VDD1 and the second power supply pad VDD2 respectively located in two cascaded first pad regions 301 are adjacent to each other in the first direction Y, which can reduce the wiring difficulty of electrically connecting the first power supply pad VDD1 and the second power supply pad VDD2 through the third sub-segment vdd-1.

In some embodiments, as shown in FIG. 2, FIG. 4, FIG. 8, FIG. 9, FIGS. 11-15 and FIGS. 17-22, for two pad cell columns 2 in a cascaded loop, a first power supply pad VDD1 in the first pad region 301 (A1) in the first stage pad cell 3 is electrically connected to a bonding electrode (not shown) of the bonding region 102 through a sixth sub-segment vdd-2, and a second power supply pad VDD2 in the first pad region 301 (A4) in the last stage pad cell 3 is electrically connected to a bonding electrode (not shown) of the bonding region 102 through a sixth sub-segment vdd-2.

In some embodiments, as shown in FIG. 2, FIG. 4, FIG. 8, FIG. 9, FIGS. 11-15 and FIGS. 17-22, in the second direction X, the power supply pad VDD and the data pad C are in a same row.

In some embodiments, as shown in FIG. 2, FIG. 4, FIG. 8, FIG. 9, and FIGS. 11-15, in the second direction X, the first power supply pad VDD1 and the data input pad Ci are in a same row, and the second power supply pad VDD2 and the data output pad Co are in a same row.

Alternatively, in some embodiments, as shown in FIGS. 17-22, in the second direction X, the first power supply pad VDD1 and the data output pad Co are in a same row, and the second power supply pad VDD2 and the data input pad Ci are in a same row.

In some embodiments, as shown in FIG. 2, FIG. 4, FIG. 8, FIG. 9, FIGS. 11-15 and FIGS. 17-22, the first pad region 301 includes a plurality of output pads S, and the plurality of output pads S included in the first pad region 301 are all in the first pad column 3011. In the first direction Y, orthographic projections of the plurality of output pads S on the substrate 1 are between the orthographic projection of the first power supply pad VDD1 on the substrate 1 and the orthographic projection of the second power supply pad VDD2 on the substrate 1. Thus, mutual interference between the traces electrically connected the output pads S to the second pad region 302 and the third sub-segment vdd-1 can be avoided, and the wiring difficulty can be reduced.

In some embodiments, as shown in FIG. 2, FIG. 4, FIG. 8, FIG. 9, FIGS. 11-15 and FIGS. 17-22, the first pad region 301 includes a plurality of ground pads GND, and the plurality of ground pads GND are all in the second pad column 3012.

In the wiring substrate provided by the embodiments of the disclosure, when the first pad region includes the plurality of output pads, the first pad region includes the plurality of ground pads, so that the number of first pads in the first pad column and the number of the second pad column can be balanced to make that the number of pads included in the first pad column and the number of pads in the second pad column are equal, which can improve the thickness homogeneity of the first pad region, can improve the effect of the first pad region in supporting the driver chip, can improve the gravity center balance of the driver chip, and can further improve the reliability of the electrical connection between the driver chip and the first pad.

It should be noted that in FIG. 2, FIG. 4, FIG. 8, FIG. 9, FIGS. 11-15 and FIGS. 17-22, the first pad region including four output pads S and two ground pads GND is taken as an example for illustration. In specific implementation, the number of output pads S and the number of ground pads GND can be set according to actual needs.

It should be noted that in FIG. 2, FIG. 4, FIG. 8, FIG. 9, FIGS. 11-15 and FIGS. 17-22, the data pad C being only in the second pad column 3012 is taken as an example for illustration. Of course, in specific implementation, both the first pad column 3011 and the second pad column 3012 may include the data pad C.

In some embodiments, as shown in FIG. 6, FIG. 10 and FIG. 16, the address pad Di and at least a part of a region of at least one data pad C are in the first pad column 3011.

An arrangement direction of the data pad C, the address pad Di, the power supply pad VDD and the output pad S in the first pad column 3011 is the same as the cascaded direction of the plurality of pad cells 3 in the pad cell column 2; and an arrangement direction of the ground pad GND, the data pad C and the relay pad Do in the second pad column 3012 is the same as the cascaded direction of the plurality of pad cells 3 in the pad cell column 2.

An end of the first sub-segment DA1-1 is electrically connected to the data pad C in the second pad column 3012, and the other end of the first sub-segment DA1-1 is electrically connected to the data pad C in the first pad column 3011.

An orthographic projection of the first sub-segment DA1-1 on the substrate 1 is between an orthographic projection of the second sub-segment D-1 on the substrate 1 and an orthographic projection of the trunk portion gnd-1 on the substrate 1.

In specific implementation, as shown in FIG. 6, FIG. 10 and FIG. 16, both the first pad column 3011 and the second pad column 3012 include the data pad C. The address pad Di and the relay pad Do are in the first pad column 3011 and the second pad column 3012, respectively. The two ends of the first sub-segment DA1-1 are electrically connected to the first pad cell column 3011 and the second pad cell column 3012, respectively, and the two ends of the second sub-segment D-1 are electrically connected to the first pad cell column 3011 and the second pad cell column 3012, respectively. Thus, the orthographic projection of the first sub-segment DA1-1 on the substrate 1 passes through a region between first pad regions 301 adjacent to each other, and the orthographic projection of the second sub-segment D-1, which is electrically connected to two cascaded first pad regions 301 in the pad cell column 2, on the substrate 1 also passes through the region between the adjacent first pad regions 301. As a result, the layout of the traces for the cascading of pad cells may utilize the region between the first pad regions that are adjacent to each other, which may reduce the wiring difficulty.

In specific implementation, for example, both the first sub-segment and the second sub-segment are led out from a side of the second pad column facing the trunk portion, pass through the region between the adjacent first pad regions, and extend to a region between the first pad region and the first voltage line.

In specific implementation, as shown in FIG. 6, FIG. 10 and FIG. 16, the arrangement direction of the ground pad GND, the data pad C, and the relay pad Do in the second pad column 3012 is the same as the cascaded direction of the plurality of pad cells 3 in the pad cell column 2. Thus, the arrangement direction of the branch portion gnd-2, the first sub-segment DA1-1, and the second sub-segment D-1 electrically connected to two cascaded first pad regions 301 in the pad cell column 2 is the same as the cascaded direction of the plurality of pad cells 3 in the pad cell column 2, so as to avoid mutual interference among the branch portion gnd-2, the first sub-segment DA1-1, and the second sub-segment D-1 while realizing the cascading of the first pad regions through the first sub-segment DA1-1 and the second sub-segment D-1. Accordingly, the arrangement direction of the data pad C and the address pad Di in the first pad column 3011 is the same as the cascaded direction of the plurality of pad cells 3 in the pad cell column 2, so that the orthographic projection of the first sub-segment DA1-1 on the substrate 1 is between the orthographic projection of the second sub-segment D-1 on the substrate 1 and the orthographic projection of the trunk portion gnd-1 on the substrate 1, thus avoiding mutual interference between the first sub-segment DA1-1 and the second sub-segment D-1.

In some embodiments, as shown in FIG. 6, FIG. 10 and FIG. 16, at least a part of a region of at least one power supply pad VDD is in the second pad column 3012. The arrangement direction of the ground pad GND, the data pad C, the relay pad Do, and the power supply pad VDD in the second pad column 3012 is the same as the cascaded direction of the plurality of pad cells 3 in the pad cell column 2.

An end of the third sub-segment vdd-1 is electrically connected to the power supply pad VDD in the second pad column 3012, and the other end of the third sub-segment vdd-1 is electrically connected to the power supply pad VDD in the first pad column 3011.

The orthographic projection, on the substrate 1, of the second sub-segment D-1 electrically connected to two cascaded first pad regions 301 in the pad cell column 2 is between the orthographic projection of the first sub-segment DA1-1 on the substrate 1 and the orthographic projection of the third sub-segment vdd-1 electrically connected to the two cascaded first pad regions 301 in the pad cell column 2 on the substrate 1.

In specific implementation, the third sub-segment is also led out from the side of the second pad column facing the trunk portion, passes through the region between first pad regions that are adjacent to each other in the first direction Y, and extends to the region between the first pad region and the first voltage line.

In specific implementation, as shown in FIG. 6, FIG. 10 and FIG. 16, the first sub-segment DA1-1, the second sub-segment D-1 that connects two cascaded first pad regions in the pad cell column, and the third sub-segment vdd-1 are folded line segments (e.g., having a "square waves" like shape). The folded line segment includes a plurality of first line segments 10 and second line segments 11 that extend in different directions and are alternately connected end-to-end. In FIG. 6, FIG. 10 and FIG. 16, an extension direction of the first line segment 10 is perpendicular to an extension direction of the second line segment 11.

In some embodiments, as shown in FIG. 6, FIG. 10 and FIG. 16, in a plurality of traces 5 that are electrically connected to two cascaded first pad regions 301 in the pad cell column 2, an arrangement direction of the first sub-segment DA1-1, the second sub-segment D-1, and the third sub-segment vdd-1 in the first direction Y is the same as the cascaded direction of the plurality of pad cells 3 in the pad cell column 2.

In a plurality of traces 5 that are electrically connected to two cascaded first pad regions 301 respectively located in two pad cell columns 2, the second data signal line DA2, the second sub-segment D-1, and the third sub-segment vdd-1 are sequentially arranged in the direction pointing from the bonding region 102 to the functional region 101.

In the wiring substrate provided by the embodiments of the disclosure, the arrangement direction of the ground pad, the data pad, the relay pad, and the power supply pad in the second pad column is the same as the arrangement direction of the branch portion, the first sub-segment, the second sub-segment, and the third sub-segment. The arrangement direction of the data pad, the address pad, and the power supply pad in the first pad column is the same as the arrangement direction of the first sub-segment, the second sub-segment, and the third sub-segment. That is, for multiple kinds of traces that cascade the pad cells in the pad cell column, an arrangement order of different traces matches an arrangement order of corresponding first pads, which can avoid mutual interference between different traces. Moreover, the second data signal line, the second sub-segment connecting two adjacent pad columns, and the third sub-segment connecting the two adjacent pad columns are all at a side of the branch portion and the trunk portion away from the bonding region. For the first pad column and the second pad column that are respectively located in two pad cell columns and are cascaded, the arrangement direction of the data pad, the relay pad, and the power supply pad in the second pad column, the arrangement direction of the data pad, the address pad, and the power supply pad in the first pad column, and the arrangement direction of the second data signal line, the second sub-segment connecting two adjacent pad columns, and the third sub-segment connecting two adjacent pad columns are matched, which can simplify the wiring difficulty, is beneficial to reasonably utilizing the wiring space to ensure the line width of the traces, and can avoid mutual interference between the traces connected to two pad columns that are adjacent to each other.

In specific implementation, the second data signal line, the second sub-segment connecting two adjacent pad columns, and the third sub-segment connecting two adjacent pad columns are also connected by the alternately first line segment 10 and the second line segment 11 with different extension directions.

In some embodiments, as shown in FIG. 6, FIG. 10, FIG. 16, FIG. 23, and FIG. 24, at least one data pad C includes: a data input pad Ci and a data output pad Co; one of the data input pad Ci and the data output pad Co is in the first pad column 3011, and the other one of the data input pad Ci and the data output pad Co is in the second pad column 3012.

In some embodiments, as shown in FIG. 6, FIG. 10, and FIG. 16, the data input pad Ci is in the first pad column 3011, and the data output pad Co is in the second pad column 3012. In each pad cell column 2, a data output pad Co of the i-th stage first pad region 301 is electrically connected to a first portion of the first sub-segment DA1-1, and the data output pad Co of the i-th stage first pad region 301 is electrically connected to a data input pad Ci of the (i + 1)-th stage first pad region 301 through the first sub-segment DA1-1; here i is a positive integer.

In adjacent pad cell columns 2, an end of the second data signal line DA2 is electrically connected to a data output pad Co of the last stage first pad region 301 in one of the adjacent pad cell columns 2, and the other end of the second data signal line DA2 is electrically connected to a data input pad Ci of the first stage first pad region 301 in the other one of the adjacent pad cell columns 2.

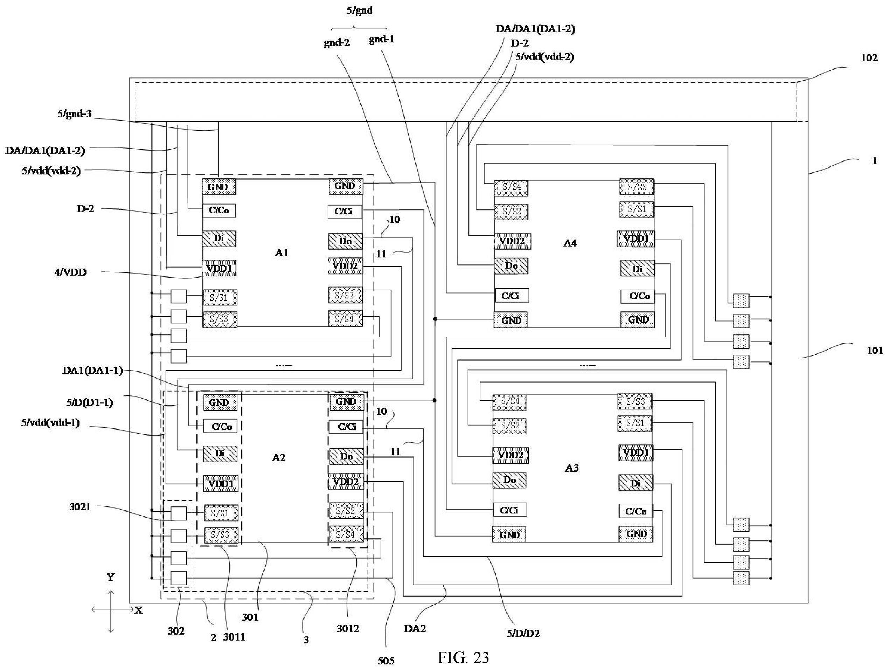

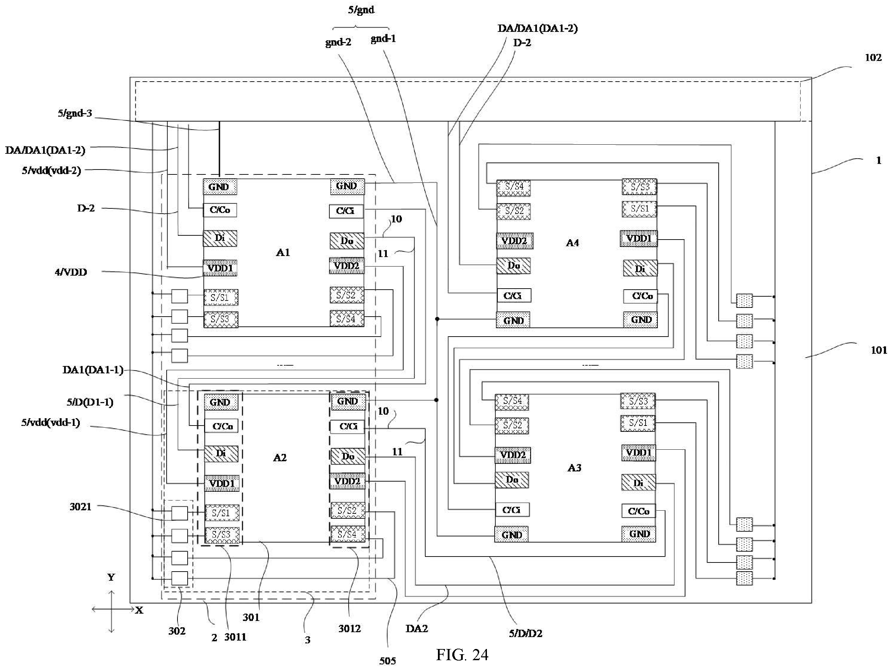

Alternatively, in some embodiments, as shown in FIG. 23 and FIG. 24, the data output pad Co is in the first pad column 3011, and the data input pad Ci is in the second pad column 3012. In each pad cell column 2, a data input pad Ci of the i-th stage first pad region 301 is electrically connected to a first portion of the first sub-segment DA1-1, and the data input pad Ci of the i-th stage first pad region 301 is electrically connected to a data output pad Co of the (i + 1)-th stage first pad region 301 through the first sub-segment DA1-1; here i is a positive integer.

In the adjacent pad cell columns 2, an end of the second data signal line DA2 is electrically connected to a data input pad Ci of the last stage first pad region 301 in one of the adjacent pad cell columns 2, and the other end of the second data signal line DA2 is electrically connected to a data output pad Co of the first stage first pad region 301 in the other one of the adjacent pad cell columns 2.

In the wiring substrate provided by the embodiments of the disclosure, the first pad region includes two data pads located in different pad columns, which can balance the number of first pads in the first pad column and the number of the second pad column, improve the thickness homogeneity of the first pad region, improve the effect of the first pad region in supporting the driver chip, improve the gravity center balance of the driver chip, and further improve the reliability of the electrical connection between the driver chip and the first pad.

In some embodiments, as shown in FIG. 6, FIG. 10, FIG. 16, FIG. 23, and FIG. 24, at least one power supply pad VDD includes: a first power supply pad VDD1 and a second power supply pad VDD2; the first power supply pad VDD1 is in the first pad column 3011, and the second power supply pad VDD2 is in the second pad column 3012.

A second power supply pad VDD2 of the i-th stage first pad region 301 is electrically connected to a first power supply pad VDD1 of the (i + 1)-th stage first pad region 301 through the third sub-segment vdd-1.

In the wiring substrate provided by the embodiments of the disclosure, the first pad region includes a plurality of power supply pads, so that the number of first pads in the first pad column and the number of first pads the second pad column can be balanced, and the number of pads included in the first pad column is equal to the number of pads included in the second pad column, which can improve the thickness homogeneity of the first pad region, improve the effect of the first pad region in supporting the driver chip, improve the gravity center balance of the driver chip, and can further improve the reliability of the electrical connection between the driver chip and the first pad. It is more conducive to reducing the wiring difficulty to realize the cascaded power supply pads electrically connected with each other through the third sub-segment.

In some embodiments, as shown in FIG. 6, FIG. 10, FIG. 16, FIG. 23 and FIG. 24, the first pad region 301 includes a plurality of output pads S. Some of the output pads S are in the second pad column 3012.In the second direction X, the output pads S in the second pad column 3012 are at a side of the second power supply pad VDD2 away from the relay pad Do.

In specific implementation, as shown in FIG. 6, FIG. 10, FIG. 16, FIG. 23 and FIG. 24, when the first pad region 301 includes a plurality of output pads S and some of the output pads S are in the second pad column 3012, the fifth connection lead 505 electrically connected to the output pads S in the second pad column 3012 passes through a region between the cascaded first pad regions 301. In the second direction X, the output pad S is at a side of the second power supply pad VDD2 away from the relay pad Do. an arrangement order of the fifth connection lead 505 and the third sub-segment vdd-1 matches an arrangement order of the output pads S and the second power supply pad VDD2, which can avoids the interference between the fifth connection lead 505 and the third sub-segment vdd-1, simplify the wiring difficulty, and save the wiring space.

In some embodiments, as shown in FIG. 6, FIG. 10, FIG. 16, FIG. 23 and FIG. 24, the first pad region 301 includes two ground pads GND, and the two ground pads GND are respectively in the first pad column 3011 and the second pad column 3012; in the first direction Y, the two ground pads GND are in the same row.

In the first pad column 3011, the ground pad GND is at a side of the data pad C facing away from the address pad Di; as shown in FIG. 6, FIG. 10 and FIG. 16, in the first pad column 3011, the ground pad GND is at a side of the data input pad Ci facing away from the address pad Di; alternatively, as shown in FIG. 23 and FIG. 24, in the first pad column 3011, the ground pad GND is at a side of the data output pad Co facing away from the address pad Di.

In the second pad column 3012, the ground pad GND is at a side of the data pad C facing away from the relay pad Do; as shown in FIG. 6, FIG. 10 and FIG. 16, in the second pad column 3012, the ground pad GND is at a side of the data output pad Co facing away from the relay pad Do; alternatively, as shown in FIG. 23 and FIG. 24, in the first pad column 3011, the ground pad GND is at a side of the data input pad Ci facing away from the relay pad Do.

In the second direction X, the data input pad Ci and the data output pad Co are in the same row, the address pad Di and the relay pad Do are in the same row, and the first power supply pad VDD1 and the second power supply pad VDD2 are in the same row.

The wiring substrate provided by the embodiments of the disclosure, when the first pad region includes a plurality of output pads, the first pad region includes a plurality of ground pads, so that the number of first pads in the first pad column and the number of first pads in the second pad column can be balanced to make the number of pads included in the first pad column is equal to the number of pads included in the second pad column, which can improve the thickness homogeneity of the first pad region, and can improve the effect of the first pad region in supporting the driver chip, and thus can improve the gravity center balance of the driver chip, and can further improve the reliability of the electrical connection between the driver chip and the first pad.

In some embodiments, as shown in FIG. 6, FIG. 10, FIG. 16, FIG. 23 and FIG. 24, the trace 5 further includes: a seventh sub-segment gnd-3; an end of the seventh sub-segment gnd-3 is electrically connected to a bonding electrode (not shown) of the bonding region 102, and the other end of the seventh sub-segment gnd-3 is electrically connected to a ground pad GND in the first stage pad cell 3 in a cascaded loop, and the ground pad GND is in the first pad column 3011.

In some embodiments, when the first pad region 301 includes the plurality of data pads C, namely a data input pad Ci and a data output pad Co. It is necessary to set the data input pad Ci electrically connected to the data output pad Co.

In some embodiments, when the wiring substrate is applied to a light-emitting substrate, that is, a first pad region is bonded to a driver chip, the data input pad Ci and the data output pad Co belonging to the same first pad region may be electrically connected through the driver chip. That is, a circuit electrically connecting the data input pad Ci with the data output pad Co is included within the driver chip. As shown in FIG. 2, FIG. 4, FIG. 6, and FIGS. 11-24, the data input pad Ci and the data output pad Co in the first pad region 301 are not directly connected through a trace set on the substrate.

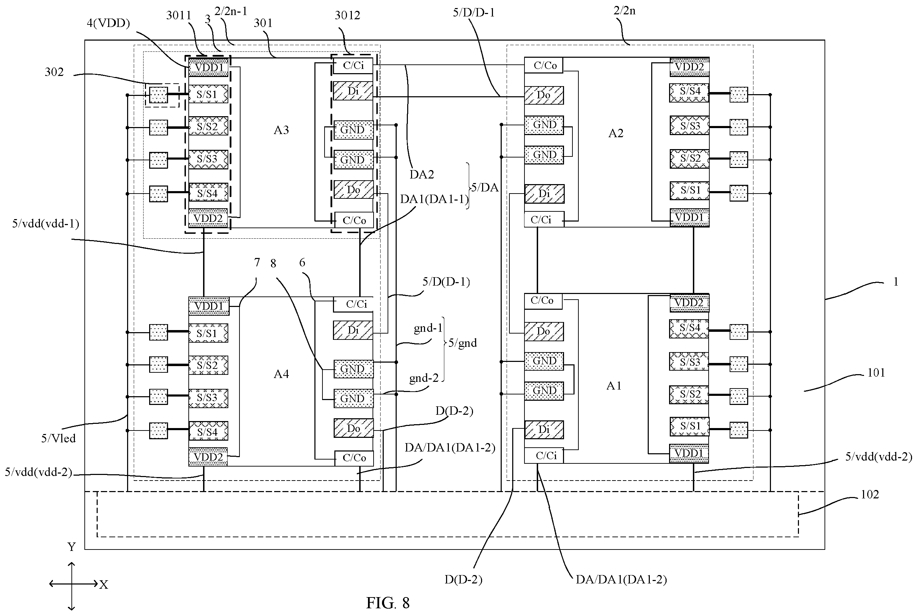

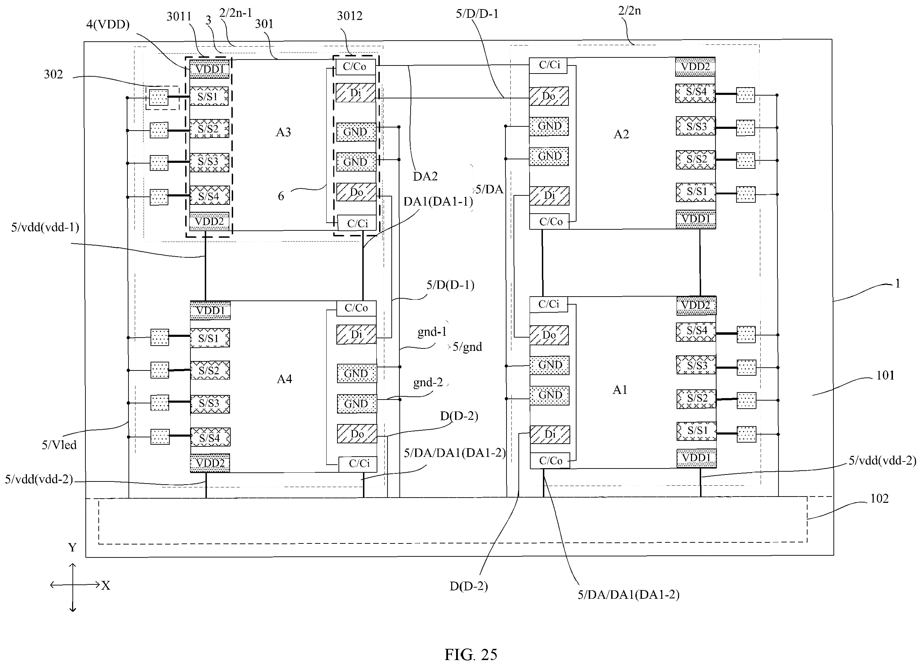

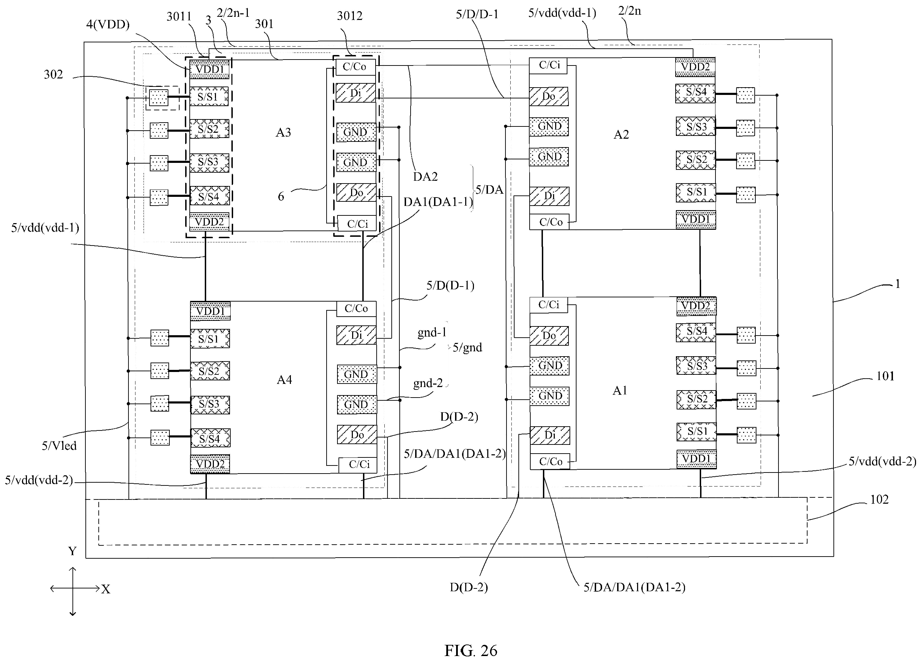

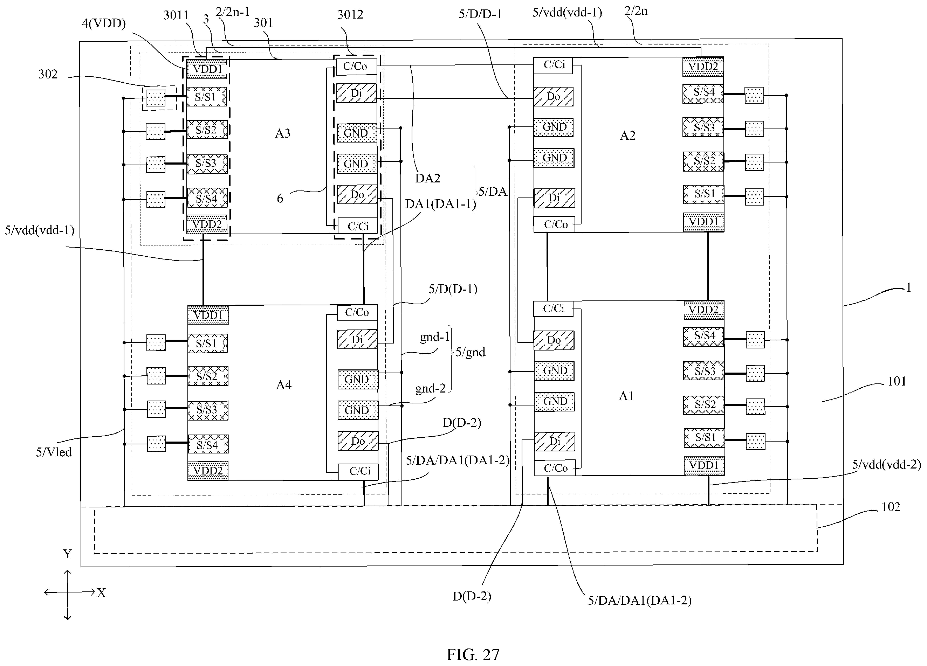

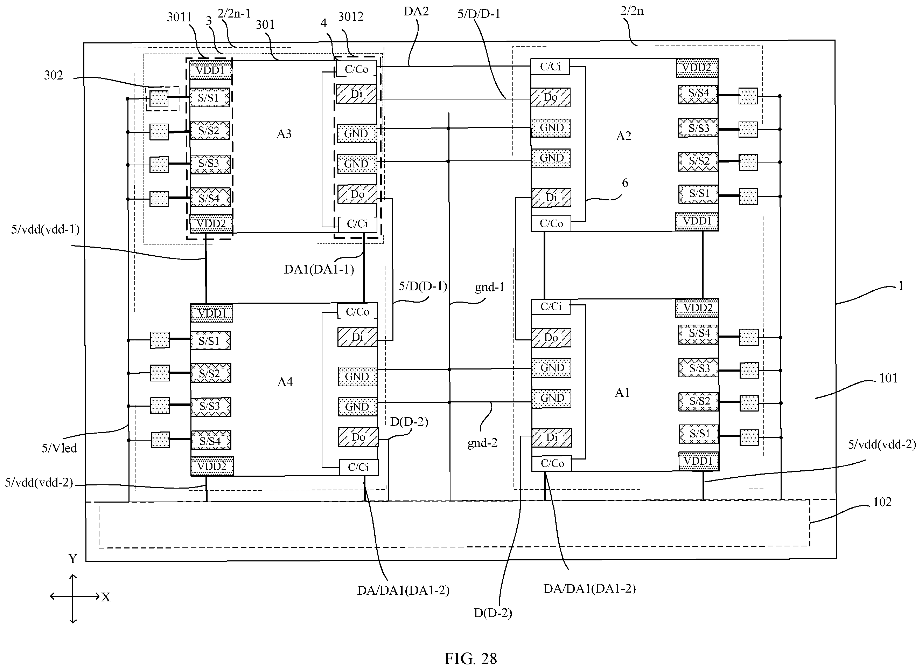

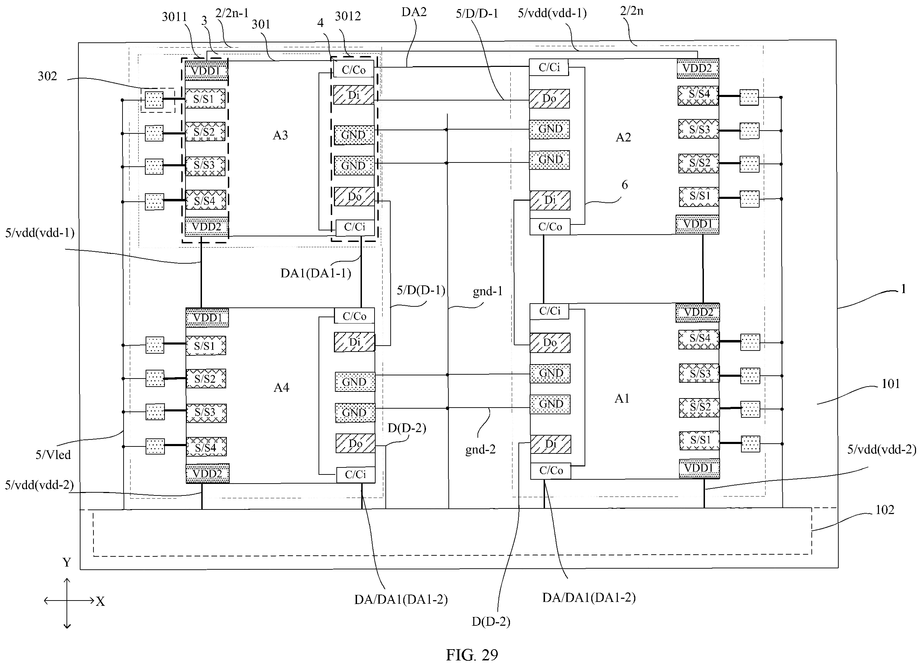

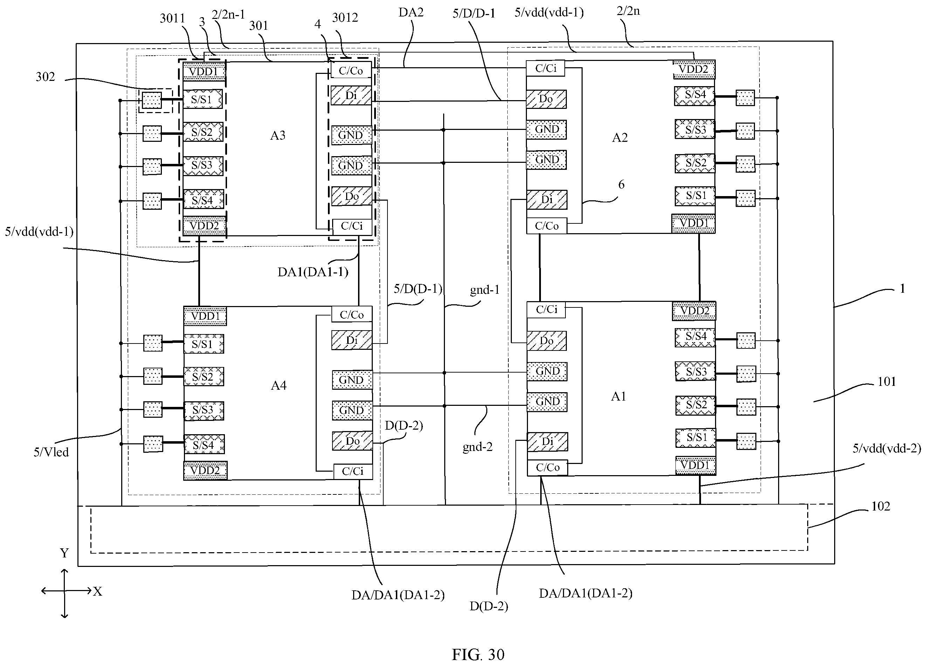

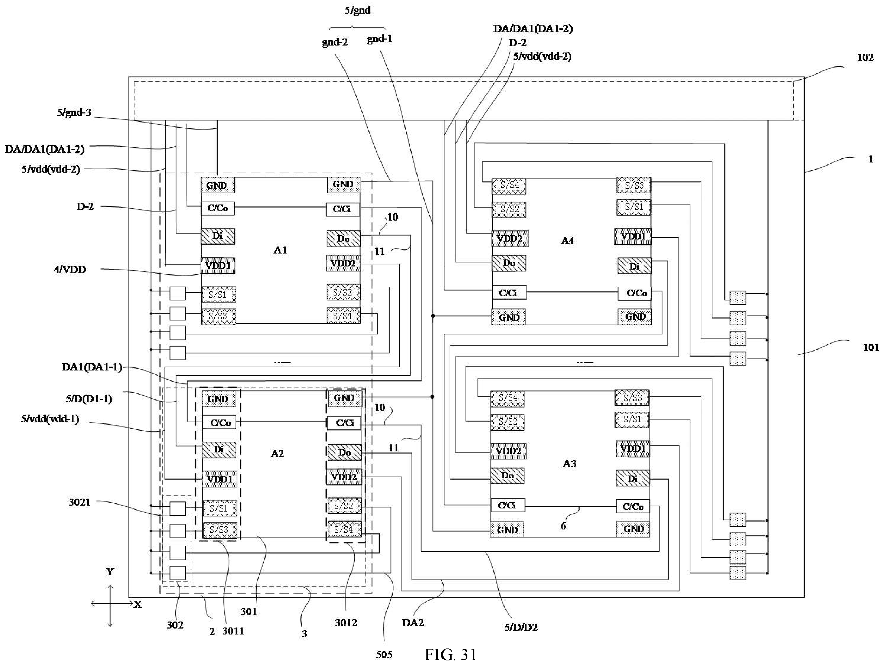

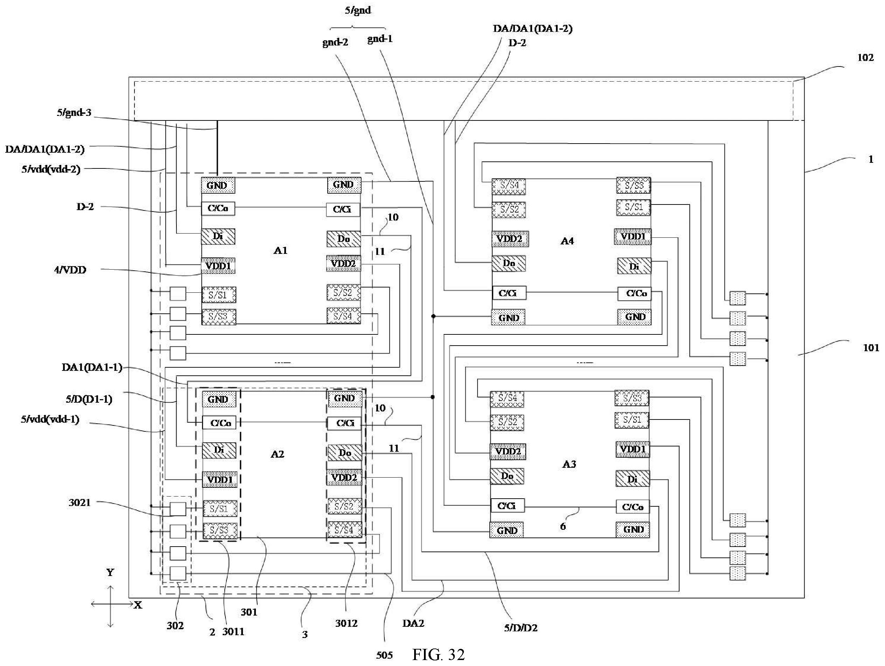

Alternatively, in some embodiments, as shown in FIG. 8, FIG. 9, FIG. 10, FIGS. 25-32, the first pad region 301 further includes: a first connection lead 6; the data input pad Ci and the data output pad Co are electrically connected to each other through the first connection lead 6.

In the wiring substrate provided by the embodiments of the disclosure, the first pad region includes the first connection lead connecting the data pads, so that the driver chip bonded to the first pad region does not need to be set up with a circuit for electrically connecting the plurality of data pads, which can simplify the difficulty of designing the driver chip.

In some embodiments, when the first pad region 301 includes a plurality of power supply pads VDD, namely a first power supply pad VDD1 and a second power supply pad VDD2. It is necessary to set the first power supply pad VDD1 electrically connected to the second power supply pad VDD2.

In some embodiments, when the wiring substrate is applied to a light-emitting substrate, that is, the first pad region is bonded to the driver chip, the first power supply pad VDD1 and the second power supply pad VDD2 belonging to the same first pad region may be electrically connected with each other through the driver chip, that is, the driver chip internally includes a circuit electrically connected to the first power supply pad VDD1 and the second power supply pad VDD2. As shown in FIG. 2, FIG. 4, FIG. 6, and FIGS. 11-32, the first power supply pad VDD1 and the second power supply pad VDD2 in the first pad region 301 are not electrically connected with each other through a trace.

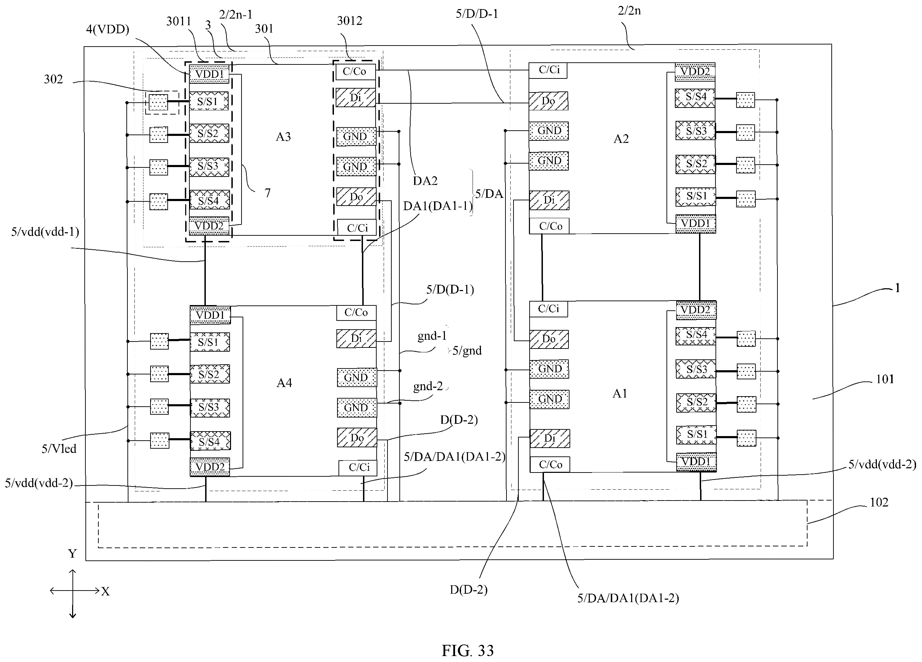

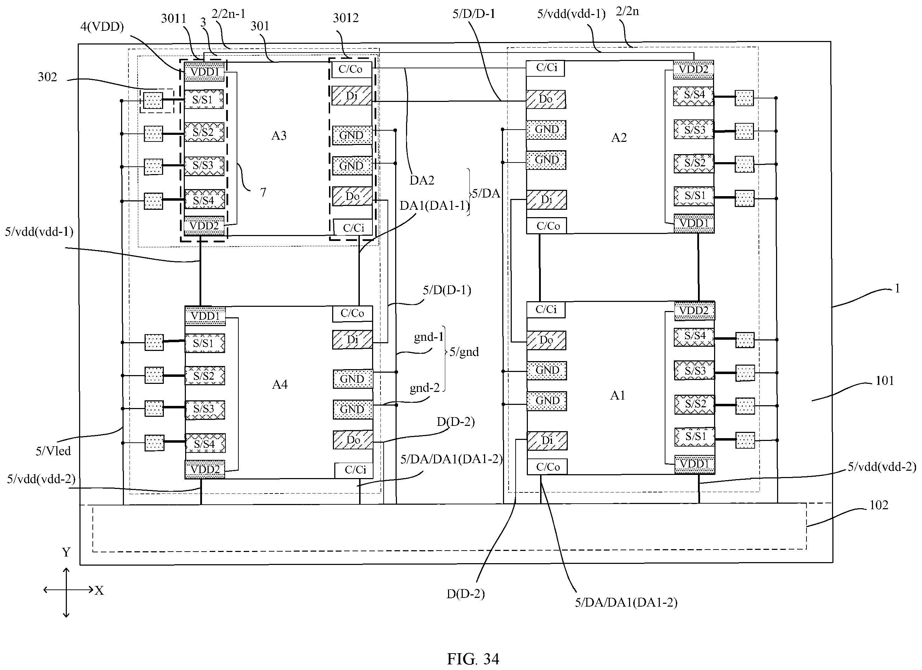

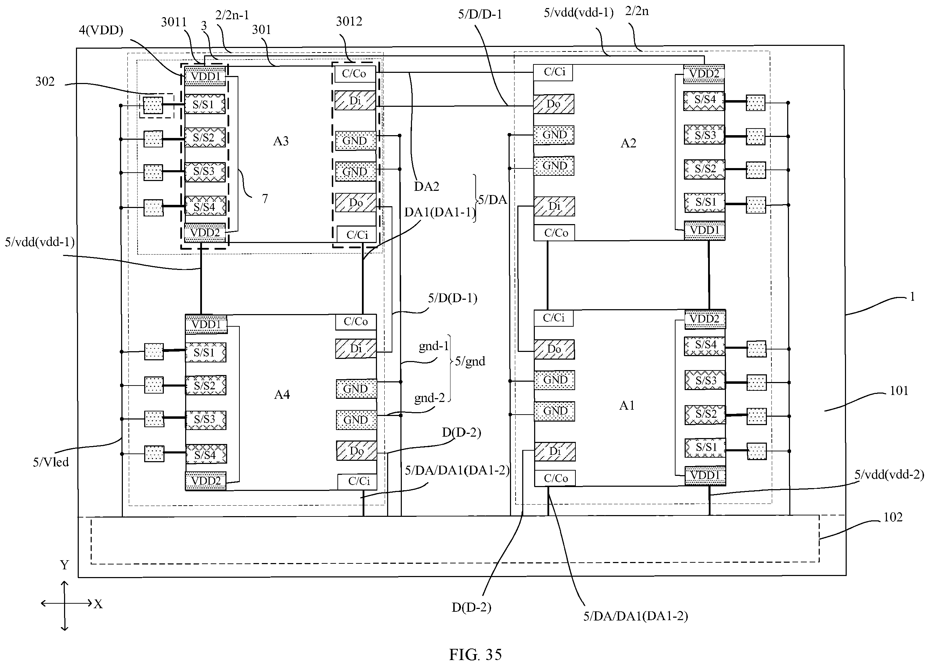

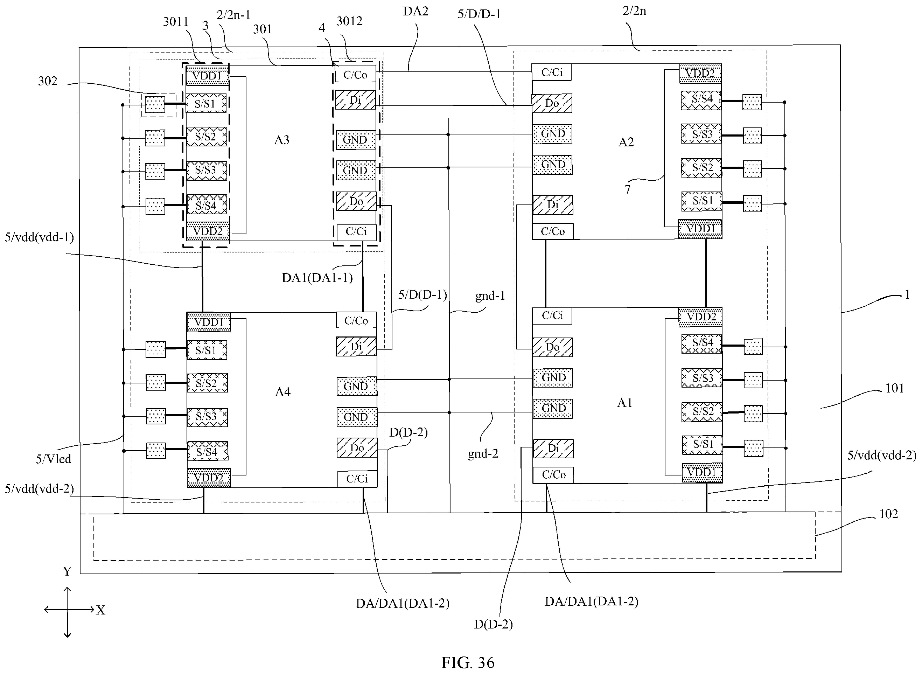

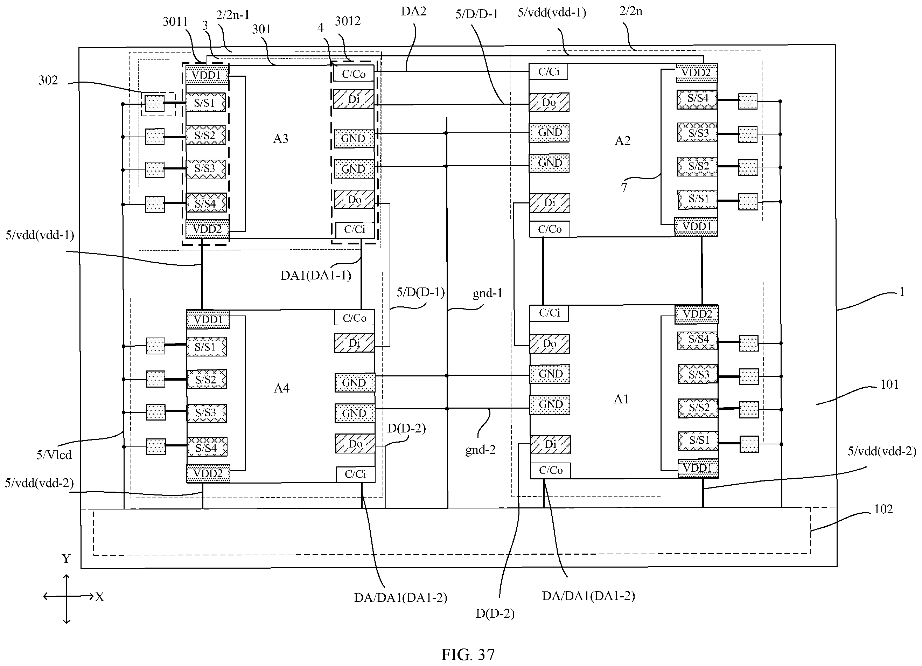

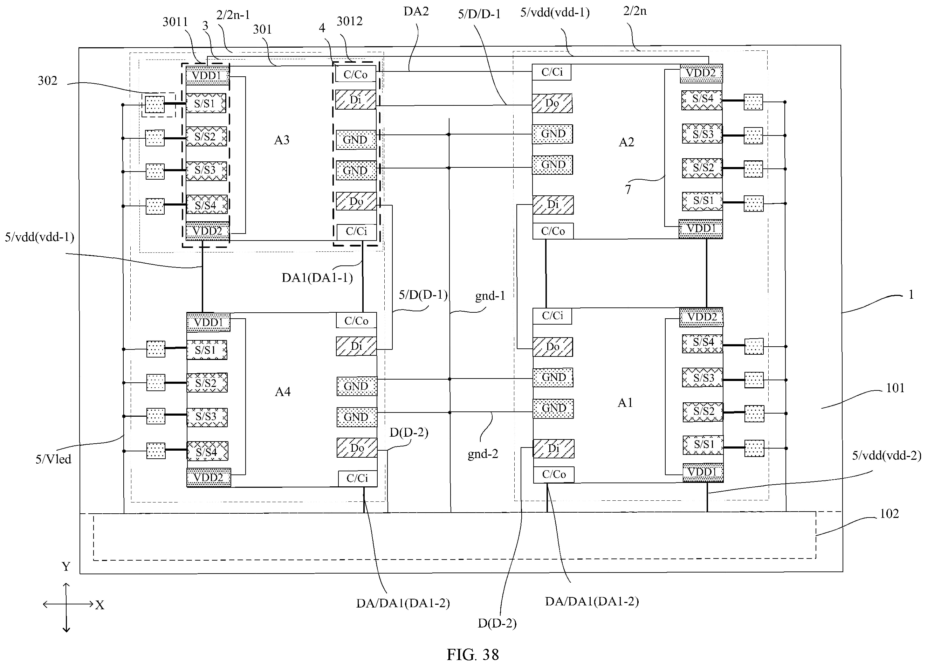

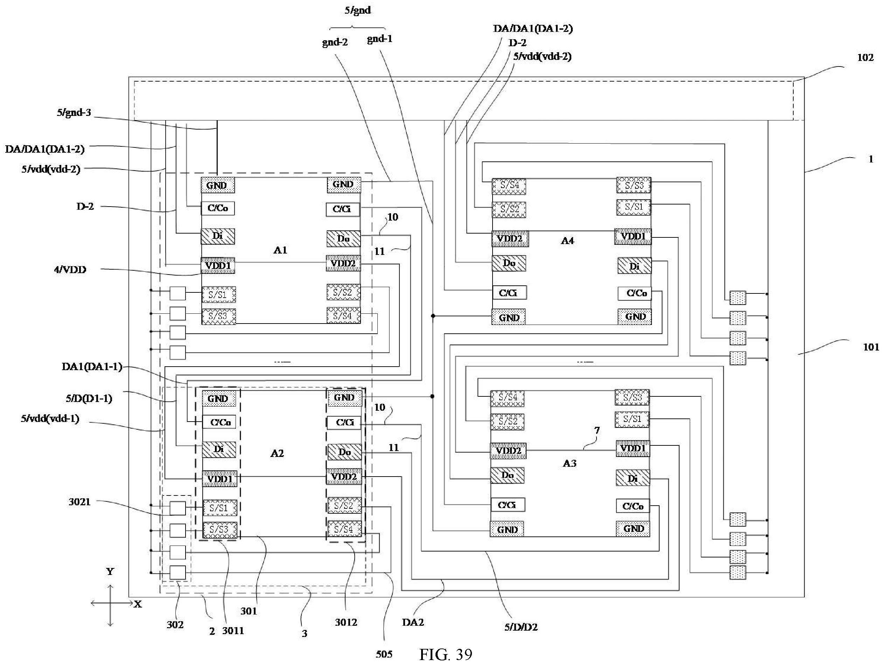

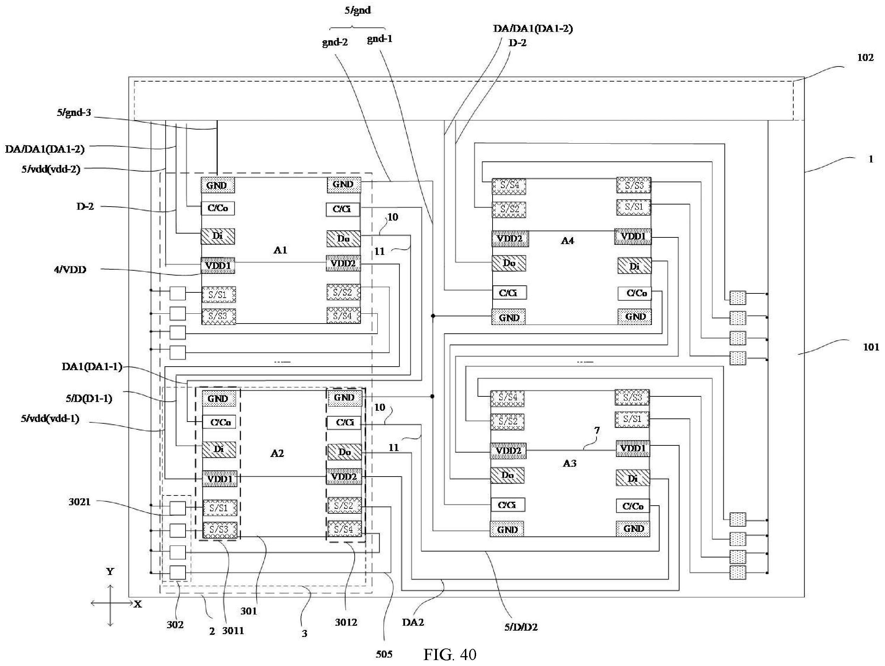

Alternatively, in some embodiments, as shown in FIG. 8, FIG. 9, FIG. 10, and FIGS. 33-40, the first pad region 301 further includes: a second connection lead 7; the first power supply pad VDD1 and the second power supply pad VDD2 are electrically connected with each other through the second connection lead 7.

In the wiring substrate provided by the embodiments of the disclosure, the first pad region includes the second connection lead connecting the power supply pads, so that the driver chip bonded to the first pad region does not need to be set up with a circuit for electrically connecting the plurality of power supply pads, which can simplify the difficulty of designing the driver chip.

In some embodiments, as shown in FIG. 2, FIG. 4, and FIG. 6, when the first pad region 301 includes a plurality of ground pads GND, it is necessary to set up the plurality of ground pads GND to be electrically connected with each other.

In some embodiments, when the wiring substrate is applied to a light-emitting substrate, that is, the first pad region is bonded to the driver chip, the plurality of ground pads GND belonging to the same first pad region may be electrically connected with each other through the driver chip, that is, the driver chip internally includes the a circuit electrically connected to the plurality of ground pads GND. As shown in FIG. 2, FIG. 4, FIG. 6, and FIGS. 11-40, the plurality of ground pads GND in the first pad region 301 are not directly electrically connected through a trace.

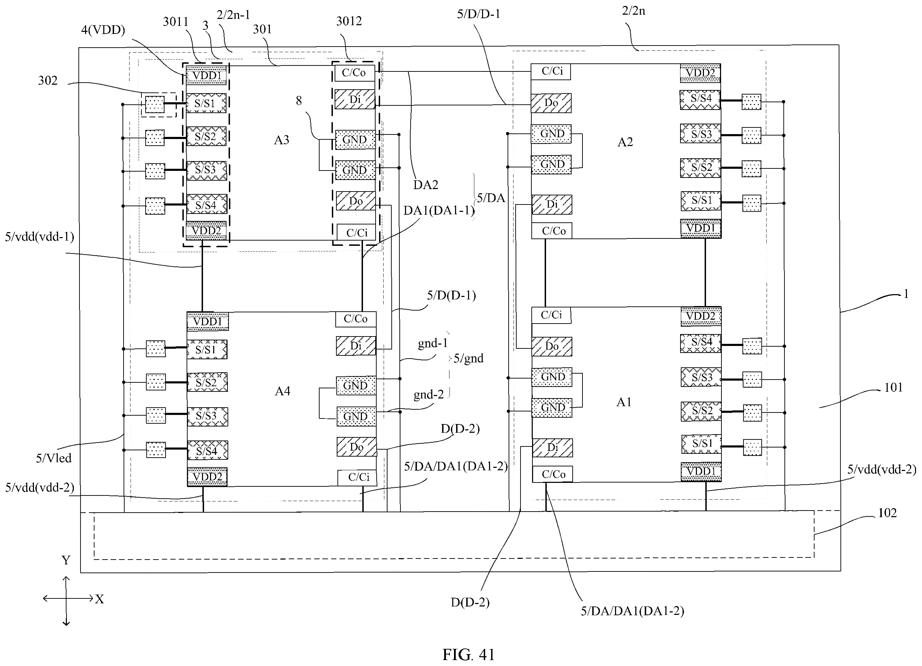

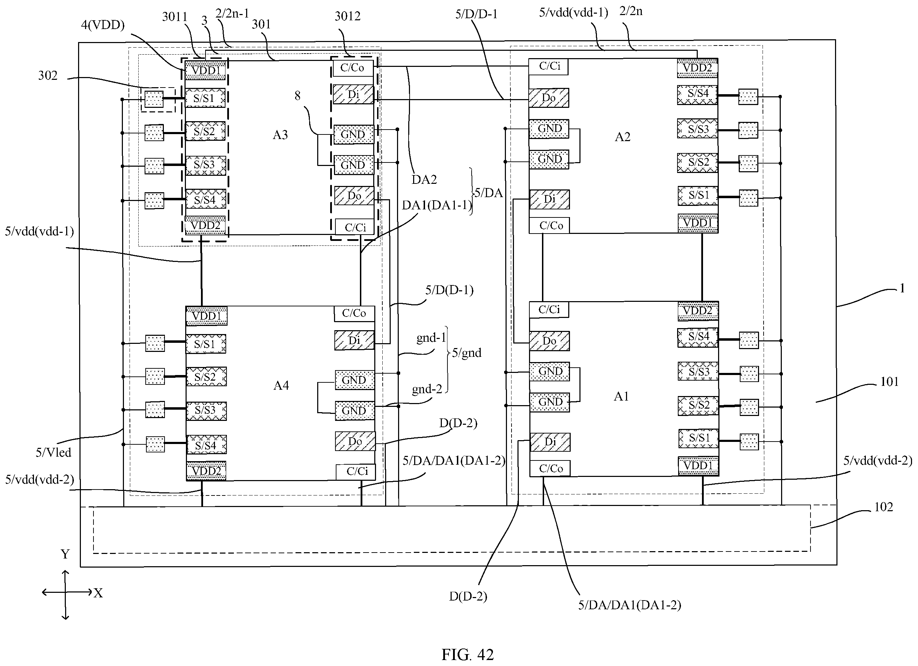

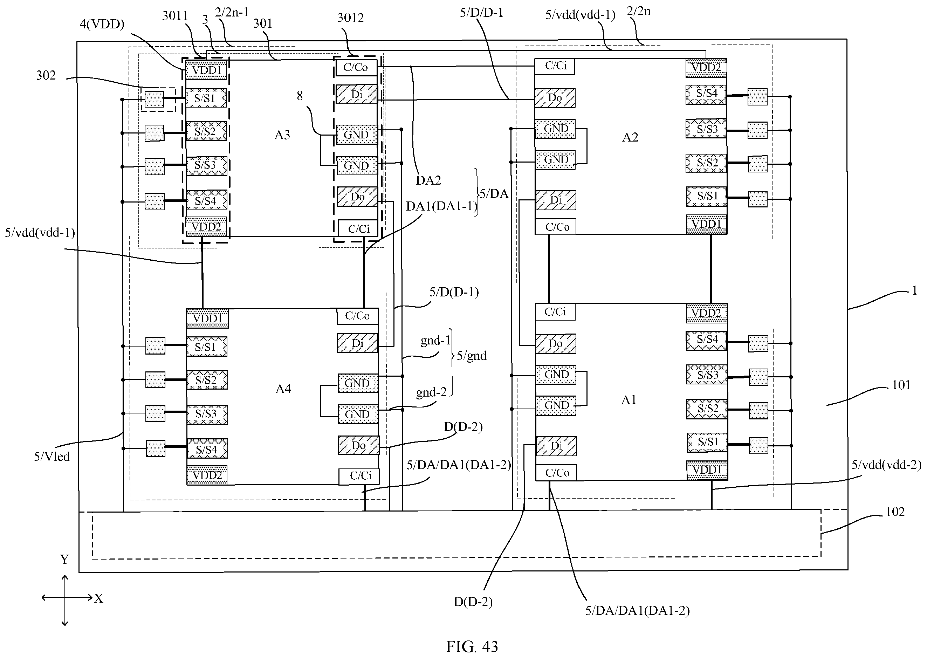

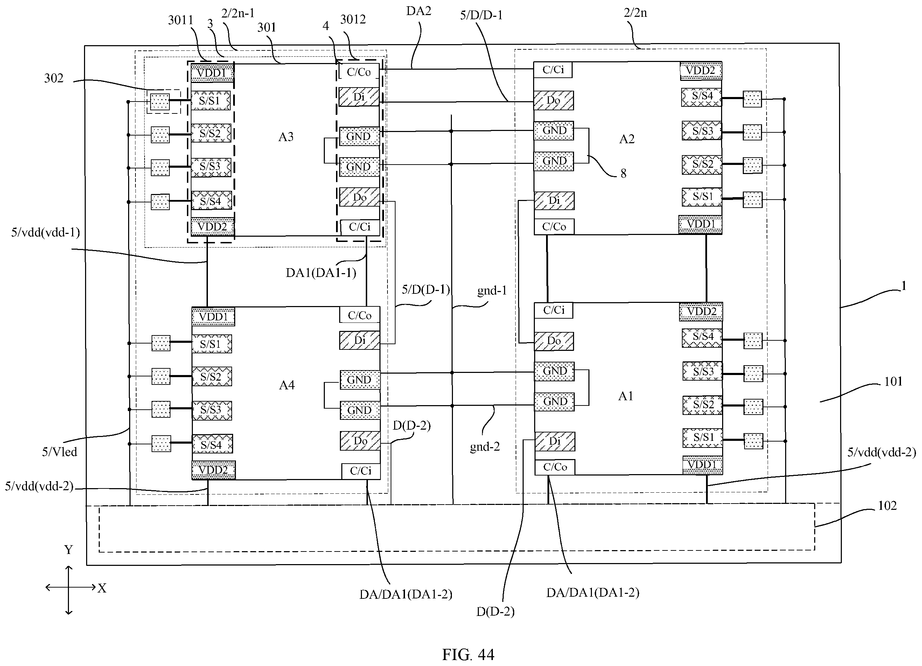

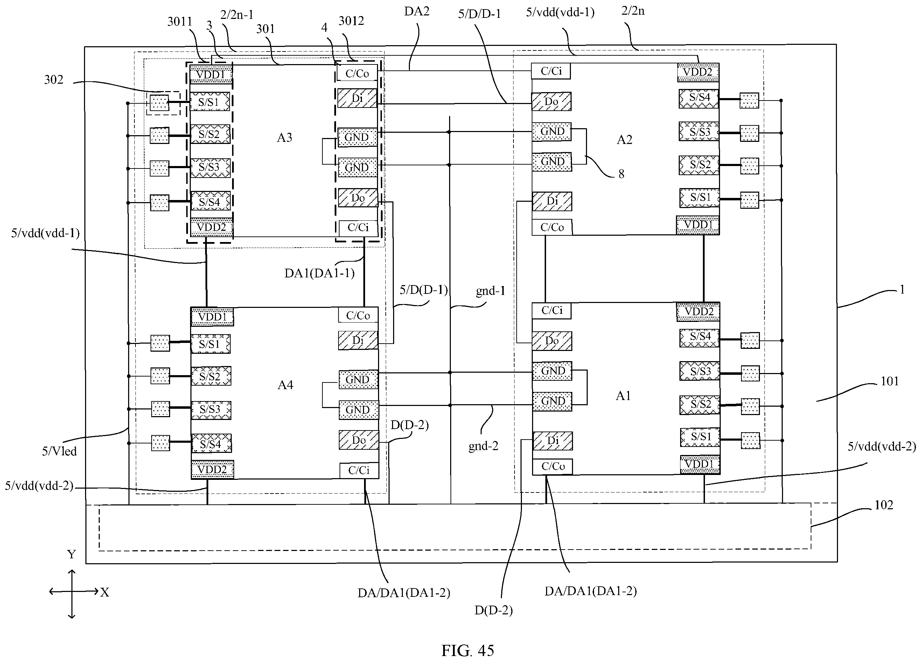

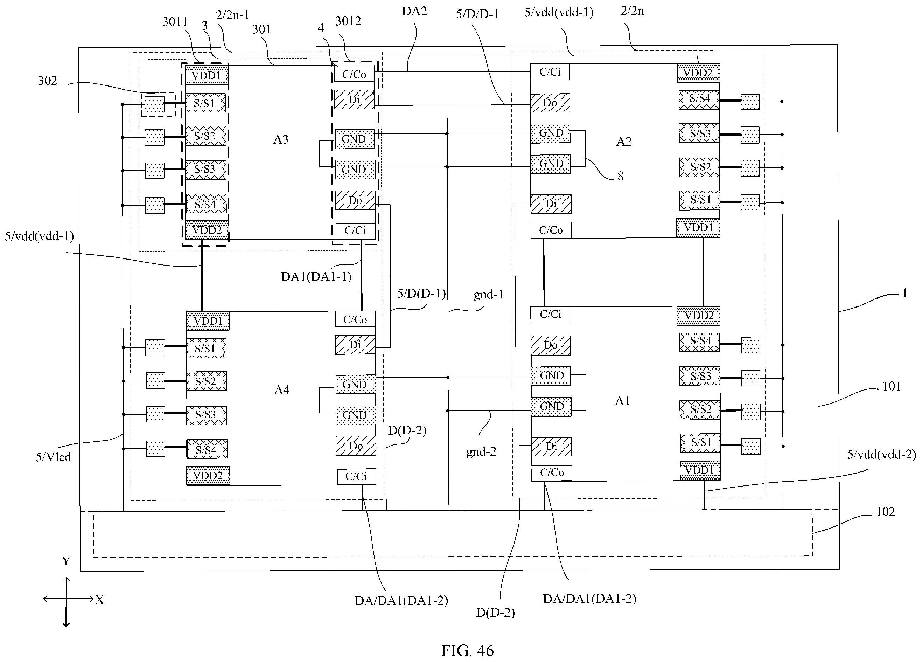

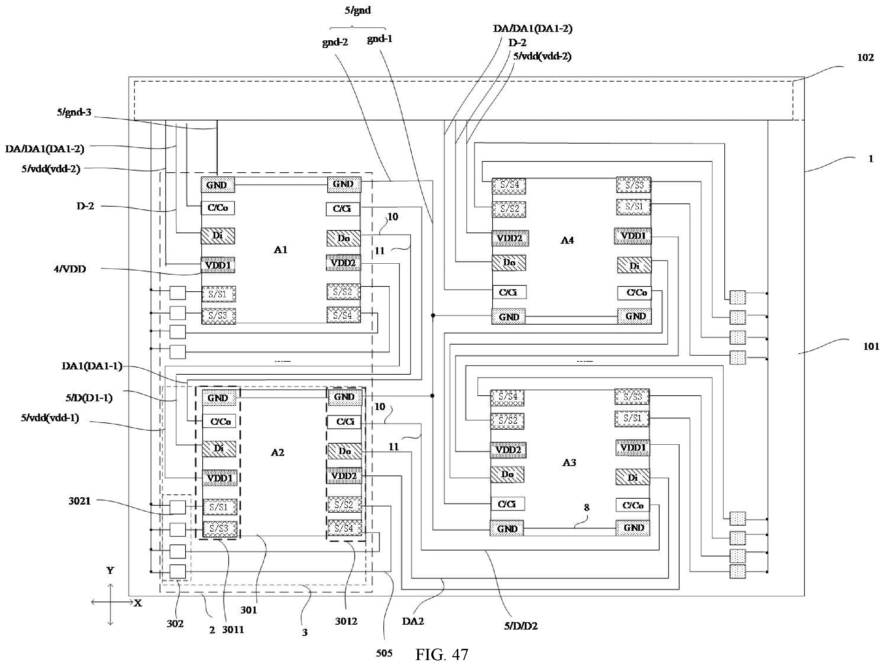

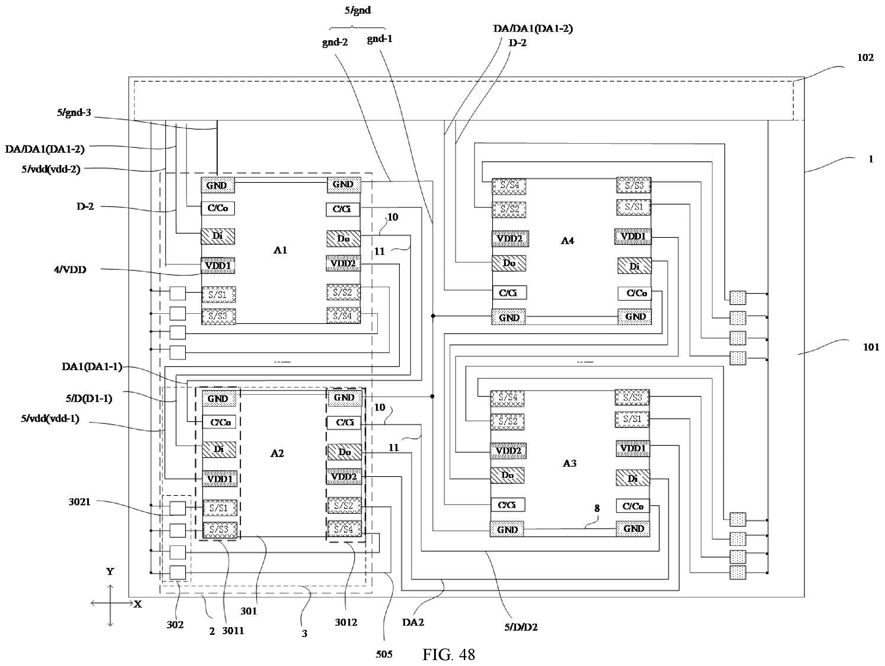

Alternatively, in some embodiments, as shown in FIG. 8, FIG. 9, FIG. 10, and FIGS. 41-48, the first pad region 301 further includes: a third connection lead 8; two ends of the third connection lead 8 are electrically connected to different ground pads GND, respectively.

In the wiring substrate provided by the embodiments of the disclosure, the first pad region includes the third connection lead for connecting the ground pads, so that the driver chip bonded to the first pad region does not need to be set up with a circuit for electrically connecting the plurality of ground pads, which can simplify the difficulty of designing the driver chip.

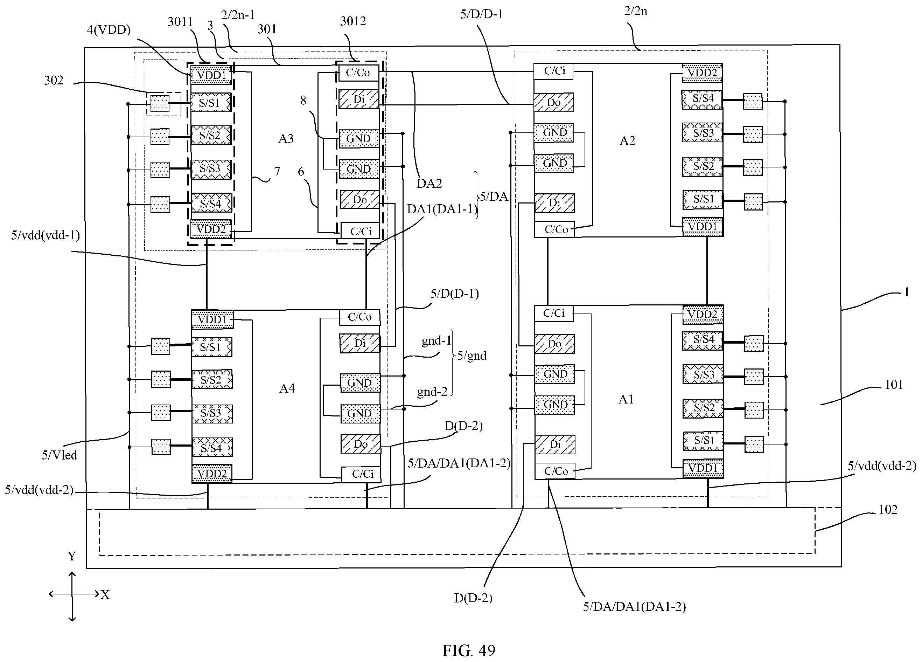

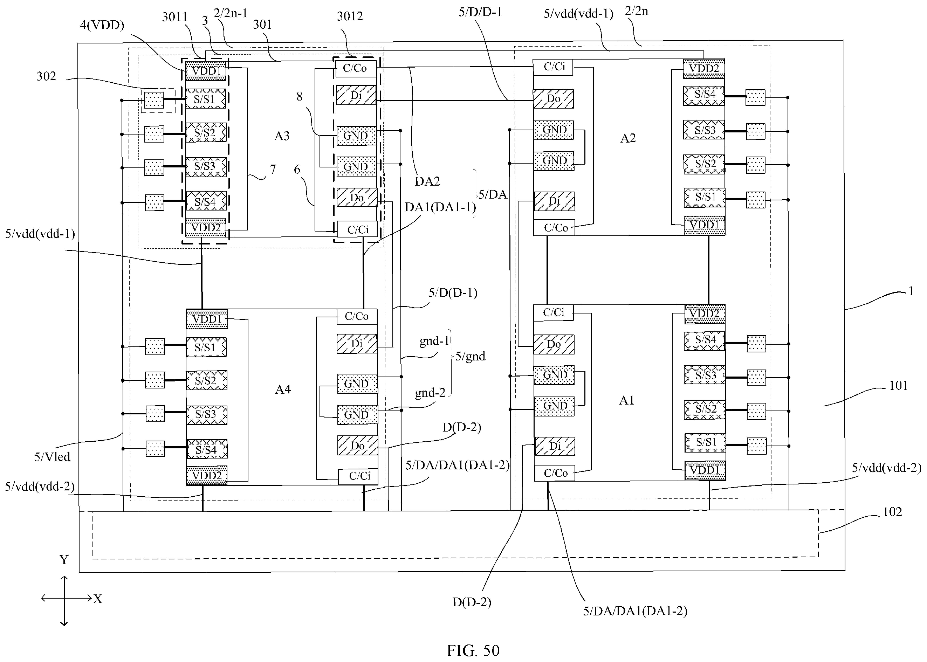

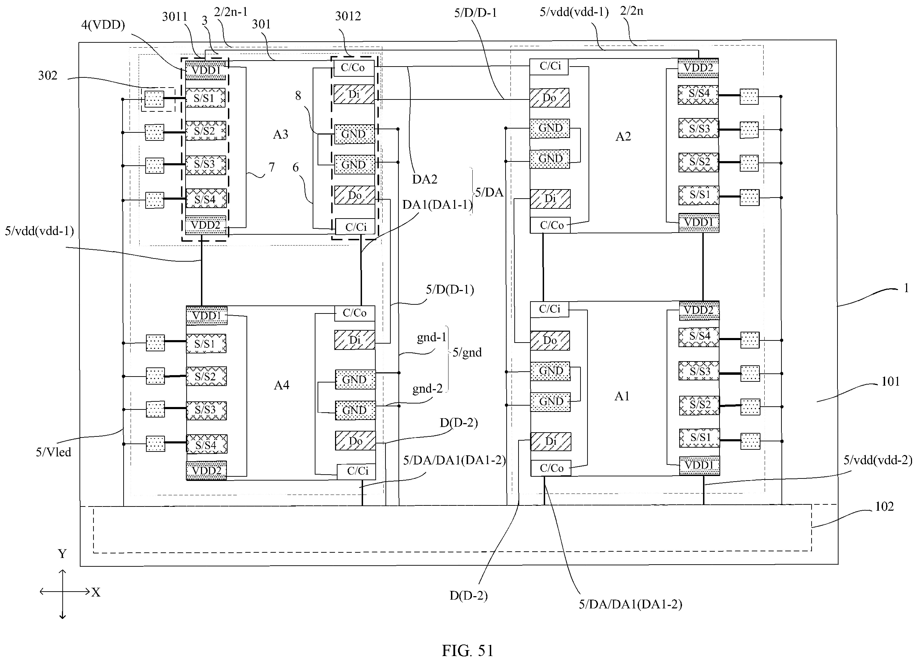

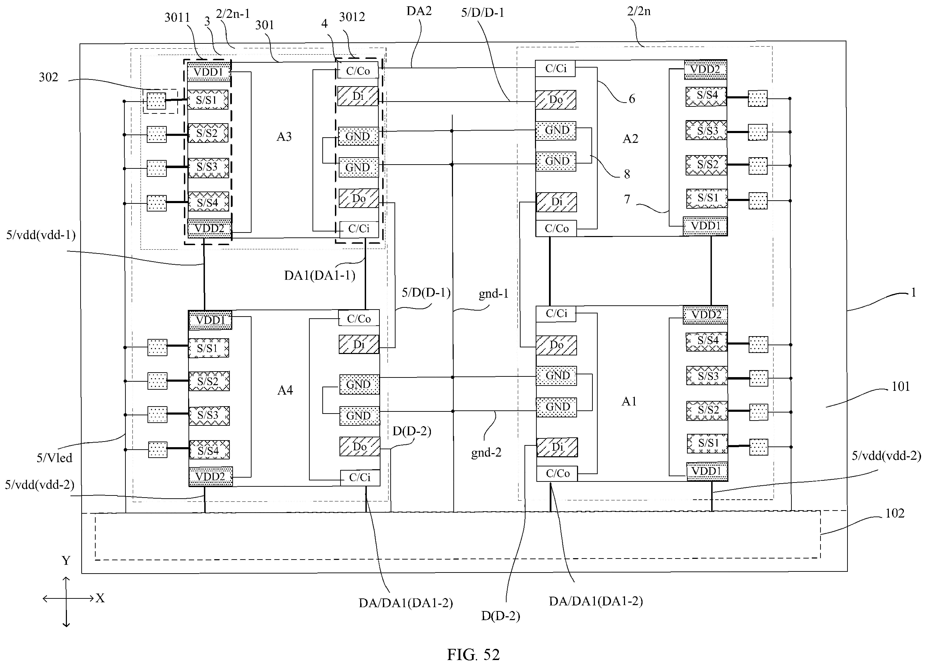

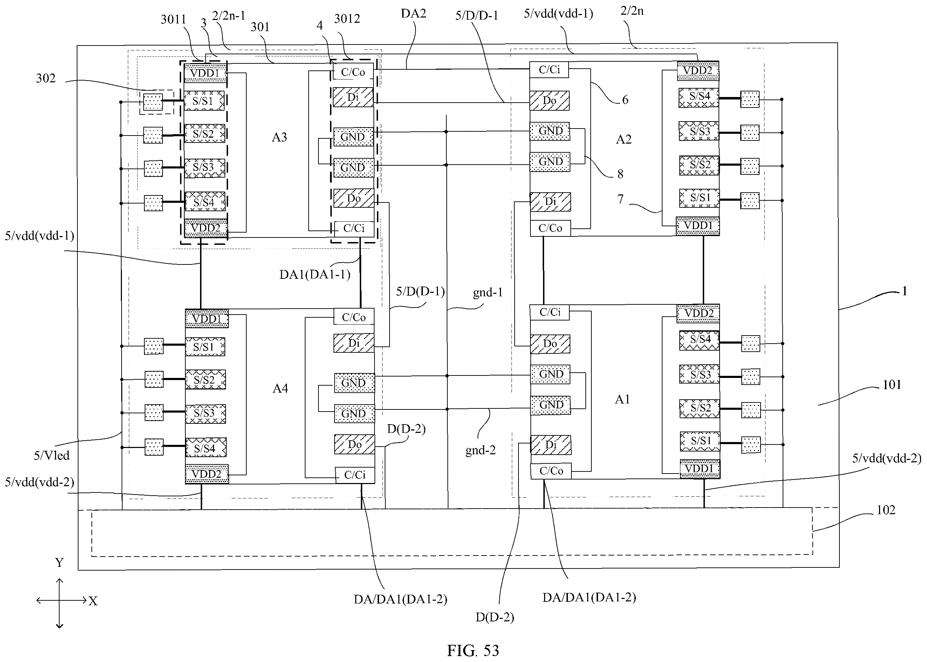

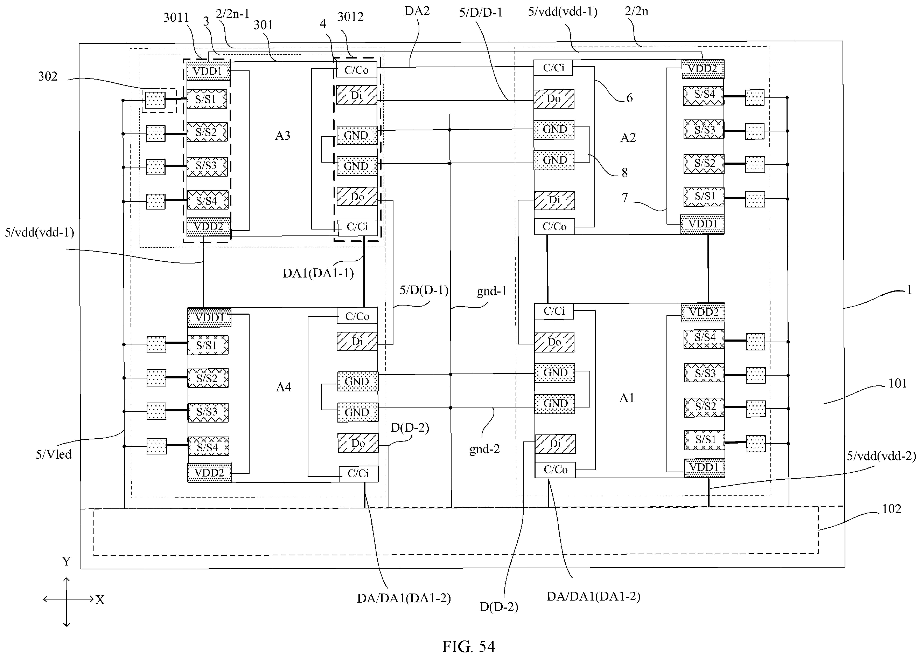

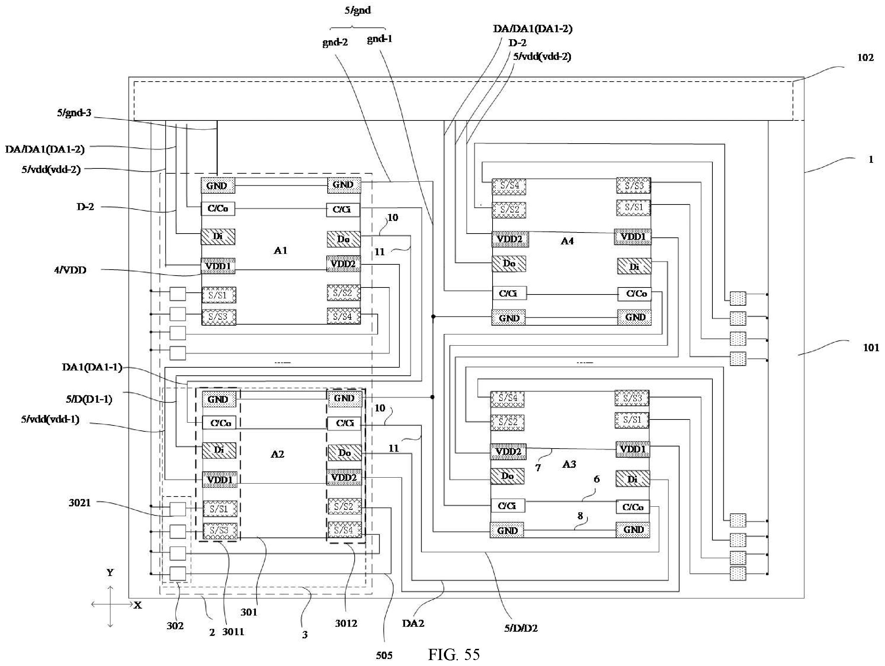

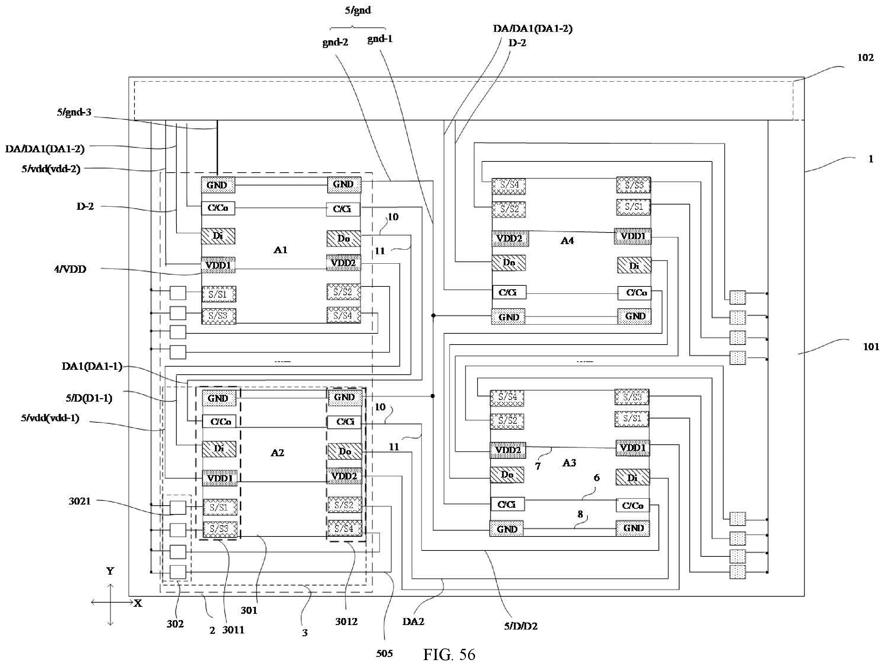

It should be noted that the first connection lead, the second connection lead, and the third connection lead may exist simultaneously in one first pad region in any combination; for example, the first pad region may simultaneously include the first connection lead and the second connection lead, or include the first connection lead and the third connection lead, or include the second connection lead and the third connection lead, or include the first connection lead, the second connection lead, and the third connection lead. FIG. 8, FIG. 9, FIG. 10, and FIG. 49-56 take an example that the first pad region 301 simultaneously includes the first connection lead 6, the second connection lead 7, and the third connection lead 8 for illustration.

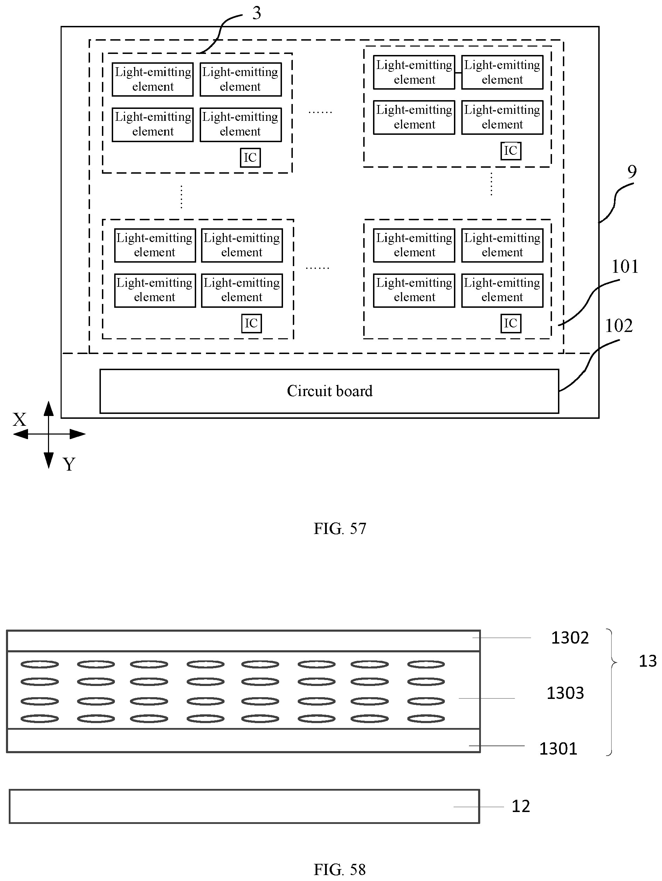

The embodiments of the disclosure provide a light-emitting substrate, as shown in FIG. 57, the light-emitting substrate includes: the wiring substrate 9 provided by the embodiments of the disclosure, and a plurality of driver circuit ICs and a plurality of light-emitting elements bonded to the wiring substrate 9.

In some embodiments, the driver chips are bonded to first pad regions in a one-to-one correspondence, and the light-emitting elements are bonded to pad groups of a plurality of second pad regions in a one-to-one correspondence.

In some embodiments, the driver chip includes a first circuit, and a plurality of data pads included in the first pad region are electrically connected with each other through the first circuit. Thus, there is no need to provide a trace for connecting the plurality of data pads in the first pad region, which can save the wiring space. In specific implementation, the first circuit is electrically connected to a data input pad and a data output pad.

In some embodiments, the driver chip includes a second circuit, and a plurality of power supply pads included in a first pad region are electrically connected with each other through the second circuit. Thus, there is no need to provide a trace for connecting the plurality of power supply pads in the first pad region, which can save the wiring space. In specific implementation, the second circuit is electrically connected to the first power supply pad and the second power supply pad.

In some embodiments, the driver chip includes a third circuit, and a plurality of ground pads included in the first pad region are electrically connected with each other through the third circuit. Thus, there is no need to provide a trace for connecting the plurality of ground pads in the first pad region, which can save the wiring space.

In some embodiments, as shown in FIG. 57, the light-emitting substrate further includes: a circuit board, bonded to the wiring substrate 9 in the bonding region 102.

In specific implementation, the circuit board is bonded to a bonding electrode of the bonding region.

In specific implementation, the circuit board can be either a rigid printed circuit board or a flexible printed circuit board.

In some embodiments, the light-emitting elements are micro-sized inorganic light-emitting diodes.

In specific implementation, for example, the micro-sized inorganic light-emitting diode is a Mini Light Emitting Diode (Mini-LED) or a Micro Light Emitting Diode (Micro-LED). Mini-LEDs and Micro-LEDs are small in size and high in brightness and are allowed to be used in a large number of applications in the display apparatus or its backlight module. For example, the typical size (such as length) of a Micro-LED is less than 100 micrometers, e.g., ranges from 10 micrometers to 80 micrometers; the typical size (such as length) of a Mini-LED is 80 micrometers to 350 micrometers, e.g., ranges from 80 micrometers to 120 micrometers. The electronic element may be at least one of the Micro-LED or the Mini-LED.

The embodiments of the disclosure provide a display apparatus including the light-emitting substrate provided by the embodiments of the disclosure.

In some embodiments, as shown in FIG. 58, the display apparatus further includes: a display panel 13, at a light-emitting side of the light-emitting substrate 12.

That is, the light-emitting substrate serves as a backlight source of the display panel.

In specific implementation, as shown in FIG. 58, for example, the display panel 13 is a liquid crystal display panel, and includes: an array substrate 1301 and an opposite substrate 1302 arranged opposite to each other, and a liquid crystal layer 1303 between the array substrate 1301 and the opposite substrate 1302.

The display apparatus provided by the embodiments of the disclosure is: a cell phone, a tablet computer, a television, a monitor, a laptop computer, a digital photo frame, a navigator, or any other product or component having a display function. Other essential components of the display apparatus are understood by those of ordinary skill in the art, and are not described herein, nor should they be taken as a limitation of the disclosure. The implementation of the display apparatus can be seen in the above embodiments of wiring substrate, light-emitting substrate, and will not be repeated.

In conclusion, in the wiring substrate, the light-emitting substrate and the display apparatus provided by the embodiments of the disclosure, the data pads in the two cascaded first pad regions located in the adjacent pad cell columns are electrically connected with each other through the second data signal line, which avoids the data signals output from the data pads in the first pad region farthest from the bonding region from being transmitted back to the bonding region through the trace with a larger length, thereby reducing the transmission time of the data signals and increasing the transmission frequency of the data signals, and avoiding the transmission delay of the data signals.

Although preferred embodiments of the present invention have been described, those embodiments are subject to additional changes and modifications once the basic inventive concepts are known to those skilled in the art. Therefore, the appended claims are intended to be construed to include the preferred embodiments as well as all changes and modifications that fall within the scope of the present invention.

Obviously, those skilled in the art may make various changes and variations to the embodiments of the present invention without departing from the spirit and scope of the embodiments of the present invention. Thus, if such modifications and variations of the embodiments of the present invention fall within the scope of the claims of the present invention and their technical equivalents, the present invention is intended to encompass such modifications and variations.

## Claims

1. A wiring substrate, comprising:
a substrate, comprising a functional region and a bonding region at a side of the functional region in a first direction;
a plurality of pad cell columns, at a side of the substrate and in the functional region; wherein:
at least one of the plurality of pad cell columns comprises a plurality of pad cells;
at least one of the plurality of pad cells comprises a first pad region; and
the first pad region comprises multiple kinds of first pads, and the multiple kinds of first pads comprises at least one data pad and at least one ground pad; and
a plurality of traces, electrically connected to the plurality of pad cells; wherein:
the plurality of traces comprise a plurality of data signal lines and a plurality of ground signal lines;
the plurality of data signal lines comprise a plurality of first data signal lines; and
the first data signal line is electrically connected to data pads of a plurality of first pad regions in one pad cell column, the ground signal line is electrically connected to ground pads of two cascaded first pad regions respectively located in adjacent pad cell columns.

2. The wiring substrate according to claim 1, wherein ground pads of the plurality of first pad regions in the one pad cell column are adjacent to ground pads of a plurality of first pad regions in a pad cell column that is adjacent to the one pad cell column.

3. The wiring substrate according to claim 1 or 2, wherein ground pads of the plurality of first pad regions in the one pad cell column are arranged in a mirror image with ground pads of a plurality of first pad regions in a pad cell column that is adjacent to the one pad cell column.

4. The wiring substrate according to claim 3, wherein the traces further comprise a plurality of address signal lines and a plurality of second voltage lines;
wherein the first pad region further comprises an address pad, a relay pad, and at least one power supply pad;
the address signal line is electrically connected to the address pad and the relay pad, and the second voltage line is electrically connected to the power supply pad; and
in two first pad regions that are adjacent to each other and respectively in two cascaded pad cell columns, an address pad of one of the two first pad regions is arranged adjacent to a relay pad of the other one of the two first pad regions.

5. The wiring substrate according to claim 4, wherein address pads and relay pads of the plurality of first pad regions in the one pad cell column after being rotated 180°are arranged in a mirror image with address pads and relay pads of the plurality of first pad regions in the pad cell column adjacent to the one pad cell column.

6. The wiring substrate according to any one of claims 1 to 5, wherein in two adjacent pad cell columns, a cascaded direction of a plurality of pad cells in one of the two adjacent pad cell columns is opposite to a cascaded direction of a plurality of pad cells in the other one of the two adjacent pad cell columns;
the wiring substrate comprises 2N pad cell columns, wherein multiple kinds of first pads of a first pad region that is rotated by 180° in a 2n-th pad cell column are arranged in a same manner as multiple kinds of first pads of a first pad region in a (2n-1)-th pad cell column; wherein N is a positive integer, and n is a positive integer not greater than N.

7. The wiring substrate according to any one of claims 1 to 6, wherein the at least one data pad and the at least one ground pad are in a same column in the first direction; and
the at least one data pad and the at least one ground pad each comprises a portion that is in the first pad region and is close to an edge of the ground signal line.

8. The wiring substrate according to claim 7, wherein the ground signal line comprises: a trunk portion extending in the first direction; the trunk portion is between two pad cell columns that are electrically connected to the ground signal line.

9. The wiring substrate according to claim 8, wherein
the ground signal line further comprises a branch portion extending in a second direction;
an orthographic projection of the branch portion on the substrate is between an orthographic projection of the trunk portion on the substrate and an orthographic projection of the pad cell column on the substrate; and
the trunk portion is connected to ground pads comprised in a second pad column through the branch portion;
wherein the second direction intersects with the first direction.

10. The wiring substrate according to claim 8 or 9, wherein the first data signal line comprises a plurality of first sub-segments; the first sub-segment is electrically connected to data pads of two cascaded first pad regions in the pad cell column; and
an orthographic projection of the first sub-segment on the substrate is at a side of the orthographic projection of the trunk portion on the substrate facing the orthographic projection of the pad cell column on the substrate.

11. The wiring substrate according to any one of claims 1 to 10, wherein the plurality of data signal lines further comprise: a plurality of second data signal lines; and
the second data signal line is electrically connected to data pads of the two cascaded first pad regions that are respectively located in the adjacent pad cell columns.

12. The wiring substrate according to claim 11, wherein the ground signal line comprises a trunk portion; an orthographic projection of the second data signal line on the substrate is at a side of an orthographic projection of the trunk portion on the substrate away from the bonding region.

13. The wiring substrate according to any one of claims 8 to 12, wherein two pad cell columns that are adjacent to each other and are cascaded are electrically connected to a same trunk portion.

14. The wiring substrate according to any one of claims 9 to 12, wherein two pad cell columns that are adjacent to each other and are cascaded are electrically connected to different trunk portions, and the branch portions are respectively electrically connected to the ground pads of the two cascaded first pad regions located in the adjacent pad cell columns.

15. The wiring substrate according to any one of claims 11 to 14, wherein
the ground signal line comprises a trunk portion;
the pad cell further comprises: at least one second pad region; and the second pad region is electrically connected to the first pad region;
the first pad further comprises: at least one output pad;
the plurality of traces further comprises: a plurality of first voltage lines extending in the first direction;
the first voltage line is electrically connected to input terminals of a plurality of second pad regions in the pad cell column, and output terminals of the plurality of second pad regions are electrically connected to the output pads; and
a first voltage line and a trunk portion that are electrically connected to a same pad cell column are respectively at both sides of the same pad cell column.

16. The wiring substrate according to claim 15, wherein at least some adjacent pad cell columns are electrically connected to a same first voltage line.

17. The wiring substrate according to claim 16, wherein
the first pad region further comprises: an address pad, a relay pad, and at least one power supply pad;
the traces further comprise: a plurality of address signal lines and a plurality of second voltage lines; the address signal line comprises a plurality of second sub-segments;
an end of the second sub-segment is electrically connected to a relay pad of one first pad region, and the other end of the second sub-segment is electrically connected to an address pad of a first pad region of a next stage of the one first pad region;
the second voltage line comprises a plurality of third sub-segments; and the third sub-segment is electrically connected to power supply pads of two cascaded first pad regions; and
in the first direction, the relay pad is in a column different from a column where the at least one power supply pad is located.

18. The wiring substrate according to claim 17, wherein
the multiple kinds of first pads comprised in the first pad region are arranged in an array of M*2 with a first pad column and a second pad column, and M is a positive integer;
in the second direction, an orthographic projection of the second pad column on the substrate is between an orthographic projection of the first pad column on the substrate and an orthographic projection of the trunk portion on the substrate; and
at least a part of a region of the at least one data pad, the relay pad, and at least a part of a region of the at least one ground pad are in the second pad column, and the at least one output pad and at least a part of a region of the at least one power supply pad are in the first pad column.

19. The wiring substrate according to claim 18, wherein
the traces are arranged in a same layer as the first pads; the address pad is in the second pad column;
an arrangement direction of the address pad and the relay pad in the second pad column is the same as a cascaded direction of the plurality of pad cells in the pad cell column;
in the second pad column and in the first direction, an orthographic projection of the ground pad on the substrate is between an orthographic projection of the address pad on the substrate and an orthographic projection of the relay pad on the substrate;
an orthographic projection of the second sub-segment that electrically connects the two cascaded first pad regions in the pad cell column on the substrate is between the orthographic projection of the first sub-segment on the substrate and the orthographic projection of the trunk portion on the substrate.

20. The wiring substrate according to claim 19, wherein the at least one data pad comprises: a data input pad and a data output pad;
in each pad cell column, a data output pad of an i-th stage first pad region is electrically connected to a data input pad of an (i + 1)-th stage first pad region through the first sub-segment; wherein i is a positive integer;
in the adjacent pad cell columns, an end of the second data signal line is electrically connected to a data output pad of a last stage first pad region in one of the adjacent pad cell columns, and the other end of the second data signal line is electrically connected to a data input pad of a first stage first pad region in the other one of the adjacent pad cell columns;
the data input pad and the data output pad are in the second pad column; an arrangement direction of the data input pad and the data output pad is the same as the cascaded direction of the plurality of pad cells in the pad cell column; and
the orthographic projection of the address pad on the substrate is between an orthographic projection of the data input pad on the substrate and the orthographic projection of the ground pad on the substrate, and the orthographic projection of the relay pad on the substrate is between an orthographic projection of the data output pad on the substrate and the orthographic projection of the ground pad on the substrate.

21. The wiring substrate according to claim 19, wherein the at least one data pad comprises: a data input pad and a data output pad;
in each pad cell column, a data input pad of an i-th stage first pad region is electrically connected to a data output pad of an (i + 1)-th stage first pad region through the first sub-segment; wherein i is a positive integer;
in the adjacent pad cell columns, an end of the second data signal line is electrically connected to a data input pad of a last stage first pad region in one of the adjacent pad cell columns, and the other end of the second data signal line is electrically connected to a data output pad of a first stage first pad region in the other one of the adjacent pad cell columns;
the data input pad and the data output pad are in the second pad column; an arrangement direction of the data output pad and the data input pad is the same as the cascaded direction of the plurality of pad cells in the pad cell column;
the orthographic projection of the address pad on the substrate is between an orthographic projection of the data input pad on the substrate and the orthographic projection of the ground pad on the substrate, and the orthographic projection of the relay pad on the substrate is between an orthographic projection of the data output pad on the substrate and the orthographic projection of the ground pad on the substrate.

22. The wiring substrate according to claim 20 or 21, wherein in the second direction, the data output pad of the first pad region and the data input pad of the first pad region rotated by 180° are in a same row;
the address pad of the first pad region and the relay pad of the first pad region rotated by 180° are in a same row;
the second data signal line extends in the second direction, and the orthographic projection of the second data signal line on the substrate is at a side of the orthographic projection of the branch portion on the substrate away from the bonding region; and
the second sub-segment that electrically connects two adjacent pad cell columns extends in the second direction, an orthographic projection of the second sub-segment that electrically connects the two adjacent pad cell columns on the substrate is between the orthographic projection of the second data signal line on the substrate and the orthographic projection of the branch portion on the substrate.

23. The wiring substrate according to claim 22, wherein the at least one power supply pad comprises: a first power supply pad and a second power supply pad; both the first power supply pad and the second power supply pad are in the first pad column;
an arrangement direction of the first power supply pad and the second power supply pad in the first pad column is the same as the cascaded direction of the plurality of pad cells in the pad cell column;
in the first direction, an orthographic projection of the output pad on the substrate is between an orthographic projection of the first power supply pad on the substrate and an orthographic projection of the second power supply pad on the substrate; and
an end of the third sub-segment is electrically connected to a second power supply pad of one first pad region, and the other end of the third sub-segment is electrically connected to a first power supply pad of a next stage of the one first pad region.

24. The wiring substrate according to claim 23, wherein in the second direction, the power supply pad and the data pad are in a same row.

25. The wiring substrate according to any one of claims 18 to 24, wherein the first pad region comprises a plurality of ground pads, and the plurality of ground pads are all in the second pad column.

26. The wiring substrate according to any one of claims 18 to 25, wherein the output pads comprised in the first pad region are all in the first pad column.

27. The wiring substrate according to claim 18, wherein the address pad and the at least a part of the region of the at least one data pad are in the first pad column;
an arrangement direction of the data pad, the address pad, the power supply pad and the output pad in the first pad column is the same as a cascaded direction of the plurality of pad cells in the pad cell column;
an arrangement direction of the ground pad, the data pad and the relay pad in the second pad column is the same as the cascaded direction of the plurality of pad cells in the pad cell column;
an end of the first sub-segment is electrically connected to the data pad in the second pad column, and the other end of the first sub-segment is electrically connected to the data pad in the first pad column; and
an orthographic projection of the first sub-segment on the substrate is between an orthographic projection of the second sub-segment on the substrate and the orthographic projection of the trunk portion on the substrate.

28. The wiring substrate according to claim 27, wherein the traces are arranged in a same layer as the first pads;
at least a part of the region of the at least one power supply pad is in the second pad column;
an arrangement direction of the ground pad, the data pad, the relay pad and the power supply pad in the second pad column is the same as the cascaded direction of the plurality of pad cells in the pad cell column;
an end of the third sub-segment is electrically connected to the power supply pad in the second pad column, and the other end of the third sub-segment is electrically connected to the power supply pad in the first pad column;
an orthographic projection of the second sub-segment that electrically connects the two cascaded first pad regions in the pad cell column on the substrate is between the orthographic projection of the first sub-segment on the substrate and an orthographic projection of the third sub-segment that electrically connects the two cascaded first pad regions in the pad cell column on the substrate.

29. The wiring substrate according to claim 28, wherein in the traces electrically connected to the two cascaded first pad regions in the pad cell column, an arrangement direction of the first sub-segment, the second sub-segment and the third sub-segment in the first direction is the same as the cascaded direction of the plurality of pad cells in the pad cell column;
in the traces electrically connected to two cascaded first pad regions respectively located in two pad cell columns, the second data signal line, the second sub-segment and the third sub-segment are arranged in sequence in a direction pointing from the bonding region to the functional region.

30. The wiring substrate according to claim 29, wherein the at least one data pad comprises: a data input pad and a data output pad; the data input pad is in the first pad column, and the data output pad is in the second pad column;
in each pad cell column, a data output pad of an i-th stage first pad region is electrically connected to a first portion of the first sub-segment, and the data output pad of the i-th stage first pad region is electrically connected to a data input pad of an (i + 1)-th stage first pad region through the first sub-segment; wherein i is a positive integer;
in the adjacent pad cell columns, an end of the second data signal line is electrically connected to a data output pad of a last stage first pad region in one of the adjacent pad cell columns, and the other end of the second data signal line is electrically connected to a data input pad of a first stage first pad region in the other one of the adjacent pad cell columns.

31. The wiring substrate according to claim 29, wherein the at least one data pad comprises: a data input pad and a data output pad; the data output pad is in the first pad column, and the data input pad is in the second pad column;
in each pad cell column, a data input pad of an i-th stage first pad region is electrically connected to a first portion of the first sub-segment, and the data input pad of the i-th stage first pad region is electrically connected to a data output pad of an (i + 1)-th stage first pad region through the first sub-segment; wherein i is a positive integer;
in the adjacent pad cell columns, an end of the second data signal line is electrically connected to a data input pad of a last stage first pad region in one of the adjacent pad cell columns, and the other end of the second data signal line is electrically connected to a data output pad of a first stage first pad region in the other one of the adjacent pad cell columns.

32. The wiring substrate according to claim 30 or 31, wherein the at least one power supply pad comprises: a first power supply pad and a second power supply pad; the first power supply pad is in the first pad column, and the second power supply pad is in the second pad column;
a second power supply pad of the i-th stage first pad region is electrically connected to a first power supply pad of the (i + 1)-th stage first pad region through the third sub-segment.

33. The wiring substrate according to claim 32, wherein the first pad region comprises two ground pads, and the two ground pads are in the first pad column and the second pad column, respectively; in the first direction, the two ground pads are in a same row;
in the first pad column, the ground pad is at a side of the data pad away from the address pad; and
in the second direction, the data input pad and the data output pad are in a same row, the address pad and the relay pad are in a same row, and the first power supply pad and the second power supply pad are in a same row.

34. The wiring substrate according to claim 33, wherein the first pad region comprises a plurality of output pads;
some of the output pads are in the second pad column; and
in the second direction, the output pads in the second pad column are at a side of the second power supply pad away from the relay pad.

35. The wiring substrate according to any one of claims 20 to 26 and 30 to 34, wherein the first pad region further comprises: a first connection lead; and the data input pad and the data output pad are electrically connected with each other through the first connection lead.

36. The wiring substrate according to any one of claims 23 to 26 and 32 to 35, wherein the first power supply pad and the second power supply pad of the first pad region are not electrically connected through the trace.

37. The wiring substrate according to any one of claims 23 to 26 and 32 to 35, wherein the first pad region further comprises: a second connection lead; and the first power supply pad and the second power supply pad are electrically connected through the second connection lead.

38. The wiring substrate according to claim 36 or 37, wherein the second voltage line comprises a third sub-segment; power supply pads of two cascaded first pad regions respectively located in adjacent pad cell columns are electrically connected through the third sub-segment.

39. The wiring substrate according to claim 38, wherein the bonding region comprises a plurality of bonding electrodes;
in the adjacent pad cell columns that are electrically connected through the third sub-segment, a power supply pad of a first stage first pad region in one of the adjacent pad cell columns and a power supply pad of a last stage first pad region in the other one of the adjacent pad cell columns are both electrically connected to the bonding electrodes through the traces.

40. The wiring substrate according to claim 38, wherein the bonding region comprises a plurality of bonding electrodes;
in the adjacent pad cell columns that are electrically connected through the third sub-segment, a power supply pad of a first stage first pad region in one of the adjacent pad cell columns is electrically connected to the bonding electrode through the trace, and a power supply pad of a last stage first pad region in the other one of the adjacent pad cell columns is not connected to the bonding electrode.

41. The wiring substrate according to any one of claims 25 and 32 to 34, wherein the first pad region further comprises: a third connection lead; two ends of the third connection lead are electrically connected to different ground pads, respectively.

42. The wiring substrate according to any one of claims 18 to 41, wherein a quantity of the first pads comprised in the first pad column is the same as a quantity of the first pads comprised in the second pad column.

43. A light-emitting substrate, comprising:
the wiring substrate according to any one of claims 1 to 42,
driving chips, bonded with first pad regions in a one-to-one correspondence, and
light-emitting elements, bonded with pad groups of a plurality of second pad regions in a one-to-one correspondence.

44. The light-emitting substrate according to claim 43, wherein the light-emitting elements are micro-sized inorganic light-emitting diodes.

45. A display apparatus, comprising the light-emitting substrate according to claim 43 or 44.
